(19) Europäisches Patentamt
European Patent Office
Office européen des brevets

(11) EP 3 778 252 B1

(12) # EUROPEAN PATENT SPECIFICATION

(45) Date of publication and mention of the grant of the patent:
**13.03.2024 Bulletin 2024/11**

(21) Application number: **19777527.3**

(22) Date of filing: **25.03.2019**

(51) International Patent Classification (IPC):
***B41C 1/10*** *(2006.01)* ***B41N 1/08*** *(2006.01)*
***G03F 7/00*** *(2006.01)* ***G03F 7/004*** *(2006.01)*
*B41N 3/03* *(2006.01)*

(52) Cooperative Patent Classification (CPC):
**B41N 1/083; B41C 1/1016; G03F 7/00; G03F 7/004;** B41C 2201/02; B41C 2210/04; B41N 3/034

(86) International application number:
**PCT/JP2019/012376**

(87) International publication number:
**WO 2019/188910 (03.10.2019 Gazette 2019/40)**

(54) **PLANOGRAPHIC PRINTING ORIGINAL PLATE, AND METHOD FOR MANUFACTURING PLANOGRAPHIC PRINTING ORIGINAL PLATE**

FLACHDRUCKORIGINALPLATTE UND VERFAHREN ZUR HERSTELLUNG EINER FLACHDRUCKORIGINALPLATTE

PLAQUE ORIGINALE D'IMPRESSION PLANOGRAPHIQUE, ET PROCÉDÉ DE FABRICATION DE PLAQUE ORIGINALE D'IMPRESSION PLANOGRAPHIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **28.03.2018 JP 2018062723**

(43) Date of publication of application:
**17.02.2021 Bulletin 2021/07**

(73) Proprietor: **FUJIFILM Corporation**
**Tokyo 106-8620 (JP)**

(72) Inventors:
- **IKEYAMA, Yusuke**
  **Shizuoka 421-0396 (JP)**
- **SONE, Nobuyuki**
  **Shizuoka 421-0396 (JP)**
- **NAMBA, Yusuke**
  **Shizuoka 421-0396 (JP)**
- **OSHIMA, Atsushi**
  **Shizuoka 421-0396 (JP)**

(74) Representative: **Hoffmann Eitle**
**Patent- und Rechtsanwälte PartmbB**
**Arabellastraße 30**
**81925 München (DE)**

(56) References cited:
**EP-A1- 3 202 586**
**WO-A1-2011/081064**
**WO-A1-2013/145949**
**WO-A1-2015/129504**
**WO-A1-2016/136655**
**WO-A1-2017/170391**
**WO-A1-2017/186556**
**JP-A- 2010 023 402**
**JP-A- 2014 198 453**
**JP-A- 2017 019 206**
**US-A1- 2017 320 351**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 778 252 B1

## Description

## BACKGROUND OF THE INVENTION

1. Field of the Invention

The present invention relates to a planographic printing plate precursor and a method of producing a planographic printing plate precursor and particularly relates to a planographic printing plate precursor and a method of producing a planographic printing plate precursor for newspapers.

2. Description of the Related Art

A planographic printing plate is typically formed of a lipophilic image area that receives ink in the process of printing and a hydrophilic non-image area that receives dampening water. Planographic printing is a method of performing printing by utilizing the property that water and oil-based ink repel each other to generate a difference in adhesiveness of ink onto a surface of a planographic printing plate using a lipophilic image area of the planographic printing plate as an ink receiving unit and a hydrophilic non-image area as a dampening water receiving unit (ink non-receiving unit), allowing the ink to land only on an image area, and transferring the ink to a printing material such as paper.

In a case where printing is performed using a planographic printing plate, since the end portions of the printing plate are in positions other than paper in printing on paper having a size smaller than the size of the printing plate such as a typical sheet-fed printing press, the end portions do not affect the print quality. However, in a case where printing is continuously performed on roll-like paper using a rotary press during newspaper printing or the like, since the end portions of the printing plate are on the surface of rolled paper, the ink adhering to the end portions is transferred to the paper and forms linear stain (hereinafter, also referred to as edge stain) and thus the commodity value of the printed material is significantly impaired.

As a method of preventing such stain on the end portions in newspaper printing, for example, JP2011-177983A describes that edge stain is prevented by treating a region which extends to a distance of 1 cm inward from the end portions of a planographic printing plate precursor with a liquid containing an organic solvent and a water-soluble resin. Further, WO2015/119089A describes that an image recording layer is coated with a coating solution containing a hydrophilizing agent and is cut such that the region coated with the coating solution is a region which extends to a distance of 1 cm from the end portions of a planographic printing plate precursor.

Further, JP1996-058257A (JP-H08-058257A) describes a photosensitive planographic printing plate in which the surface having end portions with two sides or four sides of an aluminum support, opposing each other is curved to the lower surface side and the curved side surface of a photosensitive layer is subjected to a desensitizing treatment. JP1999-052579A (JP-H11-052579A) describes a photosensitive planographic printing plate precursor in which the upper surface having end portions with at least two opposing sides of an aluminum support is upwardly curved and the curved surface is subjected to a desensitizing treatment.

Further, WO2015/129504A and US2017/320351A each disclose a planographic printing plate precursor comprising an aluminum support which has an anodized film; and an image recording layer on the aluminum support, wherein an end portion of the planographic printing plate precursor has a sagging shape having a sagging amount X and a sagging width Y, and wherein the image recording layer contains an infrared absorbing agent.

## SUMMARY OF THE INVENTION

However, in the methods described in JP2011-177983A and WO2015/119089A, the treatment width and the treatment shape of end portions of the planographic printing plate precursor are poor depending on the treatment method for a treatment liquid, and thus a desired picture cannot be drawn on the end portions of the planographic printing plate precursor during printing in some cases. Further, there is a concern that stains may be generated due to ink remaining at the corners (the intersections of the surface and the side surfaces) of the end portions of the planographic printing plate.

Further, the photosensitive planographic printing plate precursors described in JP1996-058257A (JP-H08-058257A) and JP1999-052579A (JP-H11-052579A) are subjected to a development treatment using an alkaline developer or the like after being exposed through a mask to produce printing plates, and do not support production according to a computer-to-plate (CTP) technology yet. Therefore, there is a problem in that film traces remain during printing and the range where a paper surface without stains can be ensured is reduced. Further, since the photosensitive layer contains a sensitizer, the stability under white light is degraded. Further, in the current plate-making process of storing the plate under white light, the film remains and edge stains occur, which is problematic.

The present invention has been made in consideration of the above-described circumstances, and an object thereof is to provide a planographic printing plate precursor and a method of producing a planographic printing plate

precursor, in which an image forming region (printing region) during printing on newspaper page is ensured and edge stains are eliminated.

In order to achieve the object of the present invention, there is provided a planographic printing plate precursor according to an aspect of the present invention which is as defined in the claims.

According to the present invention, in a case where the sagging amount X and the sagging width Y of the end portion of the planographic printing plate precursor are respectively set to be in the above-described range and an ink repellent agent is applied to a part or the entire side surface of two opposing sides at the end portion having the sagging shape, edge stains of the edge end portion can be suppressed. Further, the amount of the ink repellent agent to be applied onto the image recording layer can be reduced by providing the ink repellent agent on the end portion of the aluminum support, and thus a sufficient image forming region can be ensured. Further, in a case where the image recording layer contains an infrared absorbing agent, the storage stability under white light can be improved, the residual film of the film after development can be prevented, and thus edge stains can be suppressed. In addition, the edge stains indicate both crack stains caused by cracks generated on the image recording layer having a sagging shape and corner stains caused by the corners that are the boundaries between the image recording layer and the side surfaces of the planographic printing plate precursor. The effects of the present invention can be exerted as long as at least any of the stains can be eliminated.

According to the aspect, in a case where the region which extends to a distance of at least 30 $\mu$m from the end portion of the aluminum support contains the ink repellent agent, the edge stains can be prevented.

According to the aspect, in a case where the amount of the ink repellent agent is set to be in the range as described in the claims, the edge stains can be prevented, and the stickiness of the side surfaces of end portions of the planographic printing plate can be suppressed.

According to an aspect of the present invention, it is preferable that a region on the image recording layer of the aluminum support which extends to a distance of less than 3 mm from end portions of two opposing sides of the aluminum support contains the ink repellent agent.

According to an aspect of the present invention, it is preferable that a region on the image recording layer of the aluminum support which extends to a distance of less than 1 mm from end portions of two opposing sides of the aluminum support contains the ink repellent agent.

These aspects are based on the definition of the width from an end portion of the ink repellent agent applied onto the image recording layer, and the image forming region can be sufficiently ensured and occurrence of crack stains can be prevented in a case where the width from the end portion of the ink repellent agent is set to be in the above-described range.

According to the aspect, in a case where Z of the equation defined in the claims, which is a variation in the width of the ink repellent agent on the image recording layer from the end portion of the aluminum support is set to 0.5 mm or less, the boundary between the region where the ink repellent agent has been applied and the region where the ink repellent agent has not been applied can be made to be linear. Therefore, an image can be formed up to the end portion of the image forming region. Further, since the region which extends to a distance of 5 cm from both ends in the longitudinal direction is a region where the planographic printing plate is gripped during printing, the calculation is made separately from the variation value of the present embodiment.

According to the aspect, in a case where the amount of the ink repellent agent is set to be in the range described in the claims, the edge stains can be prevented, and the stickiness of the side surfaces of end portions of the planographic printing plate can be suppressed.

According to an aspect of the present invention, it is preferable that a value obtained by dividing the width of the ink repellent agent applied onto the image recording layer by a width of the side surface of the aluminum support is less than 10.

This aspect is based on the definition of the relationship between the width of the ink repellent agent applied onto the image recording layer and the width of the side surface of the aluminum support, and the stickiness of the planographic printing plate precursor can be suppressed, and the image forming region can be sufficiently ensured in a case where the value is in the above-described range.

According to an aspect of the present invention, it is preferable that an area proportion of cracks existing in a region corresponding to the sagging width Y on the surface of the anodized film is 30% or less.

According to the aspect, in a case where the area proportion of the cracks existing in the region corresponding to the sagging width Y is set to 30% or less, the amount of the ink adhering to the cracks can be reduced, and the crack stains can be prevented.

According to an aspect of the present invention, it is preferable that a steepness a45 representing the area proportion of a portion having an inclining degree of 45° or greater which is obtained by extracting a component having a wavelength of 0.2 $\mu$m to 2 $\mu$m in the surface of the anodized film on a side of the image recording layer is 25% or less.

According to the aspect, in a case where the steepness a45 is set to 25% or less, it is possible to prevent the ink after the printing from remaining on the anodized film and prevent occurrence of stains on the paper surface due to

residual ink.

According to an aspect of the present invention, it is preferable that the anodized film has micropores in the surface thereof and an average diameter of the micropores is in a range of 10 nm to 100 nm.

According to the aspect, in a case where the average particle diameter of a micropore on the surface of the anodized film is set to be in a range of 10 nm to 100 nm, the surface area of the anodized film can be increased. Further, in a case where the average diameter thereof is set to be in the above-described range, the image recording layer can be infiltrated into the micropores. Therefore, the adhesiveness between the anodized film and the image recording layer can be improved, and thus the printing durability can be improved.

According to an aspect of the present invention, it is preferable that, in the surface of the anodized film on the side of the image recording layer, a specific surface area ΔS which is a value acquired by Equation (i) based on a geometric measurement area $S_0$ and an actual area $S_X$ obtained by an approximation three point method from three-dimensional data obtained by measuring 512 × 512 points in a region having a size of 25 μm × 25 μm on the surface of the anodized film on the side of the image recording layer using an atomic force microscope is 20% or greater.

$$\Delta S = (S_x - S_0)/S_0 \times 100\ (\%) \cdots \text{(i)}$$

According to the aspect, in a case where the actual area $S_X$ is set to be greater than the geometric measurement area $S_0$ of the anodized film, the adhesiveness between the anodized film and the image recording layer can be increased, and thus the printing durability can be improved.

According to an aspect of the present invention, it is preferable that the image recording layer contains polymer particles consisting of an acrylonitrile copolymer.

According to the aspect, in a case where the image recording layer contains polymer particles formed of an acrylonitrile copolymer, the printing durability of the image recording layer can be improved.

According to an aspect of the present invention, an arithmetic average height Sa of a surface of an outermost layer on a side opposite to a side where the image recording layer is provided is in a range of 0.2 μm to 20 μm.

According to an aspect of the present invention, it is preferable that the arithmetic average height Sa of the surface of the outermost layer on a side where the image recording layer is provided is in a range of 0.3 μm to 20 μm.

According to these aspects, in a case where the arithmetic average height Sa of at least any of the surface of the outermost layer of the planographic printing plate precursor on the side where the image recording layer is provided or the surface of the outermost layer on the side opposite to the side where the image recording layer is provided is set to be in a range of 0.2 μm to 20 μm, a planographic printing plate can be easily peeled off without interposing interleaving paper between planographic printing plate precursors in a case of lamination of planographic printing plate precursors. In a case where planographic printing plate precursors are laminated without interposing interleaving paper therebetween, side surfaces of a plurality of laminated planographic printing plate precursors are coated with the ink repellent agent, and the ink repellent agent applied to the side surfaces wraps around the surface so that the end portion on the side of the image recording layer can be coated with the ink repellent agent.

According to one aspect of the present invention, it is preferable that the image recording layer includes a water-soluble or water-dispersible negative type image recording layer.

In a case where the image recording layer is a water-soluble or water-dispersible negative type image recording layer, the developing capacity of the end portions of the planographic printing plate precursor is degraded, and edge stains easily occur. However, according to the present invention, since edge stains can be suppressed, the present invention can be suitably used for the water-soluble or water-dispersible negative type image recording layer.

In order to achieve the object of the present invention, there is provided a method of producing a planographic printing plate precursor according to an aspect of the present invention, comprising: a cutting step of cutting an aluminum support which has an anodized film thereon and an image recording layer containing an infrared absorbing agent on the anodized film to form a sagging shape having a sagging amount X of 25 μm to 150 μm and a sagging width Y of 70 μm to 300 μm on end portions of two opposing sides of the aluminum support; and an ink repellent agent treatment step of coating a part or the entire side surface of two opposing sides of the aluminum support on which the sagging shape has been formed, with an ink repellent agent.

In order to achieve the object of the present invention, there is provided a method of producing a planographic printing plate precursor according to an aspect of the present invention, comprising: a cutting step of cutting an aluminum support which has an anodized film thereon and an image recording layer containing an infrared absorbing agent on the anodized film to form a sagging shape with a sagging amount X of 25 μm to 150 μm and a sagging width Y of 70 μm to 300 μm on end portions of two opposing sides of the aluminum support; and an ink repellent agent treatment step of coating a part or the entire side surface of two opposing sides of the aluminum support on which the sagging shape has been formed and a region which extends to a distance of less than 1 cm from the end portions of the aluminum support on the image recording layer, with an ink repellent agent.

According to the aspect of the present invention, in the cutting step for the aluminum support, in a case where the sagging amount X and the sagging width Y of the end portion of the planographic printing plate precursor are set to be in the above-described range and a part or the entire side surface of two opposing sides at the end portion having the sagging shape is coated with the ink repellent agent, the edge stains of the edge end portion can be suppressed. Further, in a case where the region which extends to a distance of less than 1 cm from the end portions of the aluminum support on the image recording layer is coated with the ink repellent agent, the crack stains can be suppressed, and the image forming region can be sufficiently ensured. Further, in a case where the image recording layer contains an infrared absorbing agent, the storage stability under white light can be improved, the residual film of the film after development can be prevented, and thus edge stains can be suppressed.

According to the aspects of the planographic printing plate precursor and the method of producing the planographic printing plate precursor of the present invention, in a case where the sagging amount X and the sagging width Y of the end portion of the planographic printing plate precursor are respectively set to be in a predetermined range and the side surface of the aluminum support is coated with the ink repellent agent, it is possible to prevent occurrence of edge stains due to the corners which are the intersections of the surface and the side surfaces of the planographic printing plate precursor. Further, since the region of the ink repellent agent applied to the image forming layer can be narrowed by coating the side surface thereof with the ink repellent agent, the image forming region can be largely ensured.

**BRIEF DESCRIPTION OF THE DRAWINGS**

Fig. 1 is a schematic view illustrating an example of a cross-sectional shape of an end portion of a planographic printing plate precursor before being coated with an ink repellent agent.
Fig. 2 is a cross-sectional view schematically illustrating an anodized film.
Fig. 3 is a conceptual view illustrating an example of a cutting unit of a slitter device.
Fig. 4 is a view for describing a method of applying an ink repellent agent.
Fig. 5 is a view for describing another method of applying an ink repellent agent.
Fig. 6 is a view for describing still another method of applying an ink repellent agent.
Fig. 7 is a schematic view illustrating an example of a cross-sectional shape of an end portion of a planographic printing plate precursor having an ink repellent agent.
Fig. 8 is a schematic view illustrating another example of the cross-sectional shape of the end portion of the planographic printing plate precursor having an ink repellent agent.
Fig. 9 is a schematic view illustrating still another example of the cross-sectional shape of the end portion of the planographic printing plate precursor having an ink repellent agent.
Fig. 10 is a schematic view illustrating even still another example of the cross-sectional shape of the end portion of the planographic printing plate precursor having an ink repellent agent.
Fig. 11 is a view illustrating the planographic printing plate precursor as viewed from a side of an image recording layer.

**DESCRIPTION OF THE PREFERRED EMBODIMENTS**

Hereinafter, a planographic printing plate precursor and a method of producing a planographic printing plate precursor according to the embodiment of the present invention will be described with reference to the accompanying drawings. Further, in the present specification, the numerical ranges shown using "to" indicate ranges including the numerical values described before and after "to" as the lower limits and the upper limits.

The planographic printing plate precursor according to the present embodiment is as defined in the claims and includes an image recording layer which has an anodized film on an aluminum support, contains an infrared absorbing agent on the anodized film, and is capable of performing development using at least any of printing ink or dampening water on a cylinder of a printing press. The end portion of the planographic printing plate precursor has a sagging shape in which a sagging amount X is in a range of 25 μm to 150 μm and a sagging width Y is in a range of 70 μm to 300 μm. Further, a part or the entire side surface of two opposing sides of the aluminum support at the end portion having the sagging shape contains an ink repellent agent.

«Planographic printing plate precursor»

Fig. 1 is a schematic view illustrating an example of the cross-sectional shape of the end portion of the planographic printing plate precursor before being coated with an ink repellent agent. A planographic printing plate precursor 10a illustrated in the same figure includes an aluminum support 12, an anodized film 14, and an image recording layer 16.

Fig. 2 is a cross-sectional view schematically illustrating an anodized film. The aluminum support 12 has the

anodized film 14 on a side where the image recording layer 16 is formed. The anodized film 14 has micropores 14a extending from the surface thereof to a side of the aluminum support 12. Further, the term "micropores" here is a general term used to indicate pores in the anodized film and does not specify the size of the pore.

The planographic printing plate precursor according to the present embodiment has an end portion having a sagging shape. The planographic printing plate precursor having an end portion in a sagging shape has an excellent effect of preventing edge stains. In Fig. 1, the planographic printing plate precursor 10a has an end portion having a sagging shape 18. A distance X between the upper end (the boundary between the sagging shape 18 and an end surface 20) of an end surface 20 of the planographic printing plate precursor 10a and the extended line of a surface 22 of the image recording layer (the surface of a protective layer in a case where a protective layer has been formed) is referred to as a "sagging amount". Further, a distance Y between the point where the surface 22 of the image recording layer of the planographic printing plate precursor 10a begins to sag and the extended line of the end surface 20 is referred to as a "sagging width".

The sagging amount X of the end portion of the planographic printing plate precursor according to the present embodiment is 25 μm or greater, preferably 30 μm or greater, and more preferably 40 μm or greater. From the viewpoint of preventing deterioration of the on-press developability due to degradation of the surface state of the end portion, the upper limit of the sagging amount X is 150 μm or less, preferably 100 μm or less, and more preferably 80 μm or less. From the viewpoint of suppressing occurrence of cracks, the sagging width Y is in a range of 70 μm to 300 μm, preferably in a range of 70 μm to 250 μm, and more preferably in a range of 75 μm to 250 μm. The formation of the end portion having the sagging shape can be adjusted by, for example, the cutting conditions for the printing plate precursor. The cutting method will be described below. Further, cracks 15 may occur in a case of producing the printing plate precursor in order to form the sagging shape. In a case where ink remains in the cracks 15 during printing, since stains (crack stains) are generated due to the remaining ink, it is necessary to prevent crack stains by adjusting the size of the sagging shape and applying an ink repellent agent. It is preferable that the area proportion of cracks is 30% or less with respect to the cracks existing in the region corresponding to the sagging width Y of the surface of the anodized film 14. The amount of ink remaining in the cracks can be reduced by decreasing the area proportion of cracks, and thus crack stains can be suppressed.

In the planographic printing plate precursor according to the present embodiment, a part or the entire side surface of two opposing sides of the aluminum support 12 on a side of the end portion having the sagging shape has an ink repellent agent. The end portion of the planographic printing plate indicates an edge portion formed by a step of cutting a plate in the form of a sheet in the process of producing a planographic printing plate. The sheet-like planographic printing plate precursor has four end portions in the lateral direction and the longitudinal direction. In the planographic printing plate precursor according to the embodiment of the present invention, at least two opposing end portions may have the sagging shape having the above-described size, and a part or the entire side surface of the aluminum support 12 may have an ink repellent agent. For example, typically, it is preferable that in a case of newspaper printing, two opposing sides of the printing plate precursor along a rolling paper transport direction in the plane of printing paper correspond to the end portions. The material used as the ink repellent agent and the coating method will be described in detail below.

First, each configuration of the planographic printing plate precursor 10a will be described.

<Aluminum support>

The aluminum support 12 is a metal, which is dimensionally stable and contains aluminum as a main component, and is formed of aluminum or an aluminum alloy. Examples of the aluminum support 12 include a pure aluminum plate, an alloy plate containing aluminum as a main component and a trace amount of heteroelements, and a plastic film or paper formed by laminating or depositing aluminum (alloy).

Examples of the heteroelements contained in the aluminum alloy include a silicon element, an iron element, a manganese element, a copper element, a magnesium element, a chromium element, a zinc element, a bismuth element, a nickel element, and a titanium element, and the content of the heteroelements in the alloy is 10% by mass or less. A pure aluminum plate is suitable as the aluminum support 12, but it is difficult to produce completely pure aluminum because of a smelting technology. Therefore, an aluminum plate containing a trace amount of heteroelements may be used.

The composition of the aluminum support 12 is not particularly limited, and publicly known materials (for example, JIS A 1050, JIS A 1100, JIS A 3103, and JIS A 3005) can be appropriately used.

The width of the aluminum support 12 is preferably approximately 400 to 2000 mm, and the thickness thereof is preferably approximately 200 to 400 μm. Further, the thickness is preferably 300 ± 50 μm. The width and the thickness thereof can be appropriately changed depending on the size of the printing press, the size of the printing plate, and the user’s desire.

<Anodized film>

The anodized film 14 is a film to be prepared typically on a surface of the aluminum support 12 by performing an anodization treatment, and this film is substantially perpendicular to the film surface and has extremely fine micropores 14a uniformly distributed. The micropores 14a extend along the thickness direction (a side of the aluminum support 12) from the surface (the surface of the anodized film 14 on a side opposite to a side where the aluminum support 12 is provided) of the anodized film 14 on a side of the image recording layer 16.

The average diameter (average opening diameter) of the micropores 14a in the surface of the anodized film 14 is in a range of 10 nm to 100 nm. From the viewpoint of the balance between the resistance to edge stains and the printing durability, the average opening diameter thereof is preferably in a range of 15 nm to 80 nm, more preferably in a range of 20 nm to 50 nm, and still more preferably in a range of 25 nm to 40 nm. In a case where the average diameter of the micropores 14a is set to be in the above-described range, the image recording layer 16 can be allowed to infiltrate into the micropores 14a, the adhesiveness between the anodized film 14 and the image recording layer 16 can be increased, and the printing durability can be improved.

The average diameter of micropores 14a is a value obtained by observing the surfaces of 4 sheets (N = 4) of anodized films 14 using a field emission-scanning electron microscope (FE-SEM) at a magnification of 150000, measuring the diameters of micropores present in a range of $400 \times 600$ nm$^2$ in the obtained four sheets of images, and averaging the values. Further, in a case where the shape of the micropores 14a is not circular, the equivalent circle diameter is used. The "equivalent circle diameter" is a diameter of a circle obtained by assuming the shape of an opening portion of a micropore as a circle having the same projected area as the projected area of the opening portion.

The shape of such a micropore is formed by using phosphoric acid during the anodization treatment described below.

The depth of the micropores 14a is not particularly limited, but is preferably in a range of 10 nm to 3000 nm, more preferably in a range of 50 nm to 2000 nm, and still more preferably in a range of 300 nm to 1600 nm. Further, the depth thereof is a value obtained by capturing an image (at a magnification of 150000) of a cross section of the anodized film 14, measuring the depth of 25 or more micropores 14a, and averaging the obtained values.

The shape of the micropores 14a is not particularly limited, and the shape thereof in Fig. 2 is a substantially straight tubular shape (substantially cylindrical shape), but may be a conical shape whose diameter decreases toward the depth direction (thickness direction). Further, the shape of the bottom portion of the micropores 14a is not particularly limited, but may be a curved shape (projection shape) or a planar shape.

The range of a steepness a45 representing the area proportion of a portion having an inclining degree of 45° or greater obtained by extracting a component with a wavelength of 0.2 μm to 2 μm in the surface of the anodized film 14 on a side of the image recording layer 16 is not particularly limited, but is preferably 25% or less, more preferably 20% or less, and still more preferably 18% or less from the viewpoint of improving the stain resistance and the printing durability. The lower limit thereof is not particularly limited, but is 5% or greater in many cases.

The steepness a45 is a factor representing the surface shape and is a value acquired according to the following procedures (1) to (3).

(1) The surface shape is measured to acquire three-dimensional data.

First, the surface shape of the aluminum support 12 on a side of the anodized film 14 is measured using an atomic force microscope (AFM) to acquire three-dimensional data.

The measurement is performed under the following conditions. Specifically, the aluminum support 12 is cut into a size of 1 cm$^2$ and set on a horizontal sample stand that is provided on a piezo scanner, a cantilever is allowed to approach the surface of the sample, scanning is performed in the XY direction after reaching a region where the atomic force works, and the unevenness of the sample is captured by the displacement of the piezo in the Z direction. A piezo scanner capable of performing scanning a distance of 150 μm in the XY direction and a distance of 10 μm in the Z direction is used as the piezo scanner. The measurement is performed using a cantilever having a resonance frequency of 120 kHz to 150 kHz and a spring constant of 12 to 20 N/m (SI-DF20, manufactured by Nanoprobes Inc.) in a dynamic force mode (DFM) as the cantilever. Further, by carrying out the least squares approximation of the acquired three-dimensional data, the slight inclination of the sample is corrected to acquire a reference surface.

During the measurement, $512 \times 512$ points in an area having a size of $25 \times 25$ μm on the surface are measured. The resolution in the XY direction is 1.9 μm, the resolution in the Z direction is 1 nm, and the scanning speed is 60 μm/sec.

(2) The correction is performed.

In the calculation of the steepness a45, a component having a wavelength of 0.2 μm to 2 μm which is selected from the three-dimensional data acquired in (1) described above and then corrected is used. Due to this correction, in

a case where a surface of an aluminum support or the like used in the planographic printing plate precursor which has deep unevenness is scanned using a probe of an AFM, a noise occurring in a case where the probe strikes an edge portion of a projection and springs so that a portion other than a pointed end of the probe is brought into contact with a wall surface of a deep depression can be eliminated.

The correction is carried out by performing fast Fourier transformation on the three-dimensional data acquired in (1) described above to acquire the frequency distribution, selecting a component having a wavelength of 0.2 μm to 2 μm, and performing Fourier inverse transformation.

(3) The steepness a45 is calculated.

Three points adjacent to one another are extracted using the three-dimensional data (f(x, y)) obtained by performing correction in (2) described above, an angle between a small triangle formed of these three points and the reference surface is calculated for all pieces of data to acquire the inclining degree distribution curve. In addition, the sum of the area of the small triangle is acquired and this area is set as the actual area. Based on the inclining degree distribution curve, the steepness a45 (unit: %) which is a ratio of the area of a portion having an inclining degree of 45° or greater to the actual area is calculated.

The range of a specific surface area ΔS which is a value acquired by Equation (i) based on a geometric measurement area $S_0$ and an actual area $S_x$ obtained by an approximation three point method from the three-dimensional data to be obtained by measuring 512 × 512 points in an area having a size of 25 μm × 25 μm on the surface of the anodized film 14 on a side of the image recording layer 16 using an atomic force microscope is not particularly limited, but is preferably 20% or greater, more preferably in a range of 20% to 40%, and still more preferably in a range of 25% to 35% from the viewpoint of improving the stain resistance, the printing durability, and the image visibility.

$$\Delta S = (S_x - S_0)/S_0 \times 100\ (\%) \cdots (i)$$

In the measurement of ΔS described above, the three-dimensional data (f(x, y)) is obtained according to the same procedures as in (1) that is to be performed at the time of calculating the steepness a45. Next, three points adjacent to one another are extracted using the three-dimensional data (f(x, y)) obtained in the above-described manner, the sum of the area of the small triangle formed of these three points is acquired, and this area is set as an actual area $S_x$. The specific surface area ΔS is acquired by Equation (i) based on the obtained actual area $S_x$ and the obtained geometric measurement area $S_0$.

[Undercoat layer]

The undercoat layer is a layer disposed between the anodized film 14 and the image recording layer 16 and improves the adhesiveness therebetween. In addition, the undercoat layer is a layer provided as necessary and may not be included in the planographic printing plate precursor.

The configuration of the undercoat layer is not particularly limited, but it is preferable that the undercoat layer contains a compound having a betaine structure. The betaine structure is a structure having at least one cation and at least one anion. Further, the number of cations is typically the same as the number of anions so as to be neutral as a whole. However, in a case where the number of cations is not the same as the number of anions, the betaine structure may have a required amount of counter ions in order to cancel the charge.

It is preferable that the betaine structure is any of the structures represented by Formulae (1), (2), and (3).

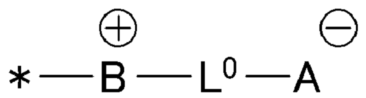

Formula (1)

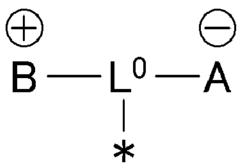

Formula (2)

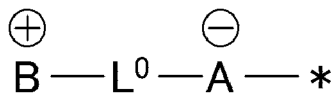

Formula (3)

In the formulae, $A^-$ represents a structure having an anion, $B^+$ represents a structure having a cation, and $L^0$ represents a linking group. The symbol "*" represents a linking site (linking position).

It is preferable that $A^-$ represents a structure having an anion such as a carboxylate, a sulfonate, a phosphonate, or a phosphinate and $B^+$ represents a structure having a cation such as ammonium, phosphonium, iodonium, or sulfonium.

$L^0$ represents a linking group. In Formulae (1) and (3), examples of $L^0$ include divalent linking groups. Among

these, -CO-, -O-, -NH-, a divalent aliphatic group, a divalent aromatic group, or a combination thereof is preferable. In Formula (2), examples of $L^0$ include trivalent linking groups.

The undercoat layer may be a layer containing a compound other than the compound having a betaine structure. For example, the undercoat layer may contain a compound containing a hydrophilic group. Examples of the hydrophilic group include a carboxylic acid group and a sulfonic acid group. The compound containing a hydrophilic group may further contain a radically polymerizable reactive group.

<Image recording layer>

As the image recording layer 16, an image recording layer which can be removed by at least any of printing ink or dampening water is preferable. It is preferable that the image recording layer 16 is a photosensitive layer. Hereinafter, each constitutional component of the image recording layer 16 will be described.

(Infrared absorbing agent)

The image recording layer 16 contains an infrared absorbing agent. It is preferable that the infrared absorbing agent has maximum absorption at a wavelength range of 750 to 1400 nm. Particularly, since on-press development is carried out by a printing press under white light in an on-press development type printing plate precursor, a printing plate precursor with excellent developability can be obtained by using an infrared absorbing agent having the maximum absorption at a wavelength range of 750 to 1400 nm, which is not easily affected by the white light. A dye or a pigment is preferable as the infrared absorbing agent.

As the dye, commercially available dyes and known dyes described in the literatures, for example, "Dye Handbook" (edited by The Society of Synthetic Organic Chemistry, Japan, published in 1970) are exemplified.

Examples of the dye include a cyanine coloring agent, a squarylium coloring agent, a pyrylium salt, a nickel thiolate complex, and an indolenine cyanine coloring agent. Among these, a cyanine coloring agent or an indolenine cyanine coloring agent is preferable, a cyanine coloring agent is more preferable, and a cyanine coloring agent represented by Formula (a) is still more preferable.

Formula (a)

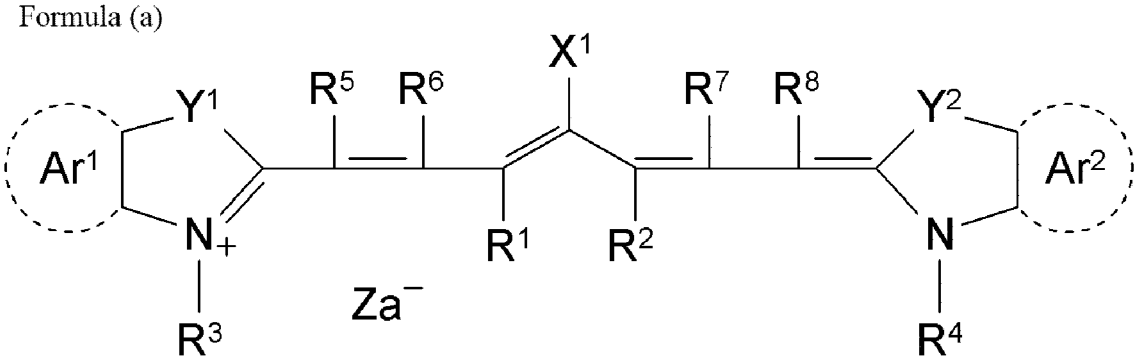

In Formula (a), $X^1$ represents a hydrogen atom, a halogen atom, $-N(R^9)(R^{10})$, $-X^Z-L^1$, or a group shown below.

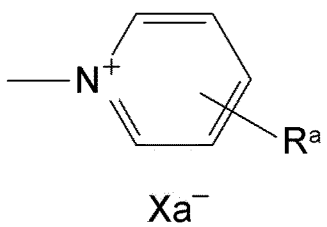

$R^9$ and $R^{10}$ each independently represent an aromatic hydrocarbon group, an alkyl group, or a hydrogen atom, and $R^9$ and $R^{10}$ may be bonded to each other to form a ring. Among these, a phenyl group is preferable.

$X^2$ represents an oxygen atom or a sulfur atom, and $L^1$ represents a hydrocarbon group having 1 to 12 carbon atoms which may have heteroatoms (such as N, S, O, a halogen atom, and Se).

$X_a^-$ has the same definition as that for $Z_a^-$ described below, and $R^a$ represents a hydrogen atom, an alkyl group, an aryl group, an amino group, or a halogen atom.

$R^1$ and $R^2$ each independently represent a hydrocarbon group having 1 to 12 carbon atoms. Further, $R^1$ and $R^2$ may be bonded to each other to form a ring, and it is preferable that a 5- or 6-membered ring is formed in a case of forming a ring.

$Ar^1$ and $Ar^2$ each independently represent an aromatic hydrocarbon group which may have a substituent (for example, an alkyl group). As the aromatic hydrocarbon group, a benzene ring group or a naphthalene ring group is preferable.

$Y^1$ and $Y^2$ each independently represent a sulfur atom or a dialkyl methylene group having 12 or less carbon atoms.

$R^3$ and $R^4$ each independently represent a hydrocarbon group having 20 or less carbon atoms which may have a substituent (such as an alkoxy group).

$R^5$, $R^6$, $R^7$, and $R^8$ each independently represent a hydrogen atom or a hydrocarbon group having 12 or less carbon atoms.

Further, Za' represents a counter anion. Here, Za' is not necessary in a case where the cyanine coloring agent represented by Formula (a) has an anionic substituent in the structure thereof and neutralization of the charge is not required. Examples of $Za^-$ include a halide ion, a perchlorate ion, a tetrafluoroborate ion, a hexafluorophosphate ion, and a sulfonic acid ion. Among these, a perchlorate ion, a hexafluorophosphate ion, or an arylsulfonic acid ion is preferable.

The above-described infrared absorbing dyes may be used alone or in combination of two or more kinds thereof. Further, infrared absorbing agents other than the infrared absorbing dyes such as pigments may be used in combination. As the pigments, the compounds described in paragraphs 0072 to 0076 in JP2008-195018A are preferable.

The content of the infrared absorbing agent is preferably in a range of 0.05% to 30% by mass and more preferably in a range of 0.1% to 20% by mass with respect to the total mass of the image recording layer.

(Polymerization initiator)

It is preferable that the image recording layer 16 contains a polymerization initiator. As the polymerization initiator, a compound (so-called radical polymerization initiator) that generates a radical using light, heat, or the energy of both light and heat and initiates polymerization of a compound containing a polymerizable unsaturated group is preferable. Examples of the polymerization initiator include a photopolymerization initiator and a thermal polymerization initiator.

As the polymerization initiator, specifically, the polymerization initiators described in paragraphs 0115 to 0141 described in JP2009-255434Acan be used.

Further, from the viewpoints of the reactivity and the stability, an oxime ester compound or an onium salt such as a diazonium salt, an iodonium salt, or a sulfonium salt is preferable as the polymerization initiator.

The content of the polymerization initiator is preferably in a range of 0.1% to 50% by mass and more preferably in a range of 0.5% to 30% by mass with respect to the total mass of the image recording layer.

(Polymerizable compound)

It is preferable that the image recording layer 16 contains a polymerizable compound. As the polymerizable compound, an addition-polymerizable compound having at least one ethylenically unsaturated bond is preferable. Among the examples, a compound having at least one (preferably two) terminal ethylenically unsaturated bond is more preferable. A so-called radically polymerizable compound is more preferable.

Examples of the polymerizable compound include the polymerizable compounds described in paragraphs 0142 to 0163 of JP2009-255434A.

Further, a urethane-based addition-polymerizable compound produced using the addition reaction between isocyanate and a hydroxyl group is also suitable. Specific examples thereof include a vinyl urethane compound containing two or more polymerizable vinyl groups in one molecule which is obtained by adding a vinyl monomer that contains a hydroxyl group represented by Formula (A) to a polyisocyanate compound containing two or more isocyanate groups in one molecule described in JP1973-041708B (JP-S48-041708B).

$$CH_2=C(R^4)COOCH_2CH(R^5)OH \qquad (A)$$

(Here, $R^4$ and $R^5$ represent H or $CH_3$.)

The content of the polymerizable compound is preferably in a range of 3% to 80% by mass and more preferably in a range of 10% to 75% by mass with respect to the total mass of the image recording layer.

(Polymer compound)

It is preferable that the image recording layer contains a polymer compound. Specific examples of the polymer compound include an acrylic resin, a polyvinyl acetal resin, a polyurethane resin, a polyurea resin, a polyimide resin, a polyamide resin, an epoxy resin, a methacrylic resin, a polystyrene-based resin, a novolak type phenolic resin, a polyester resin, synthetic rubber, and natural rubber.
The polymer compound may have a crosslinking property in order to improve the film hardness of the image area. In order to allow the polymer compound to have the crosslinking property, a crosslinkable functional group such as an ethylenically unsaturated bond may be introduced to the main chain or a side chain of the polymer. The crosslinkable functional group may be introduced by copolymerization.
As the polymer compound, the polymer compounds (binder polymers) disclosed in paragraphs 0164 to 0172 of JP2009-255434A can be used.
It is preferable that the polymer compound has a hydrophobic main chain and both a repeating unit which contains a pendant-cyano group (-C=N) directly bonded to the hydrophobic main chain and a repeating unit which contains a pendant group having a hydrophilic polyalkylene oxide segment.
Examples of the repeating unit containing a pendant-cyano group include $-[CH_2CH(C\equiv N)]-$ and $-[CH_2C(CH_3)(C\equiv N)]-$.
The repeating unit containing a pendant-cyano group can be derived from an ethylene-based unsaturated monomer (such as acrylonitrile or methacrylonitrile) or a combination thereof.
The poly(alkylene oxide) segment is, for example, an oligomer or polymer that has a block formed of an alkylene oxide unit. Examples of the alkylene oxide unit include an alkylene oxide group having 1 to 6 carbon atoms. Among the examples, an alkylene oxide group having 1 to 3 carbon atoms is preferable.
As a suitable embodiment of the pendant group that contains a poly(alkylene oxide) segment, a group represented by the following formula is exemplified.

$$-C(=O)O-[(CH_2)_xO-]_yR$$

In the formula, x represents 1 to 3, y represents 5 to 150, and R represents an alkyl group.
The content of the polymer compound is preferably in a range of 5% to 90% by mass and more preferably in a range of 5% to 70% by mass with respect to the total mass of the image recording layer.

(Thermoplastic polymer particles)

The image recording layer may contain thermoplastic polymer particles. Specific examples of a polymer constituting thermoplastic polymer particles include homopolymers or copolymers of monomers such as ethylene, styrene, vinyl chloride, methyl acrylate, ethyl acrylate, methyl methacrylate, ethyl methacrylate, vinylidene chloride, acrylonitrile, vinyl carbazole, acrylate having a polyalkylene structure, and methacrylate having a polyalkylene structure, and mixtures thereof. Among these, polystyrene, a copolymer containing styrene and acrylonitrile, or polymethyl methacrylate is preferable. Among these, an acrylonitrile copolymer is preferable. Printing durability can be improved by using polymer particles formed of an acrylonitrile copolymer. The average particle diameter of the thermoplastic polymer particles is preferably in a range of 0.01 to 3.0 μm.

(Surfactant)

The image recording layer may contain a surfactant in order to promote the on-press developability at the time of the start of printing and improve the state of the coated surface. Examples of the surfactant include a non-ionic surfactant, an anionic surfactant, a cationic surfactant, an amphoteric surfactant, and a fluorine-based surfactant. As the surfactant, the surfactants disclosed in paragraphs [0175] to [0179] of JP2009-255434A can be used. The content of the surfactant is preferably in a range of 0.001% to 10% by mass and more preferably in a range of 0.01% to 5% by mass with respect to the total mass of the image recording layer.
The image recording layer may further contain compounds other than those described above as necessary.
Examples of other compounds include the coloring agent, the printing agent, the polymerization inhibitor, the higher fatty acid derivative, the plasticizer, the inorganic fine particles, and the low-molecular-weight hydrophilic compound disclosed in paragraphs [0181] to [0190] of JP2009-255434A.
Further, other examples thereof include the hydrophobic precursor (fine particles capable of converting an image recording layer to be hydrophobic in a case of addition of heat), the low-molecular-weight hydrophilic compound, the sensitizing agent (for example, a phosphonium compound, a nitrogen-containing low-molecular-weight compound, or an ammonium group-containing polymer), and the chain transfer agent disclosed in paragraphs [0191] to [0217] of

JP2012-187907A.

<Other components>

The planographic printing plate precursor 10a according to the embodiment may include a layer other than the aluminum support 12, the anodized film 14, the undercoat layer, and the image recording layer 16 described above.

For example, for the purpose of preventing occurrence of scratches on the image recording layer 16, blocking oxygen, and preventing ablation in a case of exposure to a high-illuminance laser, a protective layer may be provided on the image recording layer 16 as necessary.

Examples of the material used for the protective layer include the materials (such as a water-soluble polymer compound and an inorganic layered compound) described in paragraphs 0213 to 0227 of JP2009-255434A.

<Method of producing printing plate precursor>

Hereinafter, an example of a method of producing the planographic printing plate precursor according to the present embodiment will be described.

In production of the planographic printing plate precursor, first, the anodized film 14 is formed on the aluminum support 12. As a method of forming the anodized film 14 on the aluminum support 12, for example, a production method in which the following steps are sequentially performed is preferable.

(Roughening treatment step) A step of performing a roughening treatment on the aluminum support 12
(Anodization treatment step) A step of anodizing the aluminum support 12 which has been subjected to the roughening treatment
(Pore widening treatment step) A step of widening the diameter of micropores 14a in the anodized film 14 by bringing the aluminum support 12 having the anodized film 14 obtained in the anodization treatment step into contact with an acid aqueous solution or an alkali aqueous solution
Hereinafter, the procedures of each step will be described in detail.

(Roughening treatment step)

The roughening treatment step is a step of performing a roughening treatment including an electrochemical roughening treatment on a surface of the aluminum support 12. It is preferable that the present step is performed before the anodization treatment step described below, but may not be performed in a case where the surface of the aluminum support 12 already has a preferable surface shape.

The roughening treatment may be carried out by performing only an electrochemical roughening treatment, but may be carried out by combining an electrochemical roughening treatment and a mechanical roughening treatment and/or a chemical roughening treatment. In a case where the mechanical roughening treatment is combined with the electrochemical roughening treatment, it is preferable that the electrochemical roughening treatment is performed after the mechanical roughening treatment. It is preferable that the electrochemical roughening treatment is performed in an aqueous solution mainly containing nitric acid or hydrochloric acid using the direct current or the alternating current. The method of performing the mechanical roughening treatment is not particularly limited, and the methods described in JP1975-040047B (JP-S50-040047B) are exemplified. The chemical roughening treatment is also not particularly limited, and known methods are exemplified. It is preferable that a chemical etching treatment is performed after the mechanical roughening treatment. The chemical etching treatment to be performed after the mechanical roughening treatment is performed in order to smooth an edge portion of the uneven shape of the surface of the aluminum plate, prevent the ink from being caught during printing, improve the stain resistance of the printing plate, and remove unnecessary matter such as abrasive material particles remaining on the surface. Examples of the chemical etching treatment include etching carried out using an acid and etching carried out using an alkali, and a chemical etching treatment carried out using an alkali aqueous solution is exemplified as a particularly excellent method in terms of etching efficiency.

(Anodization treatment step)

The anodization treatment step is not particularly limited as long as the micropores 14a can be obtained, and can be performed by a known method. In the anodization treatment step, an aqueous solution containing sulfuric acid, phosphoric acid, oxalic acid, and the like can be used as an electrolytic cell. For example, the concentration of the sulfuric acid is in a range of 100 to 300 g/L. The conditions for the anodization treatment are appropriately set depending on the electrolytic solution. As an example of the conditions, the solution temperature is in a range of 5°C to 70°C (preferably in a range of 10°C to 60°C), the current density is in a range of 0.5 to 60 A/dm$^2$ (preferably in a range of 5 to 60 A/dm$^2$),

the voltage is in a range of 1 to 100 V (preferably in a range of 5 to 50 V), the electrolysis time is in a range of 1 to 100 seconds (preferably in a range of 5 to 60 seconds), and the coated film amount is in a range of 0.1 to 5 $g/m^2$ (preferably in a range of 0.2 to 3 $g/m^2$).

(Pore widening treatment)

A pore widening treatment is a treatment (pore diameter widening treatment) of widening the diameter (pore diameter) of micropores 14a present in the anodized film 14 formed by the above-described anodization treatment step.
The pore widening treatment can be performed by bringing the aluminum support 12 obtained in the anodization treatment step into contact with an acid aqueous solution or an alkali aqueous solution. The method of bringing the aluminum support into contact with the solution is not particularly limited, and examples thereof include an immersion method and a spray method.

(Undercoat layer forming step)

An undercoat layer forming step is a step of forming the undercoat layer on the aluminum support 12 (anodized film 14). The method of producing the undercoat layer is not particularly limited, and examples thereof include a method of coating the anodized film with a coating solution for forming an undercoat layer which contains a predetermined compound (such as a compound having a betaine structure).
It is preferable that the coating solution for forming an undercoat layer contains a solvent. Examples of the solvent include water and an organic solvent. Examples of the method of coating the film with the coating solution for forming an undercoat layer include various known methods. Examples of the known methods include a bar coater coating method, a rotary coating method, a spray coating method, a curtain coating method, a dip coating method, an air knife coating method, a blade coating method, and a roll coating method. The coating amount (solid content) of the undercoat layer is preferably in a range of 0.1 to 100 $g/m^2$ and more preferably in a range of 1 to 50 $g/m^2$.

(Image recording layer forming step)

An image recording layer forming step is a step of forming the image recording layer 16. The method of forming the image recording layer 16 is not particularly limited, and examples thereof include a method of coating the anodized film or the undercoat layer of the aluminum support with a coating solution for forming an image recording layer that contains a predetermined component (such as the infrared absorbing agent, the polymerization initiator, or the polymerizable compound described above). It is preferable that the coating solution for forming an image recording layer contains a solvent. Examples of the solvent include water and an organic solvent. Examples of the method of applying the coating solution for forming an image recording layer include the methods exemplified as the method of applying the coating solution for forming an undercoat layer. The coating amount (solid content) of the image recording layer varies depending on the purpose thereof, but is typically preferably in a range of 0.3 to 3.0 $g/m^2$.

(Protective layer forming step)

In a case where a protective layer is provided on the image forming layer, the method of producing the protective layer is not particularly limited, and examples thereof include a method of coating the image recording layer with a coating solution for forming a protective layer which contains a predetermined component.

(Cutting step)

The cutting can be performed by using a known cutting method. Preferred examples thereof include the methods described in JP1996-058257A (JP-H08-058257A), JP1997-211843A (JP-H09-211843A, JP1998-100556A (JP-H10-100556A), and JP1999-052579A(JP-H11-052579A).
In the cutting, the gap between the upper cutting blade and the lower cutting blade, the biting amount, the blade edge angle, and the like of a slitter device used for cutting the planographic printing plate precursor are appropriately adjusted. In the present embodiment, the above-described conditions are appropriately adjusted so as to obtain a sagging shape in which the sagging amount X is in a range of 25 μm to 150 μm and the sagging width Y is in a range of 70 μm to 300 μm.
Fig. 3 is a cross-sectional view illustrating a cutting unit of a slitter device. A pair of upper and lower cutting blades 30 and 32 are disposed on the slitter device in the lateral direction. The cutting blades 30 and 32 are formed of circular blades on a disk, and upper cutting blades 30a and 30b are coaxially supported by a rotating shaft 34 and lower cutting blades 32a and 32b are coaxially supported by a rotating shaft 36. The upper cutting blades 30a and 30b and

the lower cutting blades 32a and 32b rotate in opposite directions. The planographic printing plate precursor 10a is cut into a predetermined width by passing between the upper cutting blades 30a and 30b and the lower cutting blades 32a and 32b. End portions having a sagging shape can be formed by adjusting the gap between the upper cutting blade 30a and the lower cutting blade 32a and the gap between the upper cutting blade 30b and the lower cutting blade 32b of the cutting unit of the slitter device.

(Step of applying coating solution containing ink repellent agent [ink repellent treatment step])

An end surface of the planographic printing plate precursor after the cutting is coated with a coating solution containing an ink repellent agent so that the ink repellent agent is applied to a side surface of the aluminum support. In the planographic printing plate precursor according to the present embodiment, a part or the entire side surface of two opposing sides of the aluminum support at an end portion of the planographic printing plate precursor on which the sagging shape has been formed contains an ink repellent agent. The ink repellent agent is not particularly limited as long as the agent can repel the ink, and a hydrophilizing agent, a desensitizing liquid, or the like can be used as the ink repellent agent. Hereinafter, materials used as the ink repellent agent will be described.

(Hydrophilizing agent)

A phosphoric acid compound is exemplified as one suitable embodiment of the hydrophilizing agent. The phosphoric acid compound includes phosphoric acid, a salt thereof, and an ester thereof. Examples thereof include phosphoric acid, metaphosphoric acid, ammonium monophosphate, ammonium diphosphate, sodium dihydrogen phosphate, sodium monohydrogen phosphate, potassium monophosphate, potassium diphosphate, sodium tripolyphosphate, potassium pyrophosphate, and sodium hexametaphosphate. Among these, sodium dihydrogen phosphate, sodium monohydrogen phosphate, or sodium hexametaphosphate is preferable.

As the phosphoric acid compound, a polymer compound is preferable, and a polymer compound that contains a phosphoric acid ester group is more preferable. Examples of the polymer compound that contains a phosphoric acid ester group include a polymer formed of one or more monomers containing a phosphoric acid ester group in a molecule, a copolymer of one or more monomers containing a phosphoric acid ester group and one or more monomers that do not contain a phosphoric acid ester group, and a polymer obtained by introducing a phosphoric acid ester group to a polymer that does not contain a phosphoric acid ester group using a polymer reaction.

Examples of the monomer containing a phosphoric acid group or a salt thereof include mono(2-(meth)acryloyloxyethyl) acid phosphate, mono(3-(meth)acryloyloxypropyl) acid phosphate, mono(3-(meth)acryloyloxy-2-hydroxypropyl) acid phosphate, mono(2-(meth)acryloyloxy-3-hydroxypropyl) acid phosphate, mono(3-chloro-2-(meth)acryloyloxypropyl)acid phosphate, mono(3 -(meth)acryloyloxy-3 -chloro-2-hydroxypropyl) acid phosphate, mono((meth)acryloyloxypolyethylene glycol) acid phosphate, mono((meth)acryloyloxypolypropylene glycol) acid phosphate, allyl alcohol acid phosphate, and salts of these phosphoric acid residues.

As the monomer that does not contain a phosphoric acid ester group in the copolymer, a monomer containing a hydrophilic group is preferable. Examples of the hydrophilic group include a hydroxy group, an alkylene oxide structure, an amino group, an ammonium group, and an amide group. Among these, a hydroxy group, an alkylene oxide structure, or an amide group is preferable, an alkylene oxide structure having 1 to 20 alkylene oxide units with 2 or 3 carbon atoms is more preferable, and a polyethylene oxide structure having 2 to 10 ethylene oxide units is still more preferable. Examples thereof include 2-hydroxyethyl acrylate, ethoxy diethylene glycol acrylate, methoxy triethylene glycol acrylate, poly(oxyethylene) methacrylate, N-isopropyl acrylamide, and acrylamide.

The content of the repeating unit that contains a phosphoric acid ester group in the polymer compound containing a phosphoric acid ester group is preferably in a range of 1% to 100% by mole, more preferably in a range of 5% to 100% by mole, and still more preferably in a range of 10% to 100% by mole with respect to the total amount of all repeating units in the polymer compound. The mass average molecular weight of the polymer compound that contains a phosphoric acid ester group is preferably in a range of 5000 to 1000000, more preferably in a range of 7000 to 700000, and still more preferably in a range of 10000 to 500000.

A phosphonic acid compound is exemplified as one suitable embodiment of the hydrophilizing agent. The phosphonic acid compound includes phosphonic acid, a salt thereof, and an ester thereof. Examples thereof include ethyl phosphonic acid, propyl phosphonic acid, isopropyl phosphonic acid, butyl phosphonic acid, hexyl phosphonic acid, octyl phosphonic acid, dodecyl phosphonic acid, octadecyl phosphonic acid, 2-hydroxyethylphosphonic acid and sodium salts thereof or potassium salts thereof; alkyl phosphonic acid monoalkyl ester such as methyl methylphosphonate, methyl ethylphosphonate, or methyl 2-hydroxyethylphosphonate and sodium salts thereof or potassium salts thereof; alkylene diphosphonic acid such as methylene diphosphonic acid or ethylene diphosphonic acid and sodium salts thereof or potassium salts thereof; and polyvinyl phosphonic acid.

A polymer compound is preferable as the phosphonic acid compound. Preferred examples of the polymer

compound as the phosphonic acid compound include polyvinyl phosphonic acid, a polymer formed of one or more monomers containing a phosphonic acid group or a phosphonic acid monoester group in a molecule, and a copolymer of one or more monomers containing a phosphonic acid group or a phosphonic acid monoester group and one or more monomers that do not contain any of a phosphonic acid group and a phosphonic acid monoester group.

Examples of the monomer that contains a phosphonic acid group or a salt thereof include vinylphosphonic acid, ethyl phosphonic acid monovinyl ester, (meth)acryloylaminomethylphosphonic acid, 3-(meth)acryloyloxypropylphosphonic acid, and salts of these phosphonic acid residues.

Preferred examples of the polymer compound include a homopolymer of a monomer containing a phosphonic acid ester group and a copolymer of a monomer containing a phosphonic acid ester group and a monomer containing no phosphonic acid ester group. A monomer containing a hydrophilic group is preferable as the monomer that does not contain a phosphonic acid ester group in the copolymer. Examples of the monomer containing a hydrophilic group include 2-hydroxyethyl acrylate, ethoxydiethylene glycol acrylate, methoxytriethylene glycol acrylate, poly(oxyethylene) methacrylate, N-isopropylacrylamide, and acrylamide.

The content of the repeating unit that contains a phosphonic acid ester group in the polymer compound containing a phosphonic acid ester group is preferably in a range of 1% to 100% by mole, more preferably in a range of 3 100% by mole, and still more preferably in a range of 5 to 100% by mole with respect to the total amount of all repeating units of the polymer compound.

The mass average molecular weight of the polymer compound that contains a phosphonic acid ester group is preferably in a range of 5000 to 1000000, more preferably in a range of 7000 to 700000, and still more preferably in a range of 10000 to 500000.

A water-soluble resin is exemplified as one suitable embodiment of the hydrophilizing agent. Examples of the water-soluble resin include water-soluble resins classified as polysaccharides, polyvinyl alcohol, polyvinylpyrrolidone, polyacrylamide and a copolymer thereof, a vinyl methyl ether/maleic acid anhydride copolymer, a vinyl acetate/maleic acid anhydride copolymer, and a styrene/maleic acid anhydride copolymer. Examples of the polysaccharides include starch derivatives (such as dextrin, enzymolysis dextrin, hydroxypropylated starch, carboxymethylated starch, phosphoric acid esterified starch, polyoxyalkylene grafted starch, and cyclodextrin), celluloses (such as carboxymethyl cellulose, carboxyethyl cellulose, methyl cellulose, hydroxypropyl cellulose, and methylpropyl cellulose), carrageenan, alginic acid, guar gum, locust bean gum, xanthan gum, gum arabic, and soy polysaccharides. Preferred examples of the water-soluble resin include starch derivatives such as dextrin and polyoxyalkylene grafted starch, gum arabic, carboxymethyl cellulose, and soy polysaccharides.

An anionic surfactant and a non-ionic surfactant are exemplified as one suitable embodiment of the hydrophilizing agent. Examples of the anionic surfactant include those described in paragraph 0022 of JP2014-104631A. Preferred examples of the anionic surfactant include dialkyl sulfosuccinates, alkyl sulfuric acid ester salts, polyoxyethylene aryl ether sulfuric acid ester salts, and alkyl naphthalene sulfonates. As the anionic surfactant, an anionic surfactant represented by Formula (I-A) or Formula (I-B) is preferable.

$$(R^1)_p — Ar^1 — (\overset{\ominus}{SO_3})_q \ \overset{\oplus}{M_1} \qquad (I-A)$$

$$(R^2)_m — Ar^2 — Y{-}O(R^3O)_n{-}\overset{\ominus}{SO_3} \ \overset{\oplus}{M_2} \qquad (I-B)$$

In Formula (I-A), $R^1$ represents a linear or branched alkyl group having 1 to 20 carbon atoms, p represents 0, 1, or 2, $Ar^1$ represents an aryl group having 6 to 10 carbon atoms, q represents 1, 2, or 3, and $M_1^+$ represents $Na^+$, $K^+$, $Li^+$, or $NH_4^+$. In a case where p represents 2, a plurality of $R^1$'s may be the same as or different from one another.

In Formula (I-B), $R^2$ represents a linear or branched alkyl group having 1 to 20 carbon atoms, m represents 0, 1, or 2, $Ar^2$ represents an aryl group having 6 to 10 carbon atoms, Y represents a single bond or an alkylene group having 1 to 10 carbon atoms, $R^3$ represents a linear or branched alkylene group having 1 to 5 carbon atoms, n represents an integer of 1 to 100, and $M_2^+$ represents $Na^+$, $K^+$, $Li^+$, or $NH_4^+$. In a case where m represents 2, a plurality of $R^2$'s may be the same as or different from one another. Further, in a case where n represents 2 or greater, a plurality of R3's may be the same as or different from one another.

In Formulae (I-A) and (I-B), it is preferable that $R^1$ and $R^2$ represent $CH_3$, $C_2H_5$, $C_3H_7$, or $C_4H_9$. $R^3$ represents preferably $-CH_2-$, $-CH_2CH_2-$, $-CH_2CH_2CH_2-$, or $-CH_2CH(CH_3)-$ and more preferably $-CH_2CH_2-$. p and m represent preferably 0 or 1, and p represents more preferably 0. It is preferable that Y represents a single bond. It is preferable that n represents an integer of 1 to 20.

Examples of the non-ionic surfactant include those described in paragraph [0031] of JP2014-104631A. Preferred examples of the non-ionic surfactant include polyoxyethylene aryl ethers and polyoxyethylene-polyoxypropylene block copolymers.
As the non-ionic surfactant, a non-ionic surfactant represented by Formula (II-A) is preferable.

$$(R^4)s\text{-}Ar^3\text{-}O(CH_2CH_2O)_t(CH_2CH(CH_3)O)_uH \qquad \text{(II-A)}$$

In Formula (II-A), $R^4$ represents a hydrogen atom or an alkyl group having 1 to 20 carbon atoms, s represents 0, 1, or 2, $Ar^3$ represents an aryl group having 6 to 10 carbon atoms, t and u each represent an integer of 0 to 100, and both t and u do not represent 0 at the same time. In a case where s represents 2, a plurality of $R^4$'s may be the same as or different from one another.
Further, organic resin fine particles (for example, microgels) may be used as the hydrophilizing agent. Microgels are reactive or non-reactive resin particles dispersed in an aqueous medium. The microgels preferably contain a polymerizable group in each particle or on each surface of the particle thereof.
It is preferable that the coating solution containing a hydrophilizing agent is in the form of an aqueous solution in which the hydrophilizing agent is dissolved or dispersed in a medium mainly formed of water. The content of the hydrophilizing agent in the coating solution containing the hydrophilizing agent is preferably in a range of 0.05% to 50% by mass and more preferably in a range of 0.1% to 30% by mass. The viscosity of the coating solution that contains the hydrophilizing agent is preferably in a range of 0.5 to 1000 mPa·s and more preferably in a range of 1 to 100 mPa·s at 25°C. The surface tension of the coating solution that contains the hydrophilizing agent is preferably in a range of 25 to 70 mN/m and more preferably in a range of 40 to 65 mN/m at 25°C.
The coating solution containing the hydrophilizing agent may contain an organic solvent, a plasticizer, a preservative, an antifoaming agent, and inorganic salts such as a nitrate and a sulfate in addition to the hydrophilizing agent.

(Desensitizing liquid)

Examples of the desensitizing liquid include an aqueous solution containing at least one of a hydrophilic organic polymer compound, hexametaphosphoric acid and a salt thereof, or phytic acid and a salt thereof. Specific examples of the hydrophilic organic polymer compound include gum arabic, dextrins, an alginate such as sodium alginate, water-soluble cellulose such as carboxymethyl cellulose, hydroxyethyl cellulose, or hydroxypropylmethyl cellulose, polyvinyl alcohol, polyvinylpyrrolidone, polyacrylamide, a water-soluble copolymer having an acrylamide unit, polyacrylic acid, a copolymer having an acrylic acid unit, polymethacrylic acid, a copolymer containing a methacrylic acid unit, a copolymer of vinyl methyl ether and maleic acid anhydride, a copolymer of vinyl acetate and maleic acid anhydride, and phosphoric acid-modified starch. Among these, gum arabic is preferable in terms of a strong desensitizing effect. These hydrophilic polymer compounds can be used in combination of two or more kinds thereof as necessary, and the concentration thereof is approximately 1% to 40% by weight and more preferably in a range of 3% to 30% by weight.
Specific examples of the hexametaphosphate include an alkali metal salt or ammonium salt of hexametaphosphoric acid. Examples of the alkali metal salt or ammonium salt of hexametaphosphoric acid include sodium hexametaphosphate, potassium hexametaphosphate, and ammonium hexametaphosphate. Specific examples of the phytic acid or the salt thereof include an alkali metal salt such as a sodium salt, a potassium salt, or a lithium salt, an ammonium salt, and an amine salt. Examples of the amine salt include salts of diethylamine, triethylamine, n-propylamine, di-n-propylamine, tri-n-propylamine, n-butylamine, n-amylamine, n-hexylamine, laurylamine, ethylenediamine, trimethylenediamine, tetramethylenediamine, pentamethylenediamine, hexamethylenediamine, ethanolamine, diethanolamine, triethanolamine, allylamine, and aniline. The phytic acid may be a normal salt obtained by substituting all hydrogen atoms of 12 acids or a hydrogen salt (acid salt) obtained by substituting some hydrogen atoms of the acids. Further, the phytic acid can be used in any form of a simple salt formed of a salt of one kind of base or a double salt containing two or more kinds of bases as components. These compounds can be used alone or in combination of two or more kinds thereof.
It is preferable that the desensitizing liquid used in the present embodiment further contains a metal salt of a strong acid so that the desensitizing effect can be increased. Specific examples of the metal salt of a strong acid include a sodium salt, a potassium salt, a magnesium salt, a calcium salt, or a zinc salt of nitric acid, a sodium salt, sodium fluoride, and potassium fluoride. These metal salts of strong acids can be used in combination of two or more kinds thereof, and the amount thereof is in a range of 0.01% to 20% by weight with respect to the total weight of the desensitizing liquid. The pH value of the desensitizing liquid used in the present invention is adjusted to be in an acidity range, more preferably in a range of 1 to 5, and most preferably in a range of 1.5 to 4.5. Therefore, more acids are added to a water phase in a case where the pH of the water phase is not in the acidity range. Examples of the acids to be added as a pH adjuster include mineral acids such as phosphoric acid, sulfuric acid, and nitric acid, and organic acids such as citric acid, tannic acid, malic acid, glacial acetic acid, lactic acid, oxalic acid, p-toluenesulfonic acid, and organic phosphonic acid. Among these, phosphoric acid is particularly excellent from the viewpoint that phosphoric acid not only functions

as a pH adjuster but also has the effect of increasing the desensitizing effect, and the content of phosphoric acid is preferably in a range of 0.01% to 20% by weight and most preferably in a range of 0.1% to 10% by weight with respect to the total weight of the desensitizing liquid.

It is preferable that the desensitizing liquid used in the present embodiment contains a wetting agent and/or a surfactant. In this manner, the coating properties of the desensitizing liquid can be improved. Specifically, lower polyhydric alcohol is preferable as the wetting agent, and examples thereof include ethylene glycol, diethylene glycol, triethylene glycol, propylene glycol, butylene glycol, pentanediol, hexylene glycol, tetraethylene glycol, polyethylene glycol, dipropylene glycol, tripropylene glycol, glycerin, sorbitol, and pentaerythritol. Among these, glycerin is particularly preferable. Examples of the surfactant which can be used include non-ionic surfactants such as polyoxyethylene alkylphenyl ether and a polyoxyethylene polyoxypropylene block copolymer, anionic surfactants such as fatty acid salts, alkyl sulfuric acid ester salts, alkylbenzene sulfonates, alkylnaphthalene sulfonates, dialkylsulfosuccinic acid ester salts, alkylphosphoric acid ester salts, and a naphthalenesulfonic acid formalin condensate, and amphoteric surfactants such as a betaine type surfactant, a glycine type surfactant, an alanine type surfactant, and a sulfobetaine type surfactant. The content of these wetting agents and/or surfactants is approximately 0.5% to 10% by weight and more preferably in a range of 1% to 5% by weight with respect to the total weight of the desensitizing liquid. The desensitizing liquid used in the present invention may further contain fillers such as silicon dioxide, talc, and clay in an amount up to 2% by weight, and dyes or pigments in an amount up to 1% by weight.

The desensitizing liquid used in the present embodiment is formed of a hydrophilic aqueous solution as described above. Further, in consideration of a case where the image recording layer is adversely affected, for example, emulsion type desensitizing liquids described in US4253999A, US4268613A, and US4348954A can also be used.

As the ink repellent agent, for example, HN-G5 (manufactured by Fujifilm Corporation) can be used.

(Method of applying ink repellent agent)

Fig. 4 is a view for describing a coating method of applying the ink repellent agent. As illustrated in Fig. 4, the coating solution containing the ink repellent agent can be applied using a wire bar 38. Further, in Fig. 4, the planographic printing plate precursor 10a is described in a simplified manner in order to describe the method of applying the ink repellent agent, and the description of the sagging shape of the end portion is not provided. The same applies to Figs. 5 and 6 described below. In a case of application of the ink repellent agent using the wire bar 38, first, the wire bar 38 is coated with a coating solution containing the ink repellent agent. The wire bar 38 coated with the coating solution is moved such that the wire bar 38 moves along the end surface 20 (the side surface of the aluminum support) of the planographic printing plate precursor 10a. The wire bar 38 can be moved at a moving speed of, for example, 20 mm/s. After the application, the coating solution is dried. As the drying conditions, for example, the coating solution can be dried by applying wind at 80°C and at a wind speed of 6 m/s for 30 seconds. Further, the size of the wire bar can be appropriately changed depending on the thickness of the aluminum support 12 of the planographic printing plate precursor 10a. For example, in a case where the thickness of the aluminum support is 0.3 mm, a #10 wire bar can be used.

Further, in the case of application of the coating solution, the coating solution may be applied by tilting the wire bar 38 at an angle $\theta$ with respect to the end surface 20 of the planographic printing plate precursor 10a as illustrated in Fig. 4. Table 1 is a table showing the coating width of the coating solution in a case of tilting the wire bar. Further, Table 1 shows the coating width in a case where the coating is performed by applying 10 $cm^3$ of the coating solution such that the wire bar is uniformly coated with the ink repellent agent.

Table. 1

| INCLINATION ANGLE $\theta$ [Deg.] | COATING WIDTH ON END PORTION OF FRONT SURFACE [mm] | COATING WIDTH ON END PORTION OF REAR SURFACE [mm] | COATING WIDTH OF SIDE SURFACE [mm] |
|---|---|---|---|
| 0 | 0.5 | 0.5 | 0.3 |
| 15 | 0.1 | 0.5 | 0.3 |
| 30 | 0 | 0.7 | 0.3 |
| -30 | 0.7 | 0 | 0.3 |

As shown in Table 1, in a case where the wire bar is parallel ($\theta$ = 0°) to the end surface 20 of the planographic printing plate precursor 10a, the ink repellent agent can be applied to the end portion on the front surface side and the end portion on the rear surface side of the planographic printing plate precursor 10a. The reason for this is that the coating solution on the wire bar 38 wraps around the front surface side and the rear surface side of the planographic printing

plate precursor 10a by pressing the end surface 20 of the planographic printing plate precursor 10a against the wire bar 38 to which the coating solution containing the ink repellent agent has adhered. By tilting the wire bar 38 by 15° such that the wire bar 38 is separated from the end surface 20 of the planographic printing plate precursor on a side of the surface 22 of the image recording layer (front surface side), the coating width of the planographic printing plate precursor 10 on the rear surface side can be widened and the coating width thereof on the front surface side can be narrowed as illustrated in Table 1. Similarly, by tilting the wire bar 38 by 30°, the ink repellent agent can be applied only to the rear surface side. Further, by tilting the wire bar 38 by -30° in the opposite direction such that the side (rear surface side) of the planographic printing plate precursor opposite to the surface 22 of the image recording layer is separated from the end surface 20, the end surface 20 and the end portion of the planographic printing plate precursor 10a on the front surface side can be coated with the ink repellent agent.

In the planographic printing plate precursor according to the present embodiment, the ink repellent agent can be provided not only on the side surface of the aluminum support but also on the front surface side of the planographic printing plate precursor. In a case where the ink repellent agent is provided on the front surface side, it is possible to prevent edge stains caused by crack stains generated during printing due to adhesion of the ink to the cracks formed at the end portions of the planographic printing plate during printing. Further, the width from the end portion at which the surface of the planographic printing plate precursor is coated with the ink repellent agent is preferably less than 1 cm, preferably 3 mm or less, and more preferably 1 mm or less. In a case where the width from the end portion is set to be in the above-described range, the image forming region can be sufficiently ensured.

Further, Figs. 5 and 6 are views illustrating another method of applying the ink repellent agent. As illustrated in Fig. 5, a part of the end surface 20 of the planographic printing plate precursor 10a and the surface 22 of the image recording layer can be coated with a coating solution 42 by using a wire bar 39 having a stepped portion 40. Further, as illustrated in Fig. 6, only the end surface 20 can be coated with the coating solution 42 by tilting the wire bar 39 such that the wire bar 39 is separated from the end surface 20 on the surface 22 side of the image recording layer of the planographic printing plate precursor 10a.

In addition, the method of applying the ink repellent agent using the wire bar has been described above, but the method of applying the ink repellent agent is not limited to the wire bar. For example, the ink repellent agent can be applied using a pen (BON-PEN, manufactured by Japan Bonkote Co., Ltd.).

In this manner, a part or the entire end surface of the planographic printing plate precursor 10a (the side surface of the aluminum support 12) in the thickness direction may be coated with the ink repellent agent. In a case where a part of the end surface in the thickness direction is coated with the ink repellent agent, it is preferable to coat a region which extends to a distance of less than 30 $\mu$m from the end portion of the aluminum support 12 on the side of the image recording layer 16 and more preferable to coat a region which extends to a distance of less than 15 $\mu$m from the end portion thereof. Further, the width of the ink repellent agent from the end portion on the image recording layer 16 and the width of the side surface of the aluminum support 12 can be calculated by known methods. For example, the widths can be determined based on a difference in tint observed by an optical microscope. In addition, a known device such as a scanning X-ray photoelectric spectroscopy analyzer, a Fourier transform infrared absorption spectrum (FT-IR) measuring device, or a corona charged particle detector (Corona CAD, manufactured by Thermo Fisher Scientific) can be used.

Next, the shape of the planographic printing plate precursor to which the ink repellent agent formed as described above has been applied will be described. Figs. 7 to 10 are cross-sectional views illustrating the planographic printing plate precursor coated with the ink repellent agent. The thicknesses of the aluminum support illustrated in Figs. 7 to 10 are all 300 $\mu$m. Further, the description is made based on the scales which are different in the thickness direction and the width direction due to the size of the planographic printing plate precursor. A planographic printing plate precursor 10b illustrated in Fig. 7 has an ink repellent agent 44 on the entire side surface of the aluminum support 12. In a case where the side surface of the aluminum support 12 contains the ink repellent agent, it is possible to prevent corner stains of the corners of the planographic printing plate precursor at the boundary between the surface 22 of the image recording layer and the end surface 20. Such a planographic printing plate precursor 10b can be formed by disposing the wire bar in parallel with the end surface 20 of the planographic printing plate precursor (the angle $\theta$ is set to 0° in Fig. 4) and adjusting the pressure for pressing the wire bar against the planographic printing plate precursor.

A planographic printing plate precursor 10c illustrated in Fig. 8 contains the ink repellent agent 44 on the entire side surface of the aluminum support 12 and on the image recording layer 16. By coating the surface with the ink repellent agent so as to cover the cracks 15, it is possible to prevent coating stains due to crack stains. Such a planographic printing plate precursor 10c can be formed by tilting the wire bar 38 illustrated in Fig. 5 toward the side of the image recording layer 16 of the planographic printing plate precursor and applying the ink repellent agent.

A planographic printing plate precursor 10d illustrated in Fig. 9 contains the ink repellent agent 44 on a part of the side surface of the aluminum support 12 and on the image recording layer 16. In a case where the planographic printing plate precursor contains the ink repellent agent 44 on a part of the side surface of the aluminum support 12 and on the image recording layer 16, the corners of the planographic printing plate precursor and the cracks 15 can be

covered with the ink repellent agent, and thus it is possible to prevent edge stains including both crack stains and corner stains.

A planographic printing plate precursor 10e illustrated in Fig. 10 contains the ink repellent agent 44 on a part of the side surface of the aluminum support 12 and on the image recording layer 16. The ink repellent agent 44 on the image recording layer 16 does not cover all the cracks 15 but covers the corners of the planographic printing plate precursor, and thus it is possible to prevent edge stains caused by the corner stains. The planographic printing plate precursors illustrated in Figs. 9 and 10 can be formed by adjusting the pressure for pressing the wire bar 39 against the planographic printing plate precursor and the inclination of the ware bar 39 using the wire bar 39 having the stepped portion 40.

In a case where the planographic printing plate precursor contains the ink repellent agent 44 on a part of the side surface of the aluminum support 12 and on the image recording layer 16, the value obtained by dividing the width of the ink repellent agent on the image recording layer 16 from the end portion in the width direction by the width of the ink repellent agent of the aluminum support in the thickness direction is preferably less than 10, more preferably less than 5, and still more preferably less than 3. The image forming region can be sufficiently ensured by narrowing the width of the ink repellent agent on the image recording layer 16. Further, the stickiness of the side surface of the planographic printing plate precursor can be suppressed by narrowing the width of the ink repellent agent on the side surface of the aluminum support.

Fig. 11 is a view illustrating the planographic printing plate precursor 10 as viewed from the side of the image recording layer 16. The planographic printing plate precursor 10 illustrated in Fig. 11 contains an ink repellent layer (the ink repellent agent 44) at the end portion on the image recording layer 16. The value Z represented by Equation Z which is a variation in the width of the ink repellent agent from the end portion of the planographic printing plate (the aluminum support) in a width direction in the ink repellent agent 44 provided on the image recording layer 16 is preferably 0.5 mm or less. Further, since the region which extends to a distance of 5 cm from both end portions of the aluminum support in the longitudinal direction is a region where the planographic printing plate is gripped in a case of newspaper printing, the ink repellent agent may not be provided on this region, and thus the region which extends to a distance of 5 cm from both end portions of the aluminum support in the longitudinal direction is not included in the calculation in a case of calculating the above-described variation.

$$Z = \frac{1}{N}\sum_{n-1}^{N} \left| Zn - \bar{Z} \right|$$

Zn represents a width of the ink repellent agent from the end portion the ink repellent agent at an arbitrary point of the aluminum support in the longitudinal direction, N represents a number obtained by measuring the width of the ink repellent agent, and $\bar{Z}$ represents an average value of widths from the end portion of the ink pellent agent.

In a case where the value of Z is set to 0.5 mm or less, the end portion of the planographic printing plate precursor 10 which contains the ink repellent agent 44 and the end portion on the opposite side thereof can be made linear in the longitudinal direction. For example, in a case where extruded articles are printed in the newspaper printing, the extruded articles can be printed clearly by applying the ink repellent agent 44 such that the width thereof is set to be constant.

The amount of the ink repellent agent applied to the side surface of the aluminum support 12 is preferably in a range of 10 mg/m$^2$ to 5000 mg/m$^2$, more preferably in a range of 30 mg/m$^2$ to 3000 mg/m$^2$, and still more preferably in a range of 30 mg/m$^2$ to 500 mg/m$^2$ in terms of the coating amount after the drying. In a case where the amount of the ink repellent agent is set to be in the above-described range, it is possible to prevent both edge stains and stickiness of the end portion of the planographic printing plate precursor.

The amount of the ink repellent agent applied onto image recording layer 16 is preferably in a range of 10 mg/m$^2$ to 5000 mg/m$^2$, more preferably in a range of 30 mg/m$^2$ to 3000 mg/m$^2$, and still more preferably in a range of 50 mg/m$^2$ to 500 mg/m$^2$ in terms of the coating amount after the drying. In a case where the coating amount of the ink repellent agent is set to be in the above-described range, it is possible to prevent both edge stains and stickiness of the end portion of the planographic printing plate precursor.

<Configurations of front surface and rear surface of planographic printing plate precursor>

(Preferable aspect of rear surface)

In the planographic printing plate precursor according to the present embodiment, the arithmetic average height Sa of the rear surface (the surface of the outermost layer on the side opposite to the side where the image recording layer is provided) of the planographic printing plate precursor is preferably in a range of 0.3 μm to 20 μm. The aspect for setting the arithmetic average height Sa of the rear surface to be in the above-described range is not particularly limited, but the following aspect (Aspect A1) or (Aspect A2) is preferably exemplified.
(Aspect A1) The planographic printing plate precursor includes a resin layer containing at least one kind of particles having an average particle diameter of 0.5 μm to 20 μm as the outermost layer on a side opposite to a side where the image recording layer is provided.
(Aspect A2) The planographic printing plate precursor has a plurality of protrusion containing a polymer compound on the surface (rear surface) of the outermost layer on a side opposite to a side where the image recording layer is provided.
Preferred examples of the method for obtaining the planographic printing plate precursor according to the (Aspect A1) include a method of adding particles to a composition for forming a resin layer.
Preferred examples of the method for obtaining the planographic printing plate precursor according to the (Aspect A2) include a method of coating the surface of the outermost layer with a composition containing at least one selected from the group consisting of particles and a polymer compound to form protrusions.
In the (Aspect A2), it is preferable that the planographic printing plate precursor includes a resin layer as the outermost layer on a side of the support opposite to a side where the image recording layer is provided and has the plurality of protrusions on the resin layer.

[Resin layer]

The film thickness of the resin layer is preferably in a range of 0.5 μm to 3 μm, more preferably in a range of 0.6 μm to 2 μm, and still more preferably in a range of 0.8 μm to 1.5 μm.
It is preferable that the resin layer in the (Aspect A1) described above contains particles and a binder.
It is preferable that the resin layer in the (Aspect A2) described above contains a binder.
In the resin layer in the (Aspect A1), from the viewpoints of the on-press development delay resistance, the plate feeding property of taking out a precursor from a laminate, suppression of falling of particles, scratch resistance, and ease of peeling at the time of lamination without using interleaving paper, the density of particles is preferably in a range of 500 pcs/$m^2$ to 500000 pcs/$m^2$, more preferably in a range of 1000 pcs/$m^2$ to 100000 pcs/$m^2$, and still more preferably in a range of 5000 pcs/$m^2$ to 50000 pcs/$m^2$.
In the resin layer in the (Aspect A2), from the viewpoints of the on-press development delay resistance, the plate feeding property of taking out a precursor from a laminate, suppression of falling of particles, scratch resistance, and ease of peeling at the time of lamination without using interleaving paper, the density of protrusions is preferably in a range of 500 pcs/$m^2$ to 500000 pcs/$m^2$, more preferably in a range of 1000 pcs/$m^2$ to 100000 pcs/$m^2$, and still more preferably in a range of 5000 pcs/$m^2$ to 50000 pcs/$m^2$.

- Particles -

The particles contained in the resin layer according to the (Aspect A1) and the particles used for achieving the (Aspect A2) are not particularly limited, but at least one kind of particles selected from the group consisting of organic resin particles and inorganic particles are preferable from the viewpoint of the on-press development delay resistance.

<<Organic resin particles>>

Preferred examples of the organic resin particles include polyolefins such as poly(meth)acrylic acid esters, polystyrene and derivatives thereof, polyamides, polyimides, low-density polyethylene, high-density polyethylene, and polypropylene; particles formed of synthetic resins such as polyurethanes, polyureas, and polyesters; and particles formed of natural polymers such as chitin, chitosan, cellulose, crosslinked starch, and crosslinked cellulose.
Among these, synthesis resin particles have advantages that the particle size can be easily controlled and desired surface characteristics can be easily controlled by surface modification.
As a method of producing such organic resin particles, atomization can also be made using a crushing method in a case of a relatively hard resin such as polymethyl methacrylate (PMMA), but a method of synthesizing particles using an emulsion suspension polymerization method is preferably employed from the viewpoints of ease of controlling

the particle diameter and the precision.

The method of producing organic resin particles is described in detail in "Ultrafine Particle as Materials" edited by Materials Science Society of Japan, published by SHOKABO Co., Ltd., 1993 and "Manufacturing & Application of Microspheres & Powders" supervised by Haruma Kawaguchi, published by CMC Publishing, 2005.

Examples of commercially available products of the organic resin particles include crosslinked acrylic resins MX-40T, MX-80H3wT, MX-150, MX-180TA, MX-300, MX-500, MX-1000, MX-1500H, MR-2HG, MR-7HG, MR-10HG, MR-3GSN, MR-5GSN, MR-7G, MR-10G, mR-5C, and MR-7GC, and styryl resin-based SX-350H and SX-500H (manufactured by Soken Chemical & Engineering Co., Ltd.), Acrylic resins MBX-5, MBX-8, MBX-12, MBX-15, MBX-20, MB20X-5, MB30X-5, MB30X-8, MB30X-20, SBX-6, SBX-8, SBX-12, and SBX-17 (manufactured by Sekisui Plastics Co., Ltd.), polyolefin resins and CHEMIPEARL W100, W200, W300, W308, W310, W400, W401, W405, W410, W500, WF640, W700, W800, W900, W950, and WP100 (manufactured by Mitsui Chemicals, Inc.).

<<Inorganic particles>>

Examples of the inorganic particles include silica, alumina, zirconia, titania, carbon black, graphite, $BaSO_4$, ZnS, $MgCO_3$, $CaCO_3$, ZnO, CaO, $WS_2$, $MoS_2$, MgO, $SnO_2$, $\alpha$-Fe2O3, $\alpha$-FeOOH, SiC, $CeO_2$, BN, SiN, MoC, BC, WC, titanium carbide, corundum, artificial diamond, petroleum stone, garnet, silica stone, tripolite, diatomaceous earth, and dolomite.

As the above-described particles, a particle having a hydrophilic surface is preferable. Examples of the particle having a hydrophilic surface include an organic resin particle having a hydrophilic surface and an inorganic particle having a hydrophilic surface.

As the organic resin particle having a hydrophilic surface, an organic resin particle covered with at least one inorganic compound selected from the group consisting of silica, alumina, titania, and zirconia is preferable and an organic resin particle covered with silica is particularly preferable.

It is preferable that an organic resin constituting an organic resin particle having a hydrophilic surface is at least one resin selected from the group consisting of a polyacrylic resin, a polyurethane-based resin, a polystyrene-based resin, a polyester-based resin, an epoxy-based resin, a phenolic resin, and a melamine resin.

Hereinafter, the organic resin particle having a hydrophilic surface will be described in detail using an organic resin particle covered with silica (hereinafter, also referred to as a "silica-coated organic resin particle") as an example, and the organic resin particle having a hydrophilic surface in the present disclosure is not limited thereto.

The silica-coated organic resin particle is a particle obtained by coating the surface of the particle formed of an organic resin with silica. It is preferable that the organic resin particle constituting the core is not softened or does not become sticky due to the moisture in the air or the temperature thereof.

Examples of the organic resin constituting the organic resin particle in the silica-coated organic resin particles include a polyacrylic resin, a polyurethane-based resin, a polystyrene-based resin, a polyester-based resin, an epoxy-based resin, a phenol resin, and a melamine resin.

As a material forming the silica layer covering the surface of the silica-coated organic resin particle, a compound containing an alkoxysilyl group such as a condensate of an alkoxysiloxane-based compound, particularly, a siloxane-based material, and specifically, silica particles such as silica sol, colloidal silica, and silica nanoparticles are preferably exemplified.

The configuration of the silica-coated organic resin particle may be a configuration in which a silica particle adheres to the surface of an organic resin particle as a solid component or a configuration in which a siloxane-based compound layer is formed on the surface of an organic resin particle by performing a condensation reaction on an alkoxysiloxane-based compound.

Silica does not necessarily cover the entire surface of the organic resin particle, and it is preferable that the surface thereof is covered with at least 0.5% by mass or greater of silica at least with respect to the total mass of the organic resin particles. In other words, in a case where silica is present on at least a part of the surface of the organic resin particle, improvement in affinity for a coexisting water-soluble polymer such as polyvinyl alcohol (PVA) is achieved, falling off of the particle is suppressed even in a case where external stress is applied thereto, and excellent scratch resistance and ease of peeling at the time of lamination without using interleaving paper can be maintained. Accordingly, the expression "covered with silica" in the present disclosure includes a state in which silica is present on at least a part of the surface of the organic resin particle as described above.

The state of the surface being covered with silica can be confirmed by morphological observation using a scanning electron microscope (SEM) or the like. Further, the covering amount of silica can be confirmed by detecting Si atoms through elemental analysis such as fluorescent X-ray analysis and calculating the amount of silica present therein.

A method of producing silica-coated organic resin particles is not particularly limited, and examples thereof include a method of forming a silica surface coating layer simultaneously with formation of organic resin particles by

allowing silica particles or a silica precursor compound to coexist with a monomer component which becomes the raw material of the organic resin particles; and a method of forming organic resin particles, physically adhering silica particles to each surface of the organic resin particles, and fixing the silica particles thereto.

Hereinafter, an example of the method of producing silica-coated organic resin particles will be described. First, silica and a raw material resin (more specifically, a raw material resin such as a monomer capable of suspension polymerization, a prepolymer capable of suspension cross-linking, or a resin liquid, constituting the above-described organic resin) are added to water containing a suspension stabilizer appropriately selected from a water-soluble polymer such as polyvinyl alcohol, methyl cellulose, or polyacrylic acid and an inorganic suspending agent such as calcium phosphate or calcium carbonate, and stirred and mixed with the water to prepare a suspension in which silica and a raw material resin are dispersed. At this time, a suspension having a target particle diameter can be formed by adjusting the type, the concentration, and the stirring rotation speed of the suspension stabilizer. Next, the suspension is heated to start the reaction, and resin particles are generated by performing suspension polymerization or suspension cross-linking on the resin raw material. At this time, the coexisting silica is fixed to the resin particle cured by the polymerization or the cross-linking reaction, particularly, the vicinity of the surface of the resin particle due to the physical properties thereof. Thereafter, the suspension is subjected to solid-liquid separation, the suspension stabilizer adhering to the particles is removed by washing, and the particles are dried. In this manner, silica-coated organic resin particles to which silica is fixed and which have a desired particle diameter and a substantially spherical shape can be obtained.

As described above, silica-coated organic resin particles having a desired particle diameter can be obtained by controlling the conditions during the suspension polymerization or the suspension cross-linking or silica-coated organic resin particles are generated without strictly controlling the conditions and then silica-coated organic particles having a desired size can be obtained by a mesh filtration method or the like.

In regard to the amount of the raw material to be added to the mixture during the production of the silica-coated organic particles according to the above-described method, in a case where the total amount of the raw material resin and the silica is 100 parts by mass, an aspect in which 0.1 parts by mass to 20 parts by mass of the suspension stabilizer is firstly added to 200 parts by mass to 800 parts by mass of water serving as a dispersion medium, and sufficiently dissolved or dispersed therein, 100 parts by mass of a mixture of the raw material resin and the silica is put into the solution, the solution is stirred while the stirring speed is adjusted such that the dispersed particles have a predetermined particle size, and the solution temperature is increased to 30°C to 90°C after the adjustment of the particle size to cause a reaction for 1 hour to 8 hours is preferably exemplified.

The above-described method is merely an example of the method of producing silica-coated organic resin particles and silica-coated organic resin particles obtained by the methods specifically described in JP2002-327036A, JP2002-173410A, JP2004-307837A, JP2006-38246A, and the like can be also suitably used in the present disclosure.

Further, the silica-coated organic resin particles are also available as commercially available products, and specific examples of silica-melamine composite particles include OPTBEADS 2000M, OPTBEADS 3500M, OPTBEADS 6500M, OPTBEADS 10500M, OPTBEADS 3500S, and OPTBEADS 6500S (all manufactured by Nissan Chemical Industries, Ltd.). Specific examples of silica-acrylic composite particles include ART PEARL G-200 transparent, ART PEARL G-400 transparent, ART PEARL G-800 transparent, ART PEARL GR-400 transparent, ART PEARL GR-600 transparent, ART PEARL GR-800 transparent, and ART PEARL J-7P (all manufactured by Negami Chemical Industrial Co., Ltd.). Specific examples of silica-urethane composite particles include ART PEARL C-400 transparent, C-800 transparent, P-800T, U-600T, U-800T, CF-600T, CF800T (all manufactured by Negami Chemical Industrial Co., Ltd.) and DYNAMIC BEADS CN5070D and DANPLACOAT THU (both manufactured by Dainichiseika Color & Chemicals Mfg. Co., Ltd.).

Hereinbefore, the organic resin particles used in the present disclosure have been described using the silica-coated organic resin particles as an example, but the same applies to organic resin particles covered with alumina, titania, or zirconia by using alumina, titania, or zirconia in place of silica.

«Shape»

As the shape of particles, a perfectly spherical shape is preferable, and a flat plate shape or a so-called spindle shape in which a projection view is in an elliptical shape may be employed.

From the viewpoint of the on-press development delay resistance, the average particle diameter of particles used for forming unevenness on the rear surface is preferably 0.1 μm or greater, more preferably 0.3 μm or greater, still more preferably 0.5 μm or greater, and particularly preferably 0.7 μm or greater. Further, from the viewpoint of the on-press development delay resistance, the average particle diameter thereof is preferably 20 μm or less, more preferably 10 μm or less, and still more preferably 7 μm or less.

In addition, from the viewpoints of the on-press development delay resistance, the plate feeding property of taking out a precursor from a laminate, suppression of falling of particles, scratch resistance, and ease of peeling at the time of lamination without using interleaving paper, it is preferable that the resin layer according to the (Aspect A1)

satisfies Expression (A).

$$0.2 \leq (\text{the film thickness of the resin layer/the average particle diameter of the particles contained in the resin layer}) \leq 0.5 \cdots \text{Expression (A)}$$

The value of (the film thickness of the resin layer/the average particle diameter of the particles contained in the resin layer) is preferably 0.2 or greater, more preferably 0.22 or greater, and still more preferably 0.25 or greater. Further, the value thereof is preferably 0.5 or less, more preferably 0.45 or less, and still more preferably 0.4 or less.

The value represented by (the film thickness of the resin layer/the average particle diameter of the particles contained in the resin layer) is also referred to as a particle embedment rate.

From the viewpoint of the on-press development delay resistance, the average particle diameter of the particles used for forming unevenness on the front surface described below is preferably in a range of 0.1 μm to 20 μm, more preferably in a range of 0.3 μm to 10 μm, still more preferably in a range of 0.5 μm to 7 μm, and particularly preferably in a range of 0.5 μm to 5 μm.

The average particle diameter of the particles in the present disclosure indicates the volume average particle diameter, and the volume average particle diameter can be measured using a laser diffraction and scattering type particle size distribution meter. Examples of the measuring device include a particle size distribution measuring device "Microtrac MT-3300II" (manufactured by Nikkiso Co., Ltd.).

Further, in the present disclosure, the average particle diameter of other particles is set to be measured according to the above-described measurement method unless otherwise specified.

- Hardness -

The 10% hardness of the particles is preferably 80 MPa or less, more preferably 50 MPa or less, and still more preferably 40 MPa or less. Further, the 10% hardness thereof is preferably 1 MPa or greater and more preferably 10 MPa or greater.

The 10% hardness of the particles indicates the hardness obtained in a case where 10% of the particles are pushed in and is measured using a micro compression tester MCT Series (manufactured by Shimadzu Corporation). Specifically, the particles are interposed until the diameter thereof reaches 90% of the length and the pressure at that time is measured.

« Addition amount »

[Rear surface]

In a case where the particles are added to a composition for forming a resin layer in order to form unevenness on the rear surface, the amount of the particles to be added to the outermost layer is adjusted such that the amount of the particles, which are present on the resin layer, is preferably in a range of 500 pcs/m2 to 500000 pcs/$m^2$, more preferably in a range of 1000 pcs/$m^2$ to 100000 pcs/$m^2$, and still more preferably in a range of 5000 pcs/$m^2$ to 50000 pcs/$m^2$. In a case where the amount of the particles to be added is in the above-described range, the arithmetic average height Sa is easily adjusted to be in the above-described range and desorption of particles is prevented so that the failure is not caused.

[Front surface]

According to the following aspect, in a case where the particles are added to a composition for forming an outermost layer in order to form unevenness on the front surface, the mass of the particles to be added is preferably in a range of 0.5% by mass to 50% by mass, more preferably in a range of 1.0% by mass to 20% by mass, and still more preferably in a range of 2.5% by mass to 10% by mass with respect to 100% by mass of the total mass of the outermost layer. In a case where the mass of the particles to be added is in the above-described range, the plate feeding property of taking out a precursor from a laminate, suppression of falling of particles, scratch resistance, and ease of peeling at the time of lamination without using interleaving paper become excellent.

From the viewpoints of the plate feeding property of taking out a precursor from a laminate, suppression of falling of particles, scratch resistance, and ease of peeling at the time of lamination without using interleaving paper, the image recording layer contains at least one kind of particles having an average particle diameter of 0.5 μm to 20 μm and it is preferable that the image recording layer contains two or more kinds of particles having different average particle

diameters.

It is preferable that the particles having an average particle diameter of 0.5 μm to 20 μm are particles for forming the unevenness, and examples of other particles include a polymer compound having a particle shape and thermoplastic polymer particles described below.

In the present disclosure, "the image recording layer contains two or more kinds of particles having different average particle diameters" is confirmed by checking whether two or more peaks are present in the particle size distribution. The particle size distribution is measured in the same manner as that for the average particle diameter of the particles or acquired by imaging an electron micrograph of particles, measuring the total number of 5,000 particle diameters of particles on the photograph, dividing the interval from the maximum value of the obtained measured value of the particle diameter to 0 into the logarithmic scale of 50, and plotting the appearance frequency of each particle diameter. Further, the particle diameter of a spherical particle having the same particle area as the particle area on the photograph was set to the particle diameter, as non-spherical particles.

Further, the two or more peaks described above are preferably peaks separated from each other by 10 nm or longer, more preferably peaks separated from each other by 100 nm or longer, and still more preferably peaks separated from each other by 100 nm or longer.

- Binder -

It is preferable that the binder according to the (Aspect A1) contains at least one selected from the group consisting of a novolak resin such as a phenol formaldehyde resin, an m-cresol formaldehyde resin, a p-cresol formaldehyde resin, an m-/p-mixed cresol formaldehyde resin, or a phenol/cresol (any of m-, p-, and m-/p-mixed)-mixed formaldehyde resin, a resol resin, pyrogallol, an acetone resin, an epoxy resin, a saturated copolymer polyester resin, a phenoxy resin, a polyvinyl acetal resin, a vinylidene chloride copolymer resin, polybutene, polybutadiene, polyamide, an unsaturated copolymer polyester resin, polyurethane, polyurea, polyimide, polysiloxane, polycarbonate, an epoxy resin, chlorinated polyethylene, an aldehyde condensation resin of alkyl phenol, polyvinyl chloride, polyvinylidene chloride, polystyrene, polyacrylate, a carboxyvinyl polymer, an acrylic resin copolymer resin, hydroxy cellulose, hydroxymethyl cellulose, polyvinyl alcohol, polyvinylpyrrolidone, cellulose acetate, methyl cellulose, and carboxymethyl cellulose. Among these, a water-insoluble resin is preferable in order to prevent dissolution in dampening water at the time of development.

Further, it is preferable that the binder contains at least one selected from the group consisting of polyurethane, an acrylic resin, polystyrene, and polyethylene.

According to the (Aspect A1), it is preferable that the particles and the binder respectively contain at least one selected from the group consisting of polyurethane, an acrylic resin, polystyrene, and polyethylene.

As the binder contained in the resin layer according to the (Aspect A2), polymer compounds which are the same as the polymer compounds contained in the protrusions described below are exemplified, and the same applies to the preferred aspect thereof.

Further, according to the (Aspect A2), from the viewpoint of preventing desorption of protrusions, it is preferable that the binder contained in the resin layer and the polymer compound contained in the protrusions respectively contain the same resin.

In the present disclosure, the expression "the resins are the same as each other" means that the resins are of the same type, such as polyurethane, an acrylic resin, polystyrene, and polyethylene, and it is not necessary that all constitutional units in the resins are the same as each other.

«SP value»

According to the (Aspect A1), a difference in the solubility parameter (SP value) between the particles and the binder is preferably 4 $MPa^{1/2}$ or less and more preferably 2 $MPa^{1/2}$ or less.

In the present disclosure, the solubility parameter (SP value) is a value [unit: $MPa^{1/2}$] acquired using an Okitsu method. The Okitsu method is one of known methods of calculating the SP value and is described in Journal of the Adhesion Society of Japan Vol. 29, No. 6 (1993), pp. 249 to 259.

- Other components -

The resin layer of the present disclosure may contain components other than the particles and the binder.

Examples of other components include known additives such as surfactants.

[Protrusions]

It is preferable that the protrusions according to the (Aspect A2) contain a polymer compound as a main component. In the present disclosure, the main component indicates a component whose content ratio (% by mass) is the highest.

- Polymer compound -

From the viewpoints of the on-press development delay resistance and the plate feeding property of taking out a precursor from a laminate, suppression of falling of particles, the polymer compound used for the protrusions may contain at least one selected from the group consisting of a novolak resin such as a phenol formaldehyde resin, an m-cresol formaldehyde resin, a p-cresol formaldehyde resin, an m-/p-mixed cresol formaldehyde resin, or a phenol/cresol (any of m-, p-, and m-/p-mixed)-mixed formaldehyde resin, a resol resin, pyrogallol, an acetone resin, an epoxy resin, a saturated copolymer polyester resin, a phenoxy resin, a polyvinyl acetal resin, a vinylidene chloride copolymer resin, polybutene, polybutadiene, polyamide, an unsaturated copolymer polyester resin, polyurethane, polyurea, polyimide, polysiloxane, polycarbonate, chlorinated polyethylene, an aldehyde condensation resin of alkyl phenol, polyvinyl chloride, polyvinylidene chloride, polystyrene, polyacrylate, a carboxyvinyl polymer, an acrylic resin copolymer resin, hydroxy cellulose, hydroxymethyl cellulose, polyvinyl alcohol, polyvinylpyrrolidone, cellulose acetate, methyl cellulose, and carboxymethyl cellulose.

Among these, from the viewpoint that the on-press developability is excellent even in a case where desorbed protrusions are moved to the image recording layer, a water-soluble polymer is more preferable. Specific examples thereof include polyacrylate, a carboxyvinyl polymer, an acrylic resin copolymer resin, hydroxy cellulose, hydroxymethyl cellulose, polyvinyl alcohol, modified polyvinyl alcohol, polyvinylpyrrolidone, cellulose acetate, methyl cellulose, and carboxymethyl cellulose.

As the modified polyvinyl alcohol, acid-modified polyvinyl alcohol containing a carboxy group or a sulfo group is preferably used. Specifically, the modified polyvinyl alcohol described in JP2005-250216A or JP2006-259137A is suitable.

The shape and the height of the protrusions are not particularly limited as long as the arithmetic average height Sa is in a range of 0.3 μm to 20 μm, and the average height thereof is preferably in a range of 0.5 μm to 20 μm.

A method of forming stripe-like protrusions (stripe coated film) is not particularly limited, and the protrusions can be easily formed by applying a composition that contains at least one selected from the group consisting of particles and resins according to at least one system selected from the group consisting of a bar coating system, an ink jet printing system, a gravure printing system, a screen printing system, a spray coating system, and a slot die coating system.

A method of forming dot-like protrusions (dot coated film) is not particularly limited, and the protrusions can be easily formed by applying a composition that contains at least one selected from the group consisting of particles and resins according to at least one system selected from the group consisting of a spray coating system, an ink jet printing system, and a screen printing system.

A method of forming dashed line protrusions (dashed line coated film) is not particularly limited, and the protrusions can be easily formed by applying a composition that contains at least one selected from the group consisting of particles and resins according to at least one system selected from the group consisting of an inkjet printing system and a screen printing system.

(Preferred surface aspect)

In the planographic printing plate precursor according to the present embodiment, the arithmetic average height Sa of the surface of the planographic printing plate precursor (the surface of the outermost layer on the side where the image recording layer is provided) is preferably in a range of 0.3 μm to 20 μm. The aspect for setting the arithmetic average height Sa of the front surface is not particularly limited, but the following aspects (Aspect B1) to (Aspect B4) are preferably exemplified.

(Aspect B1): The image recording layer is the outermost layer, contains at least one kind of particles having an average particle diameter of 0.5 μm to 20 μm, and contains two or more kinds of particles having different average particle diameters.

(Aspect B2): A protective layer is provided on the image recording layer as the outermost layer, and the protective layer contains at least one kind of particles having an average particle diameter of 0.5 μm to 20 μm.

(Aspect B3): The image recording layer is the outermost layer, and a plurality of protrusions containing a polymer compound as a main component are provided on the image recording layer.

(Aspect B4): A protective layer is provided on the image recording layer as the outermost layer, and a plurality of protrusions containing a polymer compound as a main component are provided on the protective layer.

Preferred examples of the method for obtaining the planographic printing plate precursor according to the (Aspect B1) include a method of adding particles to a composition for forming an image recording layer.
Preferred examples of the method for obtaining the planographic printing plate precursor according to the (Aspect B2) include a method of adding particles to a composition for forming a protective layer.
Preferred examples of the method for obtaining the planographic printing plate precursor according to the (Aspect B3) or (Aspect B4) include a method of coating the surface of the outermost layer with a composition containing at least one selected from the group consisting of particles and a polymer compound to form protrusions.
Examples of the particles used in the (Aspect B1) to (Aspect B4) include the particles used in the (Aspect A1) and (Aspect A2) described above.
Examples of the polymer compound used in the (Aspect B3) or (Aspect B4) include the polymer compound used in the (Aspect A2) described above.
In a case where the arithmetic average height Sa of the surface of the outermost layer which is the rear surface of the planographic printing plate precursor and the arithmetic average height Sa of the surface of the outermost layer which is the front surface of the planographic printing plate precursor are respectively set to be in the above-described range, laminated planographic printing plate precursors can be easily peeled off even in a case where the planographic printing plate precursors are laminated for storage. Typically, in a case of storage of the planographic printing plate precursors, interleaving paper is interposed therebetween in order to allow the laminated planographic printing plate precursors to be easily peeled off. According to the present embodiment, since the ink repellent agent can also be applied from the side surface of the laminated planographic printing plate precursors in a case where the aluminum support is coated with the ink repellent agent, the front surfaces and the rear surfaces of the planographic printing plate precursors may not be coated with the ink repellent agent in a case of laminating the planographic printing plate precursors by interposing interleaving paper therebetween. By respectively setting the arithmetic average height Sa of the surface of the outermost layer which is the rear surface of the planographic printing plate precursor and the arithmetic average height Sa of the surface of the outermost layer which is the front surface of the planographic printing plate precursor to be in the above-described range, the planographic printing plate precursors can be easily peeled off even in a case where interleaving paper is not provided therebetween, and both the application of the ink repellent agent and ease of peeling the planographic printing precursors off can be achieved.

<Method of producing planographic printing plate>

Next, a method of producing a planographic printing plate using the planographic printing plate precursor will be described.
The method of producing a planographic printing plate typically includes an exposure step of imagewise-exposing (image-exposing) the planographic printing plate precursor having the image recording layer to form an exposed portion and an unexposed portion, and a step of removing the unexposed portion of the imagewise-exposed planographic printing plate precursor.
More specifically, a method of producing a planographic printing plate including a step of imagewise-exposing (image-exposing) the planographic printing plate precursor having the image recording layer to form an exposed portion and an unexposed portion, and an on-press development step of supplying at least any of printing ink or dampening water and removing the unexposed portion of the imagewise-exposed printing plate precursor on a printing press is exemplified.
Hereinafter, these embodiments will be described.
The method of producing a planographic printing plate includes a step of imagewise-exposing (image-exposing) the planographic printing plate precursor having an. image recording layer. The image exposure is performed by laser exposure through a transparent original picture having a line image or a halftone image or by laser beam scanning using digital data.
The wavelength of a light source is preferably in a range of 750 to 1,400 nm. In case of the light source having a wavelength of 750 nm to 1,400 nm, the image recording layer including the infrared absorbing agent which is a sensitizing dye having absorption at a wavelength range.
As the light source of emitting light with a wavelength of 750 to 1400 nm, a solid-state laser or a semiconductor laser that radiates infrared rays is exemplified. The output of the infrared laser is preferably 100 mW or greater, the exposure time per one pixel is preferably less than 20 microseconds, and the irradiation energy quantity is preferably in a range of 10 to 300 $mJ/cm^2$. For the purpose of reducing the exposure time, it is preferable to use a multi-beam laser device. The exposure mechanism may be any of an internal drum system, an external drum system, and a flat bed system.
The image exposure can be performed using a plate setter according to a method of the related art. In a case of the on-press development system, the printing plate precursor is mounted on the printing press, and image exposure may be performed on the printing press.
The image-exposed printing plate precursor is subjected to a development treatment according to a system

(developer treatment system) of removing the unexposed portion using a developer with a pH of 2 to 12 or a system (on-press development system) of removing the unexposed portion using at least one of printing ink or dampening water on the printing press.

(Developer treatment system)

In the developer treatment system, the image-exposed planographic printing plate precursor is treated by a developer with a pH of 2 to 14, and the image recording layer of the unexposed portion is removed to produce a planographic printing plate.

As the developer, a developer with a pH of 5 to 10 which contains at least one acid group selected from the group consisting of a phosphoric acid group, a phosphonic acid group, and a phosphinic acid group and a compound (specific compound) containing one or more carboxyl groups is preferable.

In a case where the development is carried out by a treatment manually, a method of allowing sponge or absorbent cotton to sufficiently contain a developer, performing the treatment while rubbing the entire planographic printing plate precursor, and sufficiently drying the developer after completion of the treatment is exemplified. In a case of an immersion treatment, a method of immersing the planographic printing plate precursor in a tray, a deep tank, or the like containing a developer therein for approximately 60 seconds, stirring the solution, and sufficiently drying the aqueous solution while rubbing the planographic printing plate precursor with absorbent cotton or sponge is exemplified.

It is preferable that a device capable of simplifying the structure and the steps is used in the development treatment.

In a development treatment of the related art, development is performed using an alkaline developer, an alkali is removed in the post-water washing step, the gum treatment is performed in a gum coating step, and drying is performed in a drying step.

In addition, development and gum coating can also be simultaneously performed using one liquid. As the gum, a polymer is preferable, and a water-soluble polymer compound or a surfactant is more preferable. Further, it is preferable that the excessive developer is removed using a squeeze roller after the development and the gum coating and then drying is performed.

The present treatment may be performed according to a method of performing immersion in a developer once or a method of performing immersion twice or more times. Among these, a method of performing immersion in the developer once or twice is preferable.

The immersion may be carried out by passing the exposed planographic printing plate precursor through a developer tank in which the developer is stored or spraying the developer onto the plate surface of the exposed planographic printing plate precursor using a spray or the like.

Further, the development treatment is performed using one liquid (one liquid treatment) even in a case where the planographic printing plate precursor is immersed in the developer twice or more times or in a case where the planographic printing plate precursor is immersed, twice or more times, in the same developer described above or a developer (fatigue liquid) obtained by dissolving or dispersing components of the image recording layer using the developer and the development treatment.

In the development treatment, it is preferable to use a rubbing member and also preferable that a rubbing member such as a brush is installed in a developing bath which removes a non-image area of the image recording layer.

The development treatment can be performed by immersing the planographic printing plate precursor which has been subjected to the exposure treatment in a developer and rubbing the surface with brushes or pumping up a treatment liquid added to an external tank using a pump, spraying the treatment liquid from a spray nozzle, and rubbing the surface with brushes at a temperature of preferably 0°C to 60°C and more preferably 15°C to 40°C, according to a method of the related art. These development treatments can be continuously performed plural times. For example, the development treatment can be performed by pumping up the developer added to an external tank using a pump, spraying the developer from a spray nozzle, rubbing the plate surface with brushes, spraying the developer from the spray nozzle again, and rubbing the plate surface with the brushes. In a case where the development treatment is performed using an automatic development device, since the developer is fatigued as the treatment amount increases, it is preferable that the treatment capability is recovered using a replenisher or a fresh developer.

The development treatment of the present disclosure can also be performed using a gum coater or an automatic development device which has been known to be used for a presensitized plate (PS) and CTP in the related art. In a case where an automatic development device is used, for example, any system from among a system of performing the treatment by pumping the developer added to a developer tank or the developer added to an external tank using a pump and spraying the developer from a spray nozzle, a system of performing the treatment by immersing a planographic printing plate in a tank filled with the developer and transporting the planographic printing plate using a guide roller in the developer, and a so-called disposable treatment system, which is a system of performing the treatment by supplying the substantially unused developer by an amount required for each plate can be employed. In all systems, it is more

preferable that a rubbing mechanism using brushes or a molleton is provided. For example, commercially available automatic development devices (Clean Out Unit C85/C125, Clean-Out Unit+ C85/120, FCF 85V, FCF 125V, FCF News (manufactured by Glunz & Jensen); and Azura CX85, Azura CX125, and Azura CX150 (manufactured by AGFA GRAPHICS) can be used. In addition, a device in which a laser exposure portion and an automatic development device portion are integrally incorporated can also be used.

(On-press development system)

In the on-press development system, printing ink and dampening water are supplied on the printing press, and the image recording layer of the non-image area is removed to produce a planographic printing plate using the image-exposed planographic printing plate precursor.

That is, in a case where the planographic printing plate precursor is image-exposed and directly mounted on the printing press without performing any developer treatment or the planographic printing plate precursor is mounted on the printing press, image-exposed on the printing press, and printed by supplying printing ink and dampening water, at the initial stage of the printing, the image recording layer of the unexposed portion is dissolved or dispersed and removed by the supplied printing ink and/or dampening water in the non-image area, and thus the hydrophilic surface in the removed portion is exposed. In the exposed portion, the image recording layer cured by being exposed forms an oil-based ink receiving portion having a lipophilic surface. Due to such a configuration, it is preferable that the image recording layer is a water-soluble or water-dispersible negative type image recording layer. Printing ink or dampening water may be initially supplied to the plate surface, but it is preferable that printing ink is initially supplied thereto from the viewpoint of preventing contamination due to the components of the image recording layer from which dampening water has been removed.

In this manner, the planographic printing plate precursor is subjected to on-press development on the printing press and used for printing multiple sheets. That is, according to an embodiment of the printing method according to the embodiment of the present invention, a printing method including an exposure step of imagewise-exposing the planographic printing plate precursor to form an exposed portion and an unexposed portion, and a printing step of supplying at least any of printing ink or dampening water and removing the unexposed portion of the imagewise-exposed planographic printing plate precursor on a printing press to perform printing is exemplified.

In the method of producing a planographic printing plate from the planographic printing plate precursor, regardless of the development system, the entire surface of the printing plate precursor may be heated before the image exposure, during the image exposure, or during the time period from the image exposure to the development treatment as necessary.

Examples

Hereinafter, the present invention will be described in detail with reference to examples, but the present invention is not limited thereto.

First, a support preparation method, an undercoat layer forming treatment method, an image recording layer forming method, a protective layer forming method, a resin layer (back coat layer) forming method, and an ink repellent agent coating method which are used in examples and comparative examples will be described.

<Preparation of support (1)>

Each of the following treatments (a) to (f) was sequentially performed on an aluminum plate to produce an aluminum support having an anodized film (support (1)). Further, a water washing treatment was performed between all treatment steps.

(a) Alkali etching treatment

An aluminum plate (material JIS 1052) having a thickness of 0.3 mm was subjected to an etching treatment by spraying an aqueous solution at a temperature of 60°C in which the concentration of caustic soda was 25% by mass and the concentration of aluminum ions was 100 g/L using a spray tube. The etching amount of the surface of the aluminum plate to be subjected to an electrochemical roughening treatment was 3 g/m$^2$.

(b) Desmutting treatment

Next, a desmutting treatment was performed on the aluminum plate by spraying a sulfuric acid aqueous solution (concentration of 300 g/L) at a temperature of 35°C for 5 seconds from the spray tube.

(c) Electrochemical roughening treatment

An electrochemical roughening treatment was continuously performed on the aluminum plate using an electrolytic solution (solution temperature of 35°C) obtained by dissolving aluminum chloride in a 1 mass% hydrochloric acid aqueous solution and adjusting the aluminum ion concentration to 4.5 g/L, a 60 Hz AC power source, and a flat cell type electrolytic cell. A sine wave was used as the waveform of the AC power source. In the electrochemical roughening treatment, the current density of the aluminum plate during the anodic reaction at the peak of the alternating current was 30 A/$dm^2$. The ratio between the total electric quantity during the anodic reaction and the total electric quantity during the cathodic reaction of the aluminum plate was 0.95. The electric quantity was set to 480 C/$dm^2$ in terms of the total electric quantity during the anodic reaction of the aluminum plate. The electrolytic solution was circulated using a pump so that the stirring inside the electrolytic cell was performed.

(d) Alkali etching treatment

The aluminum plate was subjected to an etching treatment by spraying an aqueous solution at a temperature of 35°C with a caustic soda concentration of 5% by mass and an aluminum ion concentration of 5 g/L from a spray tube. The etching amount of the surface of the aluminum plate on which the electrolytic roughening treatment had been performed was 0.05 g/$m^2$.

(e) Desmutting treatment

A desmutting treatment was performed on the aluminum plate by spraying an aqueous solution at a solution temperature of 35°C with a sulfuric acid concentration of 300 g/L and an aluminum ion concentration of 5 g/L from the spray tube for 5 seconds.

(f) Anodization treatment

A DC anodized film having a thickness of 1000 nm was provided under conditions of 35°C and a current density of 4.5 A/$dm^2$ using an electrolytic solution of 15% by mass of phosphoric acid. Thereafter, the aluminum plate was washed with water using a spray.

<Steepness a45, average pore diameter, ΔS>

Here, the steepness a45 was 25%, the average pore diameter was 40 nm, and ΔS was 25%.

<Preparation of support (2)>

A support (2) was prepared in the same manner as in the preparation of the support (1) except that (f) anodization treatment was changed in the following manner in the preparation of the support (1).

(fl) First anodization treatment

A DC anodized film was provided under the conditions of 60°C and a current density of 30 A/$dm^2$ using an electrolytic solution of 15% by mass of sulfuric acid (containing 0.5% by mass of aluminum ions). Thereafter, the aluminum plate was washed with water using a spray.

(f2) Second anodization treatment

A DC anodized film was provided under the conditions of 60°C and a current density of 15 A/$dm^2$ using an electrolytic solution of 15% by mass of sulfuric acid (containing 0.5% by mass of aluminum ions). Thereafter, the aluminum plate was washed with water using a spray. The thickness of the anodized film on the support (2) was 500 nm.

<Preparation of support (3)>

A support (3) was prepared in the same manner as in the preparation of the support (1) except that (g) pore widening treatment was performed in the following manner after (f) anodization treatment in the preparation of the support (1). The thickness of the anodized film on the support (3) was 800 nm.

(g) Pore widening treatment

The aluminum plate was alkali-treated with a 5% NaOH aqueous solution at 30°C for 4 seconds.

<Preparation of support (4)>

A support (4) was prepared in the same manner as in the preparation of the support (1) except that (g) pore widening treatment was performed in the following manner after (f) anodization treatment in the preparation of the support (1). The thickness of the anodized film on the support (4) was 1000 nm.

(g) Pore widening treatment

The aluminum plate was alkali-treated with a 5% NaOH aqueous solution at 30°C for 4 seconds.

<Preparation of support (5)>

A support (5) was prepared in the same manner as in the preparation of the support (1) except that the time of the anodization treatment was controlled in the preparation of the support (1).

<Preparation of support (6)>

A support (6) was prepared in the same manner as in the preparation of the support (1) except that (a) aluminum plate (material JIS 1052) having a thickness of 0.3 mm was changed to an aluminum plate having a thickness of 0.1 mm, (g) pore widening treatment was performed in the following manner after (f) anodization treatment in the preparation of the support (1). The thickness of the anodized film on the support (6) was 1000 nm.

(g) Pore widening treatment

The aluminum plate was alkali-treated with a 5% NaOH aqueous solution at 30°C for 6 seconds.

<Preparation of support (7)>

A support (7) was prepared in the same manner as in the preparation of the support (1) except that (a) aluminum plate (material JIS 1052) having a thickness of 0.3 mm was changed to an aluminum plate having a thickness of 0.5 mm, (g) pore widening treatment was performed in the following manner after (f) anodization treatment in the preparation of the support (1). The thickness of the anodized film on the support (7) was 1000 nm.

(g) Pore widening treatment

The aluminum plate was alkali-treated with a 5% NaOH aqueous solution at 30°C for 7 seconds.

<Undercoat layer forming treatment>

(Treatment A)

The aluminum support was immersed in an aqueous solution (pH of 1.9) containing 4 g/L of polyvinyl phosphonic acid at 40°C for 10 seconds. Thereafter, the aluminum support was taken out, washed with deionized water containing calcium ions at 20°C for 2 seconds, and dried. After the treatment, the amount of P and the amount of Ca on the aluminum support were respectively 25 mg/$m^2$ and 1.9 mg/$m^2$.

(Treatment B)

The aluminum support was coated with a coating solution 1 for forming an undercoat layer such that the dry coating amount thereof was set to 20 mg/$m^2$, thereby forming an undercoat layer.

(Coating solution 1 for forming undercoat layer)

· Compound (UC-1) for undercoat layer (the following structure): 0.18 g
· Hydroxyethyl imino diacetic acid: 0.05 g
· Surfactant (EMALEX 710, manufactured by Nihon Emulsion Co., Ltd.): 0.03 g
· Water: 28.0 g

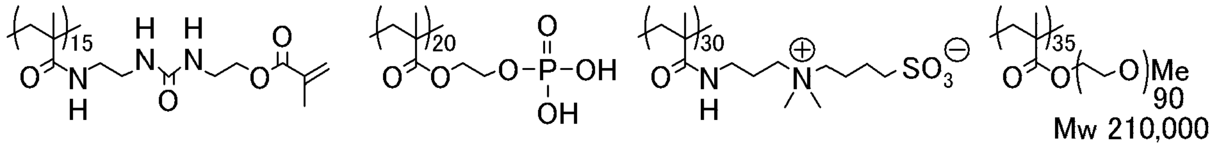

Compound (UC-1) for undercoat layer

(Treatment C)

The aluminum support was coated with a coating solution 2 for forming an undercoat layer such that the dry coating amount thereof was set to 10 mg/$m^2$ using a wire bar and dried at 90°C for 30 seconds, thereby forming an undercoat layer.

(Coating solution 2 for forming undercoat layer)

· Polymer compound A (the following structure) (mass average molecular weight: 30000): 0.05 g
· Methanol: 27 g
· Ion exchange water: 3 g

Polymer compound A

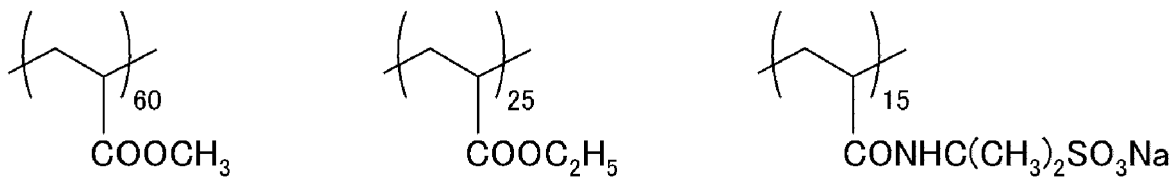

<Method of forming image recording layer A>

The aluminum support was bar-coated with a coating solution A for forming an image recording layer with the following composition and dried in an oven at 70°C for 60 seconds, thereby forming an image recording layer A having a dry coating amount of 0.6 g/$m^2$.

(Coating solution A for forming image recording layer)

· Polymer particle aqueous dispersion liquid (shown below): 20.0 g
· Infrared absorbing agent (2) (the following structure): 0.2 g
· Polymerization initiator (Irgacure 250, manufactured by Ciba Speciality Chemicals K. K.): 0.4 g
· Polymerization initiator (2) (the following structure): 0.15 g
· Polymerizable compound SR-399 (manufactured by Sartomer Japan Inc.): 1.50 g
· Mercapto-3-triazole: 0.2 g
· Byk 336 (manufactured by BYK Chemie GmbH): 0.4 g
· Klucel M (manufactured by Hercules, Inc.): 4.8 g
· ELVACITE 4026 (manufactured by Ineos Acrylics Ltd.): 2.5 g
· Anionic surfactant 1 (the following structure): 0.15 g

· n-Propanol: 55.0 g
· 2-Butanone: 17.0 g

The compounds described with the trade names in the composition above are as follows.

· IRGACURE 250: (4-methylphenyl)[4-(2-methylpropyl)phenyl]iodonium=hexafluorophosphate (75 mass% propylene carbonate solution)
· SR-399: dipentaerythritolpentaacrylate
· Byk336: modified dimethyl polysiloxane copolymer (25 mass% xylene/methoxy propyl acetate solution)
· Klucel M: hydroxypropyl cellulose (2 mass% aqueous solution)
· ELVACITE 4026: highly branched polymethyl methacrylate (10 mass% 2-butanone solution)

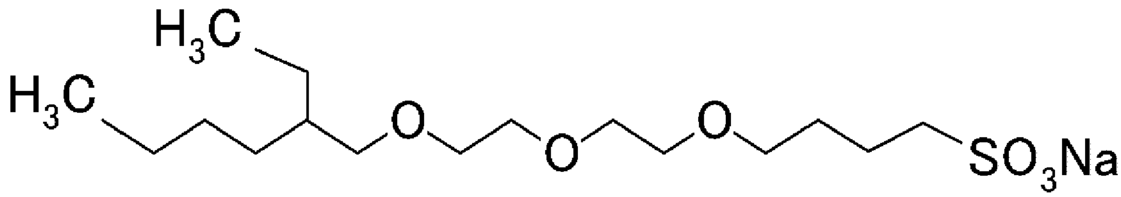

Anionic surfactant 1

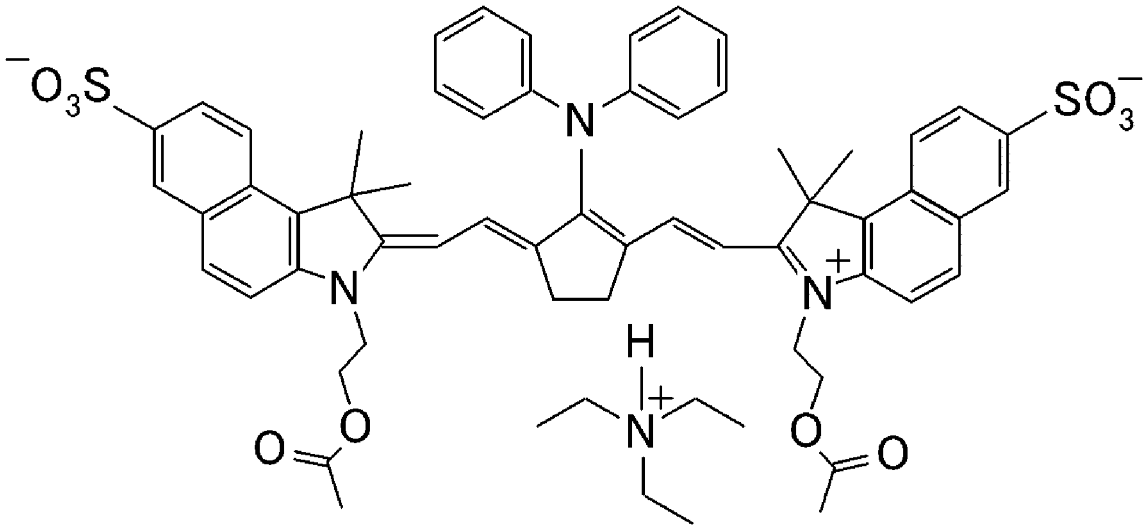

Infrared absorbing agent (2)

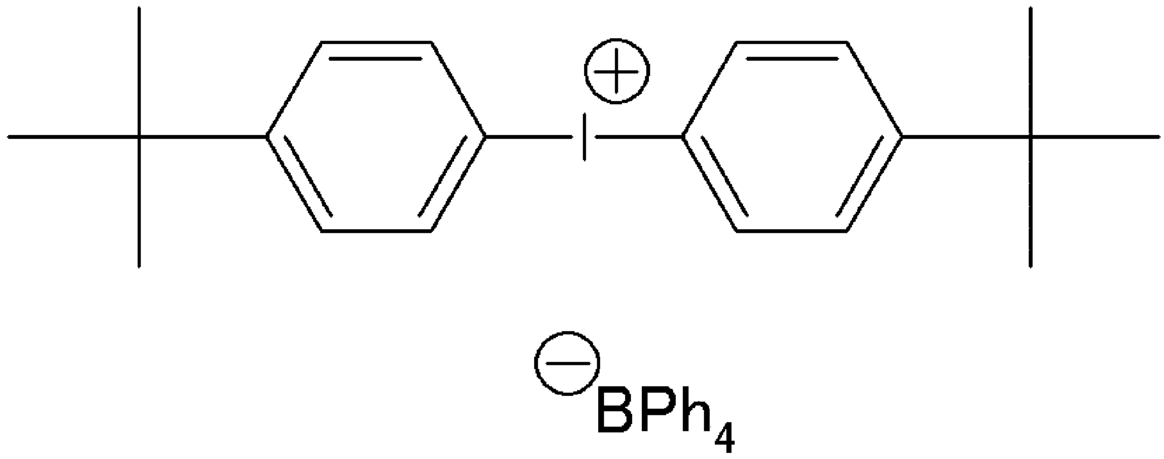

Polymerization initiator (2)

(Preparation of polymer particle aqueous dispersion liquid)

Nitrogen gas was introduced into a 1000 ml four-neck flask equipped with a stirrer, a thermometer, a dropping funnel, a nitrogen introduction pipe, and a reflux condenser, deoxygenation was performed, polyethylene glycol methyl ether methacrylate (PEGMA, average number of repeating units of ethylene glycol: 20) (10 g), distilled water (200 g), and n-propanol (200 g) were added to the flask, and then the mixture was heated until the internal temperature thereof was set to 70°C.

Next, a mixture of styrene (St) (10 g), acrylonitrile (AN) (80 g), and 2,2'-azobisisobutyronitrile (0.8 g) prepared in advance was added dropwise to the flask for 1 hour. After dropwise addition was finished, the reaction was allowed to be continued for 5 hours, 2,2'-azobisisobutyronitrile (0.4 g) was further added to the flask, and the mixture was heated until the internal temperature was set to 80°C. Subsequently, 2,2'-azobisisobutyronitrile (0.5 g) was added thereto for 6 hours. The total degree of polymerization at the stage of the continued reaction for 20 hours was 98% or greater, and a thermoplastic polymer particle aqueous dispersion liquid having PEGMA, St, and AN at a mass ratio of 10/10/80 was obtained. The particle size distribution of the polymer particle has a maximum value at 150 nm of the volume average particle diameter.

Here, the particle size distribution was acquired by imaging an electron micrograph of polymer particles, measuring the total number of 5,000 particle diameters of polymer particles on the photograph, dividing the interval from the maximum value of the obtained measured value of the particle diameter to 0 into the logarithmic scale of 50, and plotting the appearance frequency of each particle diameter. Further, the particle diameter of a spherical particle having the same particle area as the particle area on the photograph was set to the particle diameter, as non-spherical particles.

<Method of forming image recording layer B>

The aluminum support was bar-coated with a coating solution A for forming an image recording layer with the following composition and dried in an oven at 100°C for 60 seconds, thereby forming an image recording layer B having a dry coating amount of 1.0 g/m$^2$.

The coating solution B for forming an image recording layer was obtained by mixing a photosensitive solution (1) and a microgel solution (1) described below immediately before the coating and then stirring the solution.

(Photosensitive solution (1))

· Binder polymer (1) (the following structure, Mw: 55000 and n (number of ethylene oxide (EO) repeating units): 2): 0.240 parts by mass
· Infrared absorbing agent (1) (the following structure): 0.020 parts by mass
· Borate compound (sodium tetraphenyl borate): 0.010 parts by mass
· Polymerization initiator (1) (the following structure): 0.162 parts by mass
· Polymerizable compound (tris(acryloyloxyethyl) isocyanurate, NK ESTER A-9300, manufactured by Shin-Nakamura Chemical Co., Ltd.): 0.192 parts by mass

- Anionic surfactant 1 (the structure shown above): 0.050 parts by mass
- Fluorine-based surfactant (1) (the following structure): 0.008 parts by mass
- 2-Butanone: 1.091 parts by mass
- 1-Methoxy-2-propanol: 8.609 parts by mass

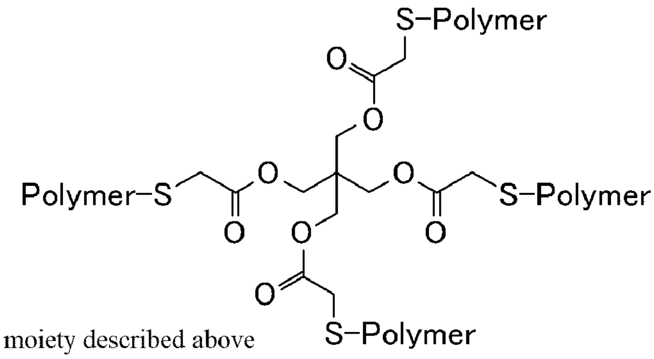

Polymer moiety described above

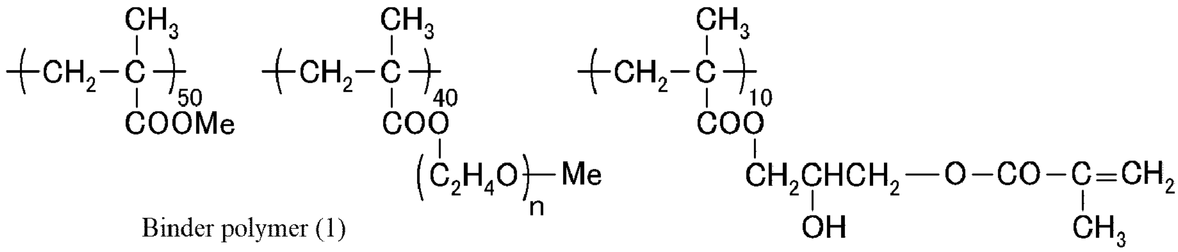

Binder polymer (1)

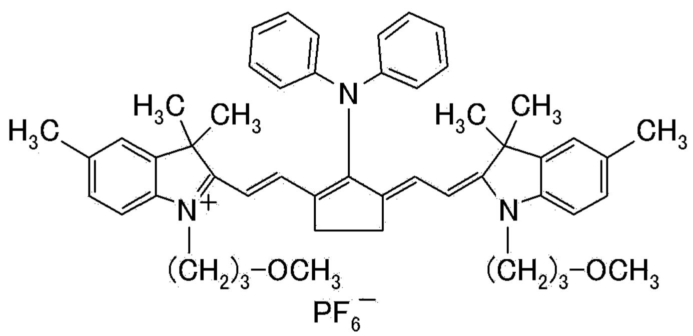

Infrared absorbing agent (1)

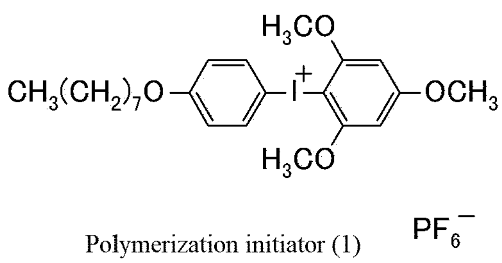

Polymerization initiator (1)

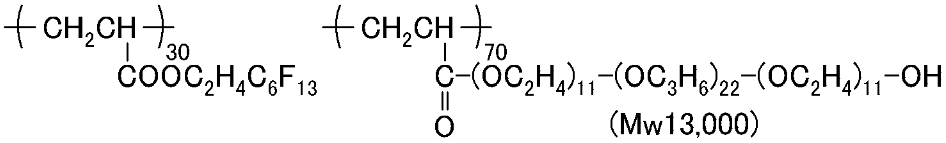

Fluorine-based surfactant (1)

(Microgel solution (1))

A method of preparing a microgel solution (1) is described below.

Bismuth tris(2-ethylhexanoate) (NEOSTANN U-600 (manufactured by NITTO KASEI CO., LTD.)) (0.043 parts by mass) was added to an ethyl acetate (25.31 parts by mass) suspension solution of isophorone diisocyanate (17.78 parts by mass, 80 molar equivalents) and the following polyhydric phenol compound (1) (7.35 parts by mass, 20 molar equivalents) and the solution was stirred. The reaction temperature was set to 50°C at the time of heat generation being subsided, and the solution was stirred for 3 hours, thereby obtaining an ethyl acetate solution (50% by mass) solution of a polyvalent isocyanate compound (1).

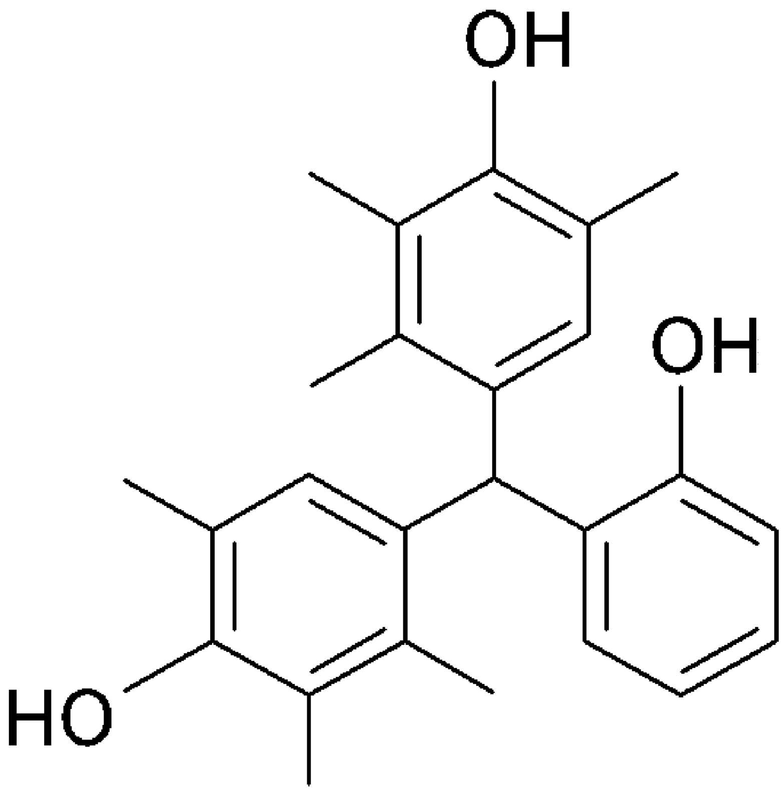

Polyhydric phenol compound (1)

The following oil phase components and the water phase components were mixed with each other and emulsified at 12000 rpm for 10 minutes using a homogenizer. The obtained emulsion was stirred at 45°C for 4 hours, a 10 mass% aqueous solution (5.20 parts by mass) of 1,8-diazabicyclo[5.4.0]undeca-7-ene-octylate (U-CAT SA102, manufactured by San-Apro Ltd.) was added thereto, and the solution was stirred at room temperature for 30 minutes and allowed to stand at 45°C for 24 hours. The concentration of solid contents was adjusted to 20% by mass using distilled water, thereby obtaining the microgel solution (1). The volume average particle diameter was measured using a dynamic light scattering type particle size distribution measuring device LB-500 (manufactured by Horiba Ltd.) according to a light scattering method, and the value was 0.28 μm.

(Oil phase components)

(Component 1) ethyl acetate: 12.0 parts by mass
(Component 2) adduct (50 mass% ethyl acetate solution, manufactured by Mitsui Chemicals, Inc.) obtained by adding trimethylolpropane (6 mol) and xylene diisocyanate (18 mol) and adding methyl one-terminal polyoxyethylene (1 mol, repetition number of oxyethylene units: 90) thereto: 3.76 parts by mass
(Component 3) polyvalent isocyanate compound (1) (as 50 mass% ethyl acetate solution): 15.0 parts by mass
(Component 4) 65 mass% solution of dipentaerythritol pentaacrylate (SR-399, manufactured by Sartomer Japan Inc.) in ethyl acetate: 11.54 parts by mass
(Component 5) 10% solution of sulfonate type surfactant (PIONINE A-41-C, manufactured by TAKEMOTO OIL & FAT Co., Ltd.) in ethyl acetate: 4.42 parts by mass
Distilled water: 46.87 parts by mass

<Method of forming image recording layer C>

The aluminum support was coated with a coating solution C for forming an image recording layer with the following composition and dried at 50°C for 60 seconds, thereby forming an image recording layer C.

The coating solution C for forming an image recording layer contained thermoplastic polymer particles, an

infrared absorbing agent IR-01, and polyacrylic acid, and the pH thereof was 3.6.

· Thermoplastic polymer particles: styrene/acrylonitrile copolymer (molar ratio of 50/50, Tg of 99°C, volume average particle diameter of 60 nm)
· Infrared absorbing agent IR-01: infrared absorbing agent with the following structure

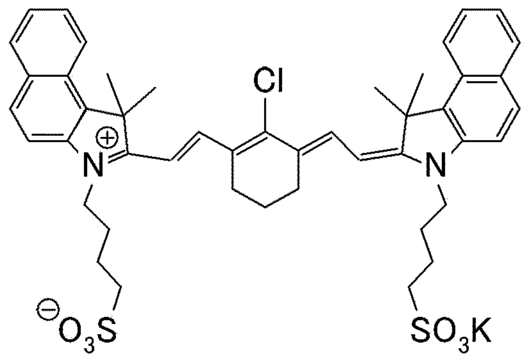

· Polyacrylic acid: weight-average molecular weight of 250000

Further, the coating amount of each component was as follows.

Thermoplastic polymer particles: 0.7 (g/$m^2$)
Infrared absorbing agent IR-01: $1.20 \times 10^{-4}$ (mol/$m^2$)
Polyacrylic acid: 0.09 (g/$m^2$)

<Method of forming image recording layer D>

The aluminum support was bar-coated with a coating solution D for forming an image recording layer with the following composition and dried in an oven at 70°C for 60 seconds, thereby forming an image recording layer D having a dry coating amount of 0.6 g/$m^2$.

(Coating solution D for image recording layer)

· Infrared absorbing agent (2) (the structure shown above): 0.030 parts
· Irgacure 250*2: 0.032 parts
· Polymerizable compound (tris(acryloyloxyethyl) isocyanurate, NK ESTER A-9300, manufactured by Shin-Nakamura Chemical Co., Ltd.): 0.092 parts
· SR-399 (manufactured by Sartomer Japan Inc.): 0.100 parts
· Graft copolymer 3*1: 0.825 parts
· BYK 306 (manufactured by BYK Chemie GmbH): 0.008 parts
· 1-Methoxy-2-propanol: 8.609 parts
· Methyl ethyl ketone: 1.091 parts

1: The graft copolymer 1 is a graft copolymer containing poly(ethylene glycol)methyl ether methacrylate, styrene, and acrylonitrile at a ratio of 10:70:20 and is a dispersion containing 24% by mass of the copolymer in a solvent containing n-propanol and water at a mass ratio of 80:20.
2: Irgacure 250 is an iodonium salt which is available from Ciba Specialty Chemicals Corporation as a 75% propylene carbonate solution and contains iodonium and (4-methylphenyl)[4-(2-methylpropyl)phenyl]-hexafluorophosphate.

<Formation of protective layer>

The image recording layer B was bar-coated with a coating solution B for a protective layer with the following composition and the image recording layer D was bar-coated with a coating solution D for a protective layer with the

following composition, and each layer was dried in an oven at 120°C for 60 seconds to form a protective layer having a dry coating amount of 0.15 g/$m^2$, thereby preparing a planographic printing plate precursor.

(Coating solution B for protective layer)

· Inorganic layered compound dispersion liquid (1) [shown below]: 1.5 g
· 6 mass% aqueous solution of polyvinyl alcohol (CKS50, manufactured by Nippon Synthetic Chemical Industry Co., Ltd., sulfonic acid-modified, saponification degree of 99% by mole or greater, degree of polymerization of 300): 0.55 g
· 6 mass% aqueous solution of polyvinyl alcohol (PVA-405, manufactured by KURARAY CO., LTD., saponification degree of 81.5% by mole, degree of polymerization of 500): 0.03 g
· 1 mass% aqueous solution of surfactant (EMALEX 710, manufactured by Nihon Emulsion Co., Ltd., polyoxyethylene lauryl ether): 0.86 g
· Ion exchange water: 6.0 g

The method of preparing the inorganic layered compound dispersion liquid (1) used in the coating solution for a protective layer is described below.

(Preparation of inorganic layered compound dispersion liquid (1))

6.4 g of Synthetic mica (SOMASIF ME-100, manufactured by CO-OP CHEMICAL CO., LTD.) was added to 193.6 g of ion exchange water and dispersed such that the average particle diameter (laser scattering method) was set to 3 μm using a homogenizer. The aspect ratio of the obtained dispersed particles was 100 or greater.

(Coating solution D for protective layer)

· 6 mass% aqueous solution of polyvinyl alcohol (PVA-405, manufactured by KURARAY CO., LTD., saponification degree of 81.5% by mole, degree of polymerization of 500): 1.0 parts
· Water: amount set such that total amount reached 10 parts by mass

The average film thickness of the protective layer depends on the number of parts of the water-soluble polymer added. For example, in a case where the number of parts of the water-soluble polymer added was 0.1 parts, since the coating amount of the water-soluble polymer was 0.1 g/$m^2$, the average film thickness of the protective layer was 0.1 μm. Further, in a case where the number of parts of the water-soluble polymer added was 0.05 parts, since the coating amount of the water-soluble polymer was 0.05 g/$m^2$, the average film thickness of the overcoat layer was 0.05 μm. The average film thickness of the overcoat layer was measured by the method described above.

<Formation of resin layer (back coat layer)>

The surface of the support opposite to a side where the image recording layer was provided was bar-coated with the coating solution (1) for a back coat layer with the following composition and dried in an oven at 120°C for 60 seconds to form a resin layer (back coat layer) such that the film thickness after the drying was set to 1 μm.

(Coating solution for back coat layer)

· PMMA (SUMIPEX (registered trademark) HT, manufactured by Sumitomo Chemical Co., Ltd.): 5.0 parts by mass
· Methyl ethyl ketone (MEK): 94.9 parts by mass
· Fluorine-based surfactant (MEGAFACE F-780-F, manufactured by DIC Corporation, 30 mass% solution of MEK): 0.1 parts by mass

<Slit>

As the slit treatment, the gap between the upper cutting blade and the lower cutting blade, the bite amount,

and the blade edge angle were adjusted using the slit device illustrated in Fig. 3 and cutting was performed to obtain sagging shapes of end portions with the sagging amounts and the sagging widths described in the examples and the comparative examples.

<Crack area proportion>

The crack area proportion in Examples 2 to 5 was 5%.

<Timing of applying ink repellent agent>

The prepared ink repellent agent was applied at the timing of " 1" or "2" below.

"1": Slit → edge treatment → exposure
"2": Slit → exposure → edge treatment

The ink repellent agent was applied to a region of the plate surface on the image recording layer side extending to a distance of 5 mm inward from two opposing end portions of the printing plate precursor by performing the above-described treatments.

<Procedures for applying ink repellent agent>

(Conditions 1 for applying ink repellent agent)

The ink repellent agent was applied according to the coating method illustrated in Fig. 4. The ink repellent agent was applied by installing a wire bar at a right angle (θ = 0°) with respect to the planographic printing plate precursor. The application was performed by the following procedures.

[1] HN-GV (manufactured by Fujifilm Global Graphic Systems Co., Ltd.) was uniformly added dropwise to a 10# wire bar in an amount of 1 $cm^3$.
[2] The wire bar was allowed to move at 20 mm/s along the side surface of the planographic printing plate precursor. At this time, the wire bar was installed at a right angle (θ = 0°) with respect to the planographic printing plate precursor.
[3] The planographic printing plate precursor was dried by applying wind at 80°C and 6 m/s for 30 seconds.
[4] Only the side surface of the planographic printing plate precursor was able to be coated with the ink repellent agent. At this time, the coating amount of the ink repellent agent was 120 $mg/m^2$.
[5] The variation Z of the coating width from the end portion of the planographic printing plate precursor was 0.1 mm.

(Conditions 2 for applying ink repellent agent)

The ink repellent agent was applied according to the coating method illustrated in Fig. 4. The coating widths of the front surface, the side surfaces, and the rear surface of the planographic printing plate precursor were adjusted by setting the amount of liquid added dropwise to the wire bar to 10 $cm^3$ and changing the angle θ between the planographic printing plate precursor and the wire bar. The coating widths were adjusted with reference to the data shown in Table 1. The coating amount of the ink repellent agent onto the side surface was 120 $mg/m^2$, and the coating amount of the ink repellent agent onto the end coating portion on the side of the photosensitive layer was 120 $mg/m^2$. Other conditions were the same as the conditions 1 for applying the ink repellent agent.

(Conditions 3 for applying ink repellent agent)

In a case where a part of the side surface of the planographic printing plate precursor was coated with the ink repellent agent, the application was performed using a wire bar having a stepped portion illustrated in Figs. 5 and 6. The application was performed by adjusting the position where the side surface of the planographic printing plate precursor and the wire bar were brought into contact with each other so that the coating width on the side surface of the planographic printing plate precursor reached a desired coating width.

(Conditions 4 for applying ink repellent agent)

In a case where the front surface side or the rear surface side was coated with the ink repellent agent such that the coating width was set to 1 mm or greater in addition to the application to the side surface of the planographic

printing plate, the ink repellent agent was applied by hand using BON-102K (manufactured by Japan Bonkote Co., Ltd.) while the pen was obliquely applied such that the corners consisting of the front surface or the rear surface and the side surfaces of the planographic printing plate precursor were in the center of the pen.

<Exposure treatment>

The prepared printing plate precursors were set by Luxel PLATESETTER T-6000III (manufactured by Fujifilm Corporation) equipped with an infrared semiconductor laser and then exposed under conditions of an external surface drum rotation speed of 1000 rpm, a laser output of 70%, and a resolution of 2400 dpi. A solid image and a 50% halftone dot chart were included in the exposed image.

<Evaluation standards>

<Edge stains, particularly edge stains caused by cracks> ("Edge stains" in the tables)

(Evaluation of printing plate precursor)

(Evaluation of edge stain resistance)

The printing plate precursors which had been exposed in the above-described manner were mounted on an offset rotary printing press, and printing was performed at a speed of 100000 sheets/hour using SOIBI KKST-S (red) (manufactured by InkTec Corporation) as printing ink for newspaper and ECO SEVEN N-1 (manufactured by SAKATA INX CORPORATION) as dampening water, the 1000 printed material was sampled, and the degree of linear stains on the end portion (edge portion) was evaluated based on the following standards. At this time, the printing was evaluated under severer conditions than the standard conditions by reducing the amount of dampening water by 35% from the standard amount.

5: Stains were not found at all
4: The level of stains was between 3 and 5
3: The end portion was slightly stained, but it was in an acceptable level
2: The level of stains was between 1 and 3, and it was in an unacceptable level
1: The end portion was clearly stained, and it was in an unacceptable level

<Paper surface formation range> ("Paper surface boundary range" in the tables)

The printing plate precursors which had been exposed were mounted on an offset rotary printing press so as to straddle the image area and the non-image area, and printing was performed at a speed of 100000 sheets/hour using SOIBI KKST-S (red) (manufactured by InkTec Corporation) as printing ink for newspaper and ECO SEVEN N-1 (manufactured by SAKATA INX CORPORATION) as dampening water, the 1000 printed material was sampled, and evaluation was performed in the following manner based on the formation condition of the paper surface. Evaluation levels up to 2 were considered as acceptable levels.

6: The printing plate was able to be treated as a normal printing plate
5: The level was between 4 and 6
4: The printing plate was able to be practically used by finely adjusting the installation position of the printing plate
3: The printing plate was able to be practically used by adjusting the drawing position and the like
2: The paper surface that was able to be drawn was present by adjusting the drawing position and the like
1: Due to the presence of many non-image areas in the printing plate, the printing plate was not able to be used as a "plate without edge stains"

<Boundary unevenness between image area and non-image area> ("Boundary unevenness" in the tables)

The printing plate precursors which had been exposed were mounted on an offset rotary printing press so as to straddle the image area and the non-image area, and printing was performed at a speed of 100000 sheets/hour using SOIBI KKST-S (red) (manufactured by InkTec Corporation) as printing ink for newspaper and ECO SEVEN N-1 (manufactured by SAKATA INX CORPORATION) as dampening water, the 1000 printed material was sampled, and the unevenness of the boundary between the image area and the non-image area was evaluated in the following manner. Evaluation levels up to 2 were considered as acceptable levels.

5: The boundary between the image area and the non-image area was on a straight line
4: The level was between 3 and 5
3: The boundary between the image area and the non-image area was seen uneven as viewed using a loupe (at a magnification of 10)
2: The level was between 1 and 3
1: At first glance, the image area and the non-image area were seen uneven.

<Stickiness>

The stickiness was evaluated in the following manner based on the feeling in a case of touching the side surface of the precursor by hand after storage at a temperature of 60°C and a humidity of 70% for 2 days.

5: Stickiness was not felt even in an environment of a temperature of 60°C and a humidity of 70%
4: The level was between 3 and 5
3: Stickiness was felt in an environment of a temperature 60°C and a humidity 70%
2: The level was between 1 and 3
1: Stickiness was felt at room temperature

<Comprehensive judgment>

In terms of ensuring an image forming region and preventing edge stains, which are the effects of the present invention, the lowest score was set as the comprehensive evaluation based on the items of the resistance to edge stains, the paper surface formation range, and the boundary unevenness between the image area and the non-image area.

<Setter plate feeding property (plate feeding property in the tables)>

A laminate obtained by laminating 100 sheets of planographic printing plate precursors directed to the same direction without using interleaving paper was set in a CTP plate setter "AMZI setter" (manufactured by NEC Engineering, Ltd.), and an operation of taking out one plate at a time from the uppermost portion of the laminate was continuously performed 100 times. The imparting of the plate-separating property at this time was evaluated based on the following standard. The evaluation was made by performing sensory evaluation with a score of 1 to 5. A value of 1 or greater is in a level of practical use and a value of 3 or greater is preferable.

5: The occurrence frequency of a phenomenon in which the next plate was not raised at the time of lifting up a plate was 100%
4: The occurrence frequency of a phenomenon in which the next plate was raised at the time of lifting up a plate and did not fall quickly was 3% or less with respect to the whole operations
3: The occurrence frequency of a phenomenon in which the next plate was raised at the time of lifting up a plate and was not peeled off by the first operation of separating the plate was 3% or less with respect to the whole operations
2: The occurrence frequency of a phenomenon in which the next plate was raised at the time of lifting up a plate and was not peeled off by the third operation of separating the plate was greater than 3% and 10% or less
1: The plate was able to be peeled off by manual plate absorption

<Measurement of arithmetic average height Sa>

The arithmetic average height Sa was measured in conformity with the method described in ISO 25178. In other words, three or more sites were selected from the same sample and measured using a micromap MM3200-M100 (manufactured by Mitsubishi Chemical Systems, Inc.), and the average value of the obtained values was set as the arithmetic average height Sa. A measurement range with a size of 1 cm × 1cm was randomly selected from the surface of the sample and the measurement was performed.

<<Comparative Example 1» (Examples 2 to 5 and Comparative Examples 1 to 5)

A support having a size of 400 mm × 1100 mm and a thickness of 0.3 mm was used as the aluminum support. The area proportion of cracks existing in the region corresponding to the sagging width Y was 5%. The ink repellent agent was applied such that the coating amount of the ink repellent agent after drying of the side surface was set to 120 $mg/m^2$ and the coating amount of the end portion on the image recording layer was set to 120 $mg/m^2$. The ink repellent agent was applied under the application conditions 1. An aluminum support having an anodized film in which the steepness

a45 was 25%, the pore diameter of micropores was 30 nm, and the specific surface area ΔS was 25% was used. The ink repellent agent was applied by coating the side surfaces of laminated planographic printing plate precursors with the ink repellent agent, and interleaving paper was interposed between the planographic printing plates for lamination. The front surface Sa of the planographic printing plate precursor was 0.2 μm, and the rear surface Sa was 0.2 μm. The ink repellent agent was applied under the conditions shown in Table 2 as other conditions such as the support and the formulation.

<<Comparative Example 2» (Examples 6 to 19 and Comparative Examples 6 to 8)

The application was performed under the same conditions as in Comparative Example 1 except that the support and the image recording layer were treated under the conditions shown in Table 3 and the conditions for applying the ink repellent agent were changed to the conditions 2 to 4 for applying the ink repellent agent.

<<Comparative Example 3» (Examples 20 to 27)

The coating of the side portion of the support with the ink repellent agent and the drying of the support were repeatedly performed, and evaluation was performed by controlling the coating amount of the ink repellent agent on the side portion of the support such that the coating amount reached to the coating amount shown in Table 4.

<<Comparative Example 4» (Examples 28 to 35)

The coating of the end portion of the image recording layer with the ink repellent agent and the drying of the image recording layer were repeatedly performed, and evaluation was performed by controlling the coating amount of the ink repellent agent on the side portion such that the coating amount reached to the coating amount shown in Table 5. At this time, the variation Z was set to 0.1 mm.

<<Comparative Example 5» (Examples 38 to 42)

The application was performed under the same conditions as in Comparative Example 2 except that the support was changed, and the evaluation was performed. At this time, the variation Z was set to 0.1 mm.

<<Comparative Example 6» (Examples 43 to 45)

The evaluation was performed by changing the steepness a45 of the anodized film to the numerical value shown in Table 7. The image recording layer A was formed using the support (2), and the application was performed under the same conditions as in the Comparative Example 2.

<<Comparative Example 7» (Examples 46 to 50)

The evaluation was performed by changing the average diameter of the micropores of the anodized film to the numerical values shown in Table 8. The image recording layer A was formed using the support (2), and the application was performed under the same conditions as in the Comparative Example 2.

<<Comparative Example 8» (Examples 51 to 53)

The evaluation was performed by changing the specific surface area ΔS of the anodized film to the numerical value shown in Table 9. The image recording layer A was formed using the support (2), and the application was performed under the same conditions as in the Comparative Example 2.

<<Comparative Example 9» (Examples 54 to 58)

MR-7GC (manufactured by Soken Chemical & Engineering Co., Ltd., crosslinked acrylic polydisperse particles, average particle diameter of 6.5 μm) was added to the coating solution for the protective layer or the photosensitive layer, and the surface Sa value was adjusted to the numerical value shown in Table 10. Further, MR-7GC (manufactured by Soken Chemical & Engineering Co., Ltd., crosslinked acrylic polydisperse particles, average particle diameter of 6.5 μm) was added to the coating solution for the back coat layer, and the surface Sa value was adjusted to the numerical value shown in Table 10. The image recording layer A was formed using the support (2), and the application was performed under the same conditions as in the Comparative Example 2.

<Results>

The results are shown in Tables 2 to 10.

Table 2

| | SUPPORT | IMAGE RECORDING LAYER | RECTANGULAR SHAPE | | INK REPELLENT AGENT ON SIDE SURFACE | | INK REPELLENT AGENT ON END PORTION OF IMAGE RECORDING LAYER | | | EVALUATION | | | COMPREHENSIVE JUDGEMENT |
|---|---|---|---|---|---|---|---|---|---|---|---|---|---|
| | | | SAGGING AMOUNT X [μm] | SAGGING AMOUNT Y [μm] | WHETHER TO IMPLEMENT | WIDTH [mm] | WHETHER TO IMPLEMENT | WIDTH [mm] | VARIATION Z [mm] | EDGE STAIN | PAPER SURFACE BOUNDARY RANGE | BOUNDARY UNEVENNESS | |
| COMPARATIVE EXAMPLE 1 | EXAMPLE 1 OF JP2011-177983A | | 3 | 15 | IMPLEMENTED | 0.3 | IMPLEMENTED | 10 | 1 | 1 | 3 | 1 | 1 |
| COMPARATIVE EXAMPLE 2 | EXAMPLE 1 OF WO2015/119089 | | 50 | 150 | NOT IMPLEMENTED | 0 | NOT IMPLEMENTED | 5 | 1 | 1 | 3 | 1 | 1 |
| COMPARATIVE EXAMPLE 3 | WITHOUT EDGE TREATMENT | | 50 | 90 | NOT IMPLEMENTED | 0 | NOT IMPLEMENTED | 0 | 0 | 1 | 5 | 5 | 1 |
| COMPARATIVE EXAMPLE 4 | EXAMPLE 1 OF JP-H08-058257A | | 50 | 150 | IMPLEMENTED | 0.3 | NOT IMPLEMENTED | 0 | 0 | 3 | 1 | 5 | 1 |
| COMPARATIVE EXAMPLE 5 | EXAMPLE 1 OF JP-H11-052579A | | 50 | 300 | NOT IMPLEMENTED | 0 | NOT IMPLEMENTED | 0 | 1 | 3 | 1 | 1 | 1 |
| EXAMPLE 2 | (1) | A | 50 | 90 | IMPLEMENTED | 0.3 | NOT IMPLEMENTED | a | 0 | 4 | 5 | 5 | 4 |
| EXAMPLE 3 | (1) | B | 50 | 90 | IMPLEMENTED | 0.3 | NOT IMPLEMENTED | 0 | 0 | 4 | 5 | 5 | 4 |
| EXAMPLE 4 | (1) | C | 50 | 90 | IMPLEMENTED | 0.3 | IMPLEMENTED | 0 | 0 | 4 | 5 | 5 | 4 |
| EXAMPLE 5 | (1) | D | 50 | 90 | IMPLEMENTED | 0.3 | NOT IMPLEMENTED | 0 | 0 | 4 | 5 | 5 | 4 |

Table 3

| | SUPPORT | IMAGE RECORDING LAYER | RECTANGULAR SHAPE | | | INK REPELLENT AGENT ON SIDE SURFACE | | INK REPELLENT AGENT ON END PORTION OF IMAGE RECORDING LAYER | | | EVALUATION | | | COMPREHENSIVE JUDGEMENT | EVALUATION |
|---|---|---|---|---|---|---|---|---|---|---|---|---|---|---|---|
| | | | **SAGGING** AMOUNT X [μm] | **SAGGING** AMOUNT Y [μm] | AREA PROPORTION OF CRACKS K | WHETHER TO IMPLEMENT | WIDTH [mm] | WHETHER TO IMPLEMENT | WIDTH [mm] | VARIATION Z [mm] | EDGE STAIN | PAPER SURFACE BOUNDARY RANGE | BOUNDARY UNEVENNESS | | STICKINESS |
| EXAMPLE 6 | (2) | A | 50 | 150 | 5 | IMPLEMENTED | 0.3 | NOT IMPLEMENTED | 0 | 0 | 4 | 5 | 5 | 4 | 5 |
| COMPARATIVE EXAMPLE 6 | (2) | A | 20 | 150 | 5 | IMPLEMENTED | 0.3 | NOT IMPLEMENTED | 0 | 0 | 1 | 5 | 5 | 1 | 5 |
| COMPRATIVE EXAMPLE 7 | (2) | A | 50 | 50 | 1 | IMPLEMENTED | 0.3 | NOT IMPLEMENTED | 0 | 0 | 1 | 5 | 5 | 1 | 5 |
| COMPARATIVE EXAMPLE 8 | (2) | A | 120 | 350 | 4 | IMPLEMENTED | 0.3 | NOT IMPLEMENTED | 0 | 0 | 1 | 5 | 5 | 1 | 5 |
| EXAMPLE 1 | (2) | A | 25 | 70 | 4 | IMPLEMENTED | 0.3 | NOT IMPLEMENTED | 0 | 0 | 2 | 5 | 5 | 2 | 5 |
| EXAMPLE 8 | (2) | A | 150 | 300 | 8 | IMPLEMENTED | 0.3 | NOT IMPLEMENTED | 0 | 0 | 2 | 5 | 5 | 2 | 5 |

(continued)

| | SUPPORT | IMAGE RECORDING LAYER | RECTANGULAR SHAPE | | | INK REPELLENT AGENT ON SIDE SURFACE | | INK REPELLENT AGENT ON END PORTION OF IMAGE RECORDING LAYER | | | EVALUATION | | | COMPREHENSIVE JUDGEMENT | EVALUATION |
|---|---|---|---|---|---|---|---|---|---|---|---|---|---|---|---|
| | | | **SAGGING** AMOUNT X [μm] | **SAGGING** AMOUNT Y [μm] | AREA PROPORTION OF CRACKS K | WHETHER TO IMPLEMENT | WIDTH [mm] | WHETHER TO IMPLEMENT | WIDTH [mm] | VARIATION Z [mm] | EDGE STAIN | PAPER SURFACE BOUNDARY RANGE | BOUNDARY UNEVENNESS | | STICKINESS |
| EXAMPLE 9 | (2) | A | 50 | 150 | 5 | IMPLEMENTED | LOWER LIMIT OF WIDTHWAS SET TO ONLY 0.29 | NOT IMPLEMENTED | 0 | 0 | 4 | 5 | 5 | 4 | 2 |
| EXAMPLE 10 | (2) | A | 50 | 150 | 5 | IMPLEMENTED | LOWER LIMIT OF WIDTHWAS SET TO ONLY 0.27 | NOT IMPLEMENTED | 0 | 0 | 3 | 5 | 5 | 3 | 2 |
| EXAMPLE 11 | (2) | A | 50 | 150 | 5 | IMPLEMENTED | 0.3 | IMPLEMENTED | 12 | 0.4 | 5 | 2 | 2 | 2 | 2 |
| EXAMPLE 12 | (2) | A | 50 | 150 | 5 | IMPLEMENTED | 0.3 | IMPLEMENTED | 10 | 0.3 | 5 | 3 | 3 | 3 | 2 |
| EXAMPLE 13 | (2) | A | 50 | 150 | 5 | IMPLEMENTED | 0.3 | IMPLEMENTED | 0.5 | 0.1 | 5 | 5 | 5 | 5 | 3 |

(continued)

| | SUP-PORT | IMAGE RECORD-ING LAY-ER | RECTANGULAR SHAPE | | | INK REPELLENT AGENT ON SIDE SURFACE | | INK REPELLENT AGENT ON END PORTION OF IMAGE RECORDING LAYER | | | EVALUATION | | | COMPRE-HENSIVE JUDGEMENT | EVALUA-TION |
|---|---|---|---|---|---|---|---|---|---|---|---|---|---|---|---|
| | | | **SAG-GING** AMOUNT X [μm] | **SAG-GING** AMOUNT Y [μm] | AREA PROPOR-TION OF CRACKS K | WHETHER TO IMPLEMENT | WIDTH [mm] | WHETHER TO IMPLE-MENT | WIDTH [mm] | VARIA-TION Z [mm] | EDGE STAIN | PAPER SUR-FACE BOUND-ARY RANGE | BOUNDA-RY UNE-VENNESS | | STICKI-NESS |
| EXAMPLE 14 | (2) | A | 50 | 150 | 5 | IMPLE-MENTED | 0.3 | IMPLE-MENTED | 1 | 0.5 | 5 | 5 | 5 | 5 | 2 |
| EXAMPLE 15 | (2) | A | 50 | 150 | 5 | IMPLE-MENTED | 0.3 | IMPLE-MENTED | 1 | 0.6 | 5 | 5 | 4 | 4 | 2 |
| EXAMPLE 16 | (2) | A | 50 | 150 | 5 | IMPLE-MENTED | 0.3 | IMPLE-MENTED | 0.6 | 0.1 | 5 | 5 | 5 | 5 | 3 |
| EXAMPLE 11 | (2) | A | 50 | 150 | 5 | IMPLE-MENTED | 0.3 | IMPLE-MENTED | 0.4 | 0.1 | 5 | 5 | 5 | 5 | 4 |
| EXAMPLE 18 | (6) | A | 50 | 130 | 5 | IMPLE-MENTED | 0.1 | IMPLE-MENTED | 0.4 | 0.1 | 3 | 5 | 5 | 3 | 2 |
| EXAMPLE 19 | (7) | A | 50 | 180 | 6 | IMPLE-MENTED | 0.1 | IMPLE-MENTED | 0.4 | 0.1 | 3 | 5 | 5 | 3 | 2 |

Table 4

| | SUPPORT | IMAGE RECORDING LAYER | RECTANGULAR SHAPE | | INK REPELLENT AGENT ON SIDE SURFACE | | | EVALUATION | | | COMPREHENSIVE JUDGEMENT | EVALUATION |
|---|---|---|---|---|---|---|---|---|---|---|---|---|
| | | | SAGGING AMOUNT X [μm] | SAGGING AMOUNT Y [μm] | WHETHER TO IMPLEMENT | WIDTH [mm] | COATING AMOUNT [mg/m$^2$] | EDGE STAIN | PAPER SURFACE BOUNDARY RANGE | BOUNDARY UNEVENNESS | | STICKINESS |
| EXAMPLE 20 | (2) | A | 50 | 150 | IMPLEMENTED | 0.3 | 8 | 2 | 5 | 5 | 2 | 5 |
| EXAMPLE 21 | (2) | A | 50 | 150 | IMPLEMENTED | 0.3 | 10 | 3 | 5 | 5 | 3 | 5 |
| EXAMPLE 22 | (2) | A | 50 | 150 | IMPLEMENTED | 0.3 | 30 | 3 | 5 | 5 | 3 | 5 |
| EXAMPLE 23 | (2) | A | 50 | 150 | IMPLEMENTED | 0.3 | 50 | 4 | 5 | 5 | 4 | 5 |
| EXAMPLE 24 | (2) | A | 50 | 150 | IMPLEMENTED | 0.3 | 500 | 4 | 5 | 5 | 4 | 5 |
| EXAMPLE 25 | (2) | A | 50 | 150 | IMPLEMENTED | 0.3 | 3000 | 4 | 5 | 5 | 4 | 4 |
| EXAMPLE 26 | (2) | A | 50 | 150 | IMPLEMENTED | 0.3 | 5000 | 4 | 5 | 5 | 4 | 3 |
| EXAMPLE 21 | (2) | A | 50 | 150 | IMPLEMENTED | 0.3 | 5500 | 4 | 5 | 5 | 4 | 2 |

Table 5

| | SUPPORT | IMAGE RECORDING LAYER | RECTANGULAR SHAPE | | INK REPELLENT AGENT ON SIDE SURFACE | | | EVALUATION | | | COMPREHENSIVE JUDGEMENT | EVALUATION |
|---|---|---|---|---|---|---|---|---|---|---|---|---|
| | | | SAGGING AMOUNT X [μm] | SAGGING AMOUNT Y [μ m] | WHETHER TO IMPLEMENT | WIDTH [mm] | COATING AMOUNT [mg/m$^2$] | EDGE STAIN | PAPER SURFACE BOUNDARY RANGE | BOUNDARY UNEVENNESS | | STICKINESS |
| EXAMPLE 28 | (2) | A | 50 | 150 | IMPLEMENTED | 0.3 | 8 | 2 | 5 | 5 | 2 | 5 |
| EXAMPLE 29 | (2) | A | 50 | 150 | IMPLEMENTED | 0.3 | 10 | 3 | 5 | 5 | 3 | 5 |
| EXAMPLE 30 | (2) | A | 50 | 150 | IMPLEMENTED | 0.3 | 30 | 4 | 5 | 5 | 4 | 5 |
| EXAMPLE 31 | (2) | A | 50 | 150 | IMPLEMENTED | 0.3 | 50 | 5 | 5 | 5 | 5 | 5 |
| EXAMPLE 32 | (2) | A | 50 | 150 | IMPLEMENTED | 0.3 | 500 | 5 | 5 | 5 | 5 | 5 |
| EXAMPLE 33 | (2) | A | 50 | 150 | IMPLEMENTED | 0.3 | 3000 | 5 | 5 | 5 | 5 | 4 |
| EXAMPLE 34 | (2) | A | 50 | 150 | IMPLEMENTED | 0.3 | 5000 | 5 | 5 | 5 | 5 | 3 |
| EXAMPLE 35 | (2) | A | 50 | 150 | IMPLEMENTED | 0.3 | 5500 | 5 | 5 | 5 | 5 | 2 |

Table 6

| | SUPPORT | CRACK RATE [%] | EVALUATION |
|---|---|---|---|
| | | | EDGE STAIN OCCURRING PARTICULARLY IN CRACKS |
| COMPARATIVE EXAMPLE 38 | (1) | 5 | 5 |
| COMPARATIVE EXAMPLE 39 | (2) | 6 | 5 |
| COMPARATIVE EXAMPLE 40 | (3) | 8 | 4 |
| COMPARATIVE EXAMPLE 41 | (4) | 10 | 4 |
| COMPARATIVE EXAMPLE 42 | (5) | 30 | 3 |

Table 7

| | a45 [μm] | RECTANGULAR SHAPE | | INK REPELLENT AGENT ON SIDE SURFACE | | INK REPELLENT AGENT ON END PORTION OF IMAGE RECORDING LAYER | | | EVALUATION | | | COMPREHEN-SIVE JUDGE-MENT |
|---|---|---|---|---|---|---|---|---|---|---|---|---|
| | | **SAGGING** AMOUNT X [μm] | SAGGING AMOUNT Y [μm] | WHETHER TO IMPLEMENT | WIDTH [mm] | WHETHER TO IMPLEMENT | WIDTH [mm] | VARIATION Z [mm] | EDGE STAIN | PAPER SURFACE BOUNDARY RANGE | BOUNDARY UNEVENNESS | |
| COMPARATIVE EXAMPLE 43 | 10% | 50 | 150 | IMPLEMENT-ED | 0.3 | IMPLEMENT-ED | 0.5 | 0.1 | 5 | 5 | 5 | 5 |
| COMPARATIVE EXAMPLE 44 | 25% | 50 | 150 | IMPLEMENT-ED | 0.3 | IMPLEMENT-ED | 0.5 | 0.1 | 5 | 5 | 5 | 5 |
| COMPARATIVE EXAMPLE 45 | 30% | 50 | 150 | IMPLEMENT-ED | 0.3 | IMPLEMENT-ED | 0.5 | 0.1 | 4 | 5 | 5 | 4 |

Table 8

| | AVERAGE DIAMETER [%] | RECTANGULAR SHAPE | | INK REPELLENT AGENT ON SIDE SURFACE | | INK REPELLENT AGENT ON END PORTION OF IMAGE RECORDING LAYER | | | EVALUATION | | | COMPREHENSIVE JUDGEMENT |
|---|---|---|---|---|---|---|---|---|---|---|---|---|
| | | SAGGING AMOUNT X [$\mu$m] | SAGGING AMOUNT Y [$\mu$m] | WHETHER TO IMPLEMENT | WIDTH [mm] | WHETHER TO IMPLEMENT | WIDTH [mm] | VARIATION Z [mm] | EDGE STAIN | PAPER SURFACE BOUNDARY RANGE | BOUNDARY UNEVENNESS | |
| COMPARATIVE EXAMPLE 46 | 5 | 50 | 150 | IMPLEMENTED | 0.3 | IMPLEMENTED | 0.5 | 0.1 | 4 | 5 | 5 | 4 |
| COMPARATIVE EXAMPLE 41 | 10 | 50 | 150 | IMPLEMENTED | 0.3 | IMPLEMENTED | 0.5 | 0.1 | 5 | 5 | 5 | 5 |
| COMPARATIVE EXAMPLE 48 | 30 | 50 | 150 | IMPLEMENTED | 0.3 | IMPLEMENTED | 0.5 | 0.1 | 5 | 5 | 5 | 5 |
| COMPARATIVE EXAMPLE 49 | 100 | 50 | 150 | IMPLEMENTED | 0.3 | IMPLEMENTED | 0.5 | 0.1 | 5 | 5 | 5 | 5 |
| COMPARATIVE EXAMPLE 50 | 150 | 50 | 150 | IMPLEMENTED | 0.3 | IMPLEMENTED | 0.5 | 0.1 | 5 | 4 | 5 | 4 |

Table 9

| | ΔS [%] | RECTANGULAR SHAPE | | INK REPELLENT AGENT ON SIDE SURFACE | | INK REPELLENT AGENT ON END PORTION OF IMAGE RECORDING LAYER | | | EVALUATION | | | COMPREHENSIVE JUDGEMENT |
|---|---|---|---|---|---|---|---|---|---|---|---|---|
| | | SAGGING AMOUNT X [μm] | **SAGGING** AMOUNT Y [μm] | WHETHER TO IMPLEMENT | WIDTH [mm] | WHETHER TO IMPLEMENT | WIDTH [mm] | VARIATION Z [mm] | EDGE STAIN | PAPER SURFACE BOUNDARY RANGE | BOUNDARY UNEVENNESS | |
| COMPARATIVE EXAMPLE 51 | 15 | 50 | 150 | IMPLEMENTED | 0.3 | IMPLEMENTED | 0.5 | 0.1 | 4 | 5 | 5 | 4 |
| COMPARATIVE EXAMPLE 52 | 20 | 50 | 150 | IMPLEMENTED | 0.3 | IMPLEMENTED | 0.5 | 0.1 | 5 | 5 | 5 | 5 |
| COMPARATIVE EXAMPLE 53 | 40 | 50 | 150 | IMPLEMENTED | 0.3 | IMPLEMENTED | 0.5 | 0.1 | 5 | 5 | 5 | 5 |

Table 10

| | FRONT SURFACE [μm] | REAR SURFACE [μm] | INTERLEAVING PAPER | RECTANGULAR SHAPE | | INK REPELLENT AGENT ON SIDE SURFACE | | INK REPELLENT AGENT ON END PORTION OF IMAGE RECORDING LAYER | | | EVALUATION | | | |
|---|---|---|---|---|---|---|---|---|---|---|---|---|---|---|
| | | | | SAGGING AMOUNT X [μm] | SAGGING AMOUNT Y [μm] | WHETHER 10 IMPLEMENT | WIDTH [mm] | WHETHER 10 IMPLEMENT | WIDTH [mm] | VARIATION Z [mm] | EDGE STAIN | PAPER SURFACE BOUNDARY RANGE | BOUNDARY UNEVENNESS | EVALUATION OF PLATE FEEDING PROPERTY |
| EXAMPLE 54 | 0.2 | 0.2 | IMPLEMENTED | 50 | 150 | IMPLEMENTED | 0.3 | IMPLEMENTED | 0.5 | 0.1 | 5 | 5 | 5 | 5 |
| EXAMPLE 55 | 1.2 | 0.2 | NOT IMPLEMENTED | 50 | 150 | IMPLEMENTED | 0.3 | IMPLEMENTED | 0.5 | 0.1 | 5 | 6 | 6 | 4 |
| EXAMPLE 56 | 0.2 | 1.2 | NOT IMPLEMENTED | 50 | 150 | IMPLEMENTED | 0.3 | IMPLEMENTED | 0.5 | 0.1 | 5 | 6 | 6 | 4 |
| EXAMPLE 51 | 1.2 | 1.2 | NOT IMPLEMENTED | 50 | 150 | IMPLEMENTED | 0.3 | IMPLEMENTED | 0.5 | 0.1 | 5 | 6 | 6 | 5 |
| EXAMPLE 58 | 0.2 | 0.2 | NOT IMPLEMENTED | 50 | 150 | IMPLEMENTED | 0.3 | IMPLEMENTED | 0.5 | 0.1 | 5 | 6 | 6 | 2 |

As shown in Table 2, in the comparative examples in which the ink repellent agent (hydrophilizing agent) or the like was applied by a method of the related art or in the edge treatment was not performed, any of the edge stains, the paper surface formation range, and the boundary unevenness was evaluated as "1" and the comprehensive judgement was also "1". The edge stains were able to be prevented in a state of ensuring the image forming region by applying the ink repellent agent only to the end portions.

Particularly, in Comparative Example 1 (Example 1 of Patent Document 1 described above) and Comparative Example 2 (Example 1 of JP2011-177983A described above), the edge stains were able to be eliminated under more severe evaluation conditions than those of the related art by applying the ink repellent agent to the side surface of the planographic printing plate precursor. As described above, it was confirmed that the resistance to edge stains can be markedly improved by applying the ink repellent agent to the side surface of the planographic printing plate precursor, and thus the image recording layer can be widely taken.

Table 3 is a table showing the results of Examples 6 to 19 and Comparative Examples 6 to 8. As shown in Comparative Examples 6 to 8, in a case where any of the sagging amount X and the sagging width Y of the end portion in a rectangular shape was not in the range of the present invention, the edge stains were not able to be eliminated simply by forming an ink repellent agent layer on the side surface. By setting the sagging amount X and the sagging width Y to be in the range of the present invention, the edge stains were able to be eliminated.

Further, the evaluation of the edge stain was lowered in a case where the lower limit of the width of the ink repellent layer on the side surface was set to 0.29 mm or 0.27 mm, but was not problematic (Examples 9 and 10). Further, the edge stains were able to be eliminated by applying the ink repellent agent to the image recording layer as well. The evaluation of the paper formation range and the boundary unevenness was lowered, but was not problematic. By narrowing the width from the end portion of the planographic printing plate on the image recording layer, satisfactory results for the paper surface formation range and the boundary unevenness were able to be obtained.

Based on Examples 14 and 15, the boundary unevenness was able to be highly evaluated by setting the value of Z to 0.5 or less, and the boundary was able to make linear.

Examples 16 to 21 are examples in which the relationship between the width of the ink repellent agent on the image forming surface and the width of the ink repellent agent on the side surface was changed. Based on comparison with Examples 11 and 12, the width of the ink repellent agent on the image forming surface was decreased using the width of the ink repellent agent on the image forming surface and the width of the ink repellent agent on the side surface. Specifically, the value obtained by dividing the width of the ink repellent agent on the forming surface by the width of the ink repellent agent on the side surface was set to 10 or less. In this manner, it is possible to prevent edge stains, ensure an image forming region, and suppress stickiness of the planographic printing plate precursor.

As shown in Table 4, edge stains can be prevented by increasing the coating amount in Examples 20 to 27. Here, since the evaluation of the stickiness is lowered as the coating amount increases, it is preferable that the coating amount is set based on the acceptable range of the stickiness.

Even in a case of the coating amount of the ink repellent agent applied onto the image forming layer, the edge stains can be prevented by increasing the coating amount thereof as shown in Table 5. However, since the evaluation of the stickiness is lowered, it is preferable that the coating amount is set based on the acceptable range of the stickiness.

As shown in Table 6, since the amount of ink remaining in cracks is increased by increasing the area proportion of the cracks in Examples 38 to 42, the evaluation of the edge stains is lowered. The crack rate is preferably 30% or less.

As shown in Table 7, in a case where the steepness a45 of the anodized film is higher than those in Examples 43 to 45, the ink is more likely to remain, and thus edge stains are more likely to occur. The steepness a45 is preferably 25% or less.

As shown in Table 8, the edge stains can be prevented in a case where the average diameter of the micropores of the anodized film is increased in Examples 46 to 50. However, since the paper surface formation range is decreased in the case where the average diameter thereof is increased, it is preferable that the average diameter thereof is set to be in a range of 15 $\mu$m to 100 $\mu$m.

As shown in Table 9, in a case where the specific surface area $\Delta S$ is increased in Examples 51 to 53, the edge stains can be prevented. The specific surface area $\Delta S$ is preferably 20% or greater.

As shown in Table 10, satisfactory evaluation results for the plate feeding property were able to be obtained by setting at least any of the front surface Sa or the rear surface Sa to 1.2 $\mu$m. Further, more satisfactory evaluation results for the plate feeding property were able to be obtained by setting both the front surface Sa and the rear surface Sa to 1.2 $\mu$m.

Explanation of References

10, 10a, 10b, 10c, 10d, 10e: planographic printing plate precursor

12: aluminum support
14: anodized film
14a: micropore
15: crack
16: image recording layer
18: sagging shape
20: end surface (side surface)
22: surface of image recording layer
30, 32: cutting blade
30a, 30b: upper cutting blade
32a, 32b: lower cutting blade
34, 36: rotating shaft
38, 39: wire bar
40: stepped portion
42: coating solution
44: ink repellent agent

## Claims

**1.** A planographic printing plate precursor (10) comprising:

an aluminum support (11) which has an anodized film; and
an image recording layer (16) on the aluminum support (12),
wherein an end portion of the planographic printing plate precursor has a sagging shape (18) having a sagging amount X of 25 μm to 150 μm and a sagging width Y of 70 μm to 300 μm,
the image recording layer contains an infrared absorbing agent,
a part or an entire side surface of two sides of the aluminum support (12), the two sides having the sagging shape (18) and opposing each other contains an ink repellent agent, and
the arithmetic average height Sa of the surface of the outermost layer on a side where the image recording layer (16) is provided is in a range of 0.2 μm to 20 μm.

**2.** The planographic printing plate precursor according to claim 1,
wherein the ink repellent agent is contained in a region which extends to a distance of at least 30 μm from a surface of the aluminum support on a side of the image recording layer and extends along a longitudinal direction of the aluminum support.

**3.** The planographic printing plate precursor according to claim 1 or 2,
wherein an amount of the ink repellent agent is in a range of 10 $mg/m^2$ to 5000 $mg/m^2$.

**4.** The planographic printing plate precursor according to any one of claims 1 to 3,
wherein a region on the image recording layer of the aluminum support which extends to a distance of less than 1 cm from end portions of two opposing sides of the aluminum support contains the ink repellent agent.

**5.** The planographic printing plate precursor according to claim 4,

wherein a region on the image recording layer of the aluminum support which extends to a distance of less than 3 mm from end portions of two opposing sides of the aluminum support contains the ink repellent agent, and preferably, a region on the image recording layer of the aluminum support which extends to a distance of less than 1 mm from end portions of two opposing sides of the aluminum support contains the ink repellent agent.

**6.** The planographic printing plate precursor according to claim 4 or 5, in the ink repellent agent provided on the image recording layer,
a value of Z represented by the following equation, which is a variation in a width of the ink repellent agent from the end portion of the aluminum support in a width direction except for a region which extends to a distance of 5 cm from both ends of two opposing sides of the aluminum support in a longitudinal direction is 0.5 mm or less.

$$Z = \frac{1}{N}\sum_{n-1}^{N} |Zn - \bar{Z}|$$

(Zn represents a width of the ink repellent agent from the end portion the ink repellent agent at an arbitrary point of the aluminum support in the longitudinal direction, N represents a number obtained by measuring the width of the ink repellent agent, and $\bar{Z}$ represents an average value of widths from the end portion of the ink pellent agent.)

**7.** The planographic printing plate precursor according to any one of claims 4 to 6,

wherein the amount of the ink repellent agent applied onto the image recording layer is in a range of 10 $mg/m^2$ to 5000 $mg/m^2$,
and/or
a value obtained by dividing the width of the ink repellent agent applied onto the image recording layer by a width of the side surface of the aluminum support is less than 10.

**8.** The planographic printing plate precursor according to any one of claims 1 to 7,
wherein the anodized film has micropores in the surface thereof and an average diameter of the micropores is in a range of 10 nm to 100 nm.

**9.** The planographic printing plate precursor according to any one of claims 1 to 8,
wherein, in the surface of the anodized film on the side of the image recording layer, a specific surface area ΔS which is a value acquired by Equation (i) based on a geometric measurement area $S_0$ and an actual area Sx obtained by an approximation three point method from three-dimensional data obtained by measuring 512 × 512 points in a region having a size of 25 μm × 25 μm on the surface of the anodized film on the side of the image recording layer using an atomic force microscope is 20% or greater.

$$\Delta S = (S_x - S_0)/S_0 \times 100\ (\%) \cdots (i)$$

**10.** The planographic printing plate precursor according to any one of claims 1 to 9,
wherein the image recording layer contains polymer particles consisting of an acrylonitrile copolymer.

**11.** The planographic printing plate precursor according to any one of claims 1 to 10,
wherein an arithmetic average height Sa of a surface of an outermost layer on a side opposite to a side where the image recording layer is provided is in a range of 0.3 μm to 20 μm.

**12.** The planographic printing plate precursor according to any one of claims 1 to 11,
wherein the image recording layer includes a water-soluble or water-dispersible negative type image recording layer.

**13.** A method of producing a planographic printing plate precursor, comprising:

a cutting step of cutting an aluminum support which has an anodized film thereon and an image recording layer containing an infrared absorbing agent on the anodized film, wherein an arithmetic average height Sa of a surface of an outermost layer on a side where the image recording layer is provided is in a range of 0.2 μm to 20 μm, to form a sagging shape having a sagging amount X of 25 μm to 150 μm and a sagging width Y of 70 μm to 300 μm on end portions of two opposing sides of the aluminum support; and
an ink repellent agent treatment step of coating a part or the entire side surface having two opposing sides of the aluminum support on which the sagging shape has been formed, with an ink repellent agent.

**14.** The method of producing a planographic printing plate precursor, according to claim 13,
wherein the ink repellent agent treatment step includes further coating a region which extends to a distance of less than 1 cm from the end portions of the aluminum support on the image recording layer, with an ink repellent agent.

**Patentansprüche**

1. Flachdruckplattenvorläufer (10), umfassend:

einen Aluminiumträger (11), der einen anodisierten Film aufweist; und
eine Bildaufzeichnungsschicht (16) auf dem Aluminiumträger (12),
worin ein Endbereich des Flachdruckplattenvorläufers eine abgesenkte Form (18) mit einer Senkhöhe X von 25 μm bis 150 μm und einer Senkbreite Y von 70 μm bis 300 μm aufweist,
worin die Bildaufzeichnungsschicht einen Infrarotabsorber umfasst,
ein Teil oder die gesamte Seitenoberfläche von zwei Seiten des Aluminiumträgers (12), wobei die zwei Seiten die abgesenkte Form (18) aufweisen und einander gegenüberliegen, ein tintenabstoßendes Mittel enthält, und die mittlere arithmetische Höhe Sa der Oberfläche der äußersten Schicht auf einer Seite, auf der die Bildaufzeichnungsschicht (16) vorgesehen ist, im Bereich von 0,2 μm bis 20 μm liegt.

2. Flachdruckplattenvorläufer gemäß Anspruch 1,
worin das tintenabstoßende Mittel in einem Bereich enthalten ist, der sich bis zu einem Abstand von mindestens 30 μm von einer Oberfläche des Aluminiumträgers auf einer Seite der Bildaufzeichnungsschicht erstreckt und sich entlang einer Längsrichtung des Aluminiumträgers erstreckt.

3. Flachdruckplattenvorläufer gemäß Anspruch 1 oder 2,
worin die Menge des tintenabstoßenden Mittels im Bereich von 10 mg/m$^2$ bis 5.000 mg/m$^2$ liegt.

4. Flachdruckplattenvorläufer gemäß irgendeinem der Ansprüche 1 bis 3,
worin ein Bereich auf der Bildaufzeichnungsschicht des Aluminiumträgers, der sich bis zu einem Abstand von weniger als 1 cm von Endbereichen von zwei gegenüberliegenden Seiten des Aluminiumträgers erstreckt, das tintenabstoßende Mittel enthält.

5. Flachdruckplattenvorläufer gemäß Anspruch 4,

worin ein Bereich auf der Bildaufzeichnungsschicht des Aluminiumträgers, der sich zu einem Abstand von weniger als 3 mm von den Endbereichen von zwei gegenüberliegenden Seiten des Aluminiumträgers erstreckt, das tintenabstoßende Mittel enthält, und
bevorzugt ein Bereich auf der Bildaufzeichnungsschicht des Aluminiumträgers, der sich zu einem Abstand von weniger als 1 mm von den Endbereichen von zwei gegenüberliegenden Seiten des Aluminiumträgers erstreckt, das tintenabstoßende Mittel enthält.

6. Flachdruckplattenvorläufer gemäß Anspruch 4 oder 5, worin in dem tintenabstoßenden Mittel, das auf der Bildaufzeichnungsschicht vorgesehen ist,

ein Wert von Z, dargestellt durch die folgende Gleichung, welches eine Variation in einer Breite des tintenabstoßenden Mittels von dem Endbereich des Aluminiumträgers in einer Breitenrichtung ist, mit Ausnahme eines Bereichs, der sich bis zu einem Abstand von 5 cm von beiden Enden von zwei gegenüberliegenden Seiten des Aluminiumträgers in einer Längsrichtung erstreckt, 0,5 mm oder weniger beträgt.

$$Z = \frac{1}{N}\sum_{n-1}^{N} \left| Zn - \bar{Z} \right|$$

(Zn stellt eine Breite des tintenabstoßenden Mittels von dem Endbereich des tintenabstoßenden Mittels an einem willkürlichen Punkt des Aluminiumträgers in der Längsrichtung dar, N stellt eine Zahl dar, die erhalten durch wird durch Messen der Breite des tintenabstoßenden Mittels, und $\bar{Z}$ stellt einen Mittelwert von Breiten von dem Endbereich des tintenabstoßenden Mittels dar.

**7.** Flachdruckplattenvorläufer gemäß irgendeinem der Ansprüche 4 bis 6,

worin die auf die Bildaufzeichnungsschicht aufgetragene Menge des tintenabstoßenden Mittels im Bereich von 10 $mg/m^2$ bis 5.000 $mg/m^2$ liegt,
und/oder
ein Wert, der erhalten wird durch Dividieren der Breite des tintenabstoßenden Mittels, das auf die Bildaufzeichnungsschicht aufgetragen ist, durch die Breite der Seitenoberfläche des Aluminiumträgers, kleiner als 10 ist.

**8.** Flachdruckplattenvorläufer gemäß irgendeinem der Ansprüche 1 bis 7, worin der anodisierte Film Mikroporen in dessen Oberfläche aufweist und ein mittlerer Durchmesser der Mikroporen im Bereich von 10 nm bis 100 nm liegt.

**9.** Flachdruckplattenvorläufer gemäß irgendeinem der Ansprüche 1 bis 8, worin in der Oberfläche des anodisierten Films auf der Seite der Bildaufzeichnungsschicht die spezifische Oberfläche $\Delta S$ 20 % oder größer ist, welche ein Wert ist, der durch die Gleichung (i) auf Grundlage einer geometrischen Messfläche $S_0$ und einer tatsächlichen Fläche $S_x$ berechnet wird, erhalten durch ein Dreipunkt-Annäherungsverfahren aus dreidimensionalen Daten, die erhalten werden durch Messen von 512 × 512 Punkten in einem Bereich in einer Größe von 25 μm × 25 μm auf der Oberfläche des anodisierten Films auf der Seite der Bildaufzeichnungsschicht unter Verwendung eines Atomkraftmikroskops:

$$\Delta S = (S_x - S_0)/S_0 \times 100\ (\%) \ \ldots\ (i).$$

**10.** Flachdruckplattenvorläufer gemäß irgendeinem der Ansprüche 1 bis 9, worin die Bildaufzeichnungsschicht Polymerpartikel umfasst, die aus einem Acrylnitril-Copolymer bestehen.

**11.** Flachdruckplattenvorläufer gemäß irgendeinem der Ansprüche 1 bis 10, worin die mittlere arithmetische Höhe Sa auf einer Oberfläche der äußersten Schicht auf einer Seite gegenüberliegend zu einer Seite, auf der die Bildaufzeichnungsschicht vorgesehen ist, im Bereich von 0,3 μm bis 20 μm liegt.

**12.** Flachdruckplattenvorläufer gemäß irgendeinem der Ansprüche 1 bis 11, worin die Bildaufzeichnungsschicht eine Bildaufzeichnungsschicht vom wasserlöslichen oder Wasser-dispergierbaren Negativ-Typ umfasst.

**13.** Verfahren zur Herstellung eines Flachdruckplattenvorläufers, umfassend:

einen Schneideschritt zum Schneiden eines Aluminiumträgers, der hierauf einen anodisierten Film und eine Bildaufzeichnungsschicht auf dem anodisierten Film, die einen Infrarotabsorber umfasst, aufweist, worin die arithmetische mittlere Höhe Sa einer Oberfläche einer äußersten Schicht auf einer Seite, auf der die Bildaufzeichnungsschicht vorgesehen ist, im Bereich von 0,2 μm bis 20 μm liegt, um eine abgesenkte Form mit einer Senkhöhe X von 25 μm bis 150 μm und einer Senkbreite Y von 70 μm bis 300 μm an Endbereichen von zwei gegenüberliegenden Seiten des Aluminiumträgers zu bilden; und
einen Behandlungsschritt mit einem tintenabstoßenden Mittel zur Beschichtung eines Teils oder der gesamten Seitenoberfläche des Aluminiumträgers, der zwei gegenüberliegende Seiten aufweist, auf der die abgesenkte Form gebildet worden ist, mit einem tintenabstoßenden Mittel.

**14.** Verfahren zur Herstellung eines Flachdruckplattenvorläufers gemäß Anspruch 13, worin der Schritt zur Behandlung mit einem tintenabstoßenden Mittel ferner das Beschichten eines Bereichs mit einem tintenabstoßenden Mittel umfasst, der sich bis zu einem Abstand von weniger als 1 cm von den Endbereichen des Aluminiumträgers auf der Bildaufzeichnungsschicht erstreck.

## Revendications

**1.** Précurseur (10) de plaque d'impression planographique comprenant :

un support (11) en aluminium qui présente un film anodisé ; et
une couche (16) d'enregistrement d'image sur le support (12) en aluminium,

dans lequel une partie d'extrémité du précurseur de plaque d'impression planographique présente une forme (18) affaissée présentant une quantité d'affaissement X de 25 $\mu$m à 150 $\mu$m et une largeur d'affaissement Y de 70 $\mu$m à 300 $\mu$m,
la couche d'enregistrement d'image contient un agent absorbant les infrarouges,
une partie ou la totalité de la surface latérale de deux côtés du support (12) en aluminium, les deux côtés présentant la forme (18) affaissée et étant opposés l'un à l'autre, contient un agent repoussant l'encre, et
la hauteur moyenne arithmétique Sa de la surface de la couche la plus extérieure sur un côté où la couche (16) d'enregistrement d'image est prévue est dans une plage de 0,2 $\mu$m à 20 $\mu$m.

**2.** Précurseur de plaque d'impression planographique selon la revendication 1, dans lequel l'agent repoussant l'encre est contenu dans une région qui s'étend sur une distance d'au moins 30 $\mu$m à partir d'une surface du support en aluminium sur un côté de la couche d'enregistrement d'image et s'étend le long d'une direction longitudinale du support en aluminium.

**3.** Précurseur de plaque d'impression planographique selon la revendication 1 ou la revendication 2, dans lequel une quantité de l'agent repoussant l'encre est dans une plage de 10 mg/$m^2$ à 5000 mg/$m^2$.

**4.** Précurseur de plaque d'impression planographique selon l'une quelconque des revendications 1 à 3, dans lequel une région sur la couche d'enregistrement d'image du support en aluminium qui s'étend sur une distance inférieure à 1 cm à partir de parties d'extrémité de deux côtés opposés du support en aluminium contient l'agent repoussant l'encre.

**5.** Précurseur de plaque d'impression planographique selon la revendication 4,

dans lequel une région sur la couche d'enregistrement d'image du support en aluminium qui s'étend sur une distance inférieure à 3 mm à partir de parties d'extrémité de deux côtés opposés du support en aluminium contient l'agent repoussant l'encre, et
de préférence, une région sur la couche d'enregistrement d'image du support en aluminium qui s'étend sur une distance inférieure à 1 mm à partir de parties d'extrémité de deux côtés opposés du support en aluminium contient l'agent repoussant l'encre.

**6.** Précurseur de plaque d'impression planographique selon la revendication 4 ou la revendication 5, dans l'agent repoussant l'encre prévu sur la couche d'enregistrement d'image,
une valeur de Z représentée par l'équation suivante, qui est une variation d'une largeur de l'agent repoussant l'encre à partir de la partie d'extrémité du support en aluminium dans une direction de largeur, à l'exception d'une région qui s'étend sur une distance de 5 cm à partir des deux extrémités de deux côtés opposés du support en aluminium dans une direction longitudinale, est de 0,5 mm ou moins.

$$Z = \frac{1}{N}\sum_{n-1}^{N} |Zn - \bar{Z}|$$

(Zn représente une largeur de l'agent repoussant l'encre a partir de la partie d'extrémité de l'agent repoussant l'encre au niveau d'un point arbitraire du support en aluminium dans la direction longitudinale, N représente un nombre obtenu en mesurant la largeur de l'agent repoussant l'encre, et 2 représente une valeur moyenne de largeurs à partir de la partie d'extrémité de l'agent repoussant l'encre.)

**7.** Précurseur de plaque d'impression planographique selon l'une quelconque des revendications 4 à 6,

dans lequel la quantité de l'agent repoussant l'encre appliqué sur la couche d'enregistrement d'image est dans une plage de 10 mg/$m^2$ à 5000 mg/$m^2$,
et/ou
une valeur obtenue en divisant la largeur de l'agent repoussant l'encre appliqué sur la couche d'enregistrement d'image par une largeur de la surface latérale du support en aluminium est inférieure à 10.

**8.** Précurseur de plaque d'impression planographique selon l'une quelconque des revendications 1 à 7, dans lequel le film anodisé présente des micropores dans la surface de celui-ci et un diamètre moyen des micropores est dans une plage de 10 nm à 100 nm.

**9.** Précurseur de plaque d'impression planographique selon l'une quelconque des revendications 1 à 8,

dans lequel, dans la surface du film anodisé du côté de la couche d'enregistrement d'image, une surface spécifique $\Delta S$ qui est une valeur acquise par l'équation (i) sur la base d'une surface de mesure géométrique $S_0$ et d'une surface réelle $S_x$ obtenue par un procédé d'approximation en trois points à partir de données tridimensionnelles obtenues en mesurant 512 × 512 points dans une région ayant une taille de 25 μm × 25 μm sur la surface du film anodisé du côté de la couche d'enregistrement d'image en utilisant un microscope à force atomique est de 20 % ou plus.

$$\Delta S = (S_x - S_0)/S_0 \times 100\ (\%) \cdots \text{(i)}$$

**10.** Précurseur de plaque d'impression planographique selon l'une quelconque des revendications 1 à 9, dans lequel la couche d'enregistrement d'image contient des particules polymères constituées d'un copolymère d'acrylonitrile.

**11.** Précurseur de plaque d'impression planographique selon l'une quelconque des revendications 1 à 10, dans lequel une hauteur moyenne arithmétique Sa d'une surface d'une couche la plus extérieure sur un côté opposé à un côté où la couche d'enregistrement d'image est prévue est dans une plage de 0,3 μm à 20 μm.

**12.** Précurseur de plaque d'impression planographique selon l'une quelconque des revendications 1 à 11, dans lequel la couche d'enregistrement d'image inclut une couche d'enregistrement d'image de type négatif hydrosoluble ou dispersible dans l'eau.

**13.** Procédé de production d'un précurseur de plaque d'impression planographique, comprenant :

une étape de découpe consistant à découper un support en aluminium qui présente un film anodisé sur celui-ci et une couche d'enregistrement d'image contenant un agent absorbant les infrarouges sur le film anodisé, dans lequel une hauteur moyenne arithmétique Sa d'une surface d'une couche la plus extérieure d'un côté où la couche d'enregistrement d'image est prévue est dans une plage de 0,2 μm à 20 μm, pour former une forme affaissée présentant une quantité d'affaissement X de 25 μm à 150 μm et une largeur d'affaissement Y de 70 μm à 300 μm sur des parties d'extrémité de deux côtés opposés du support en aluminium ; et
une étape de traitement par un agent repoussant l'encre consistant à revêtir une partie ou la totalité de la surface latérale ayant deux côtés opposés du support en aluminium sur lequel la forme d'affaissement a été formée, avec un agent repoussant l'encre.

**14.** Procédé de production d'un précurseur de plaque d'impression planographique, selon la revendication 13, dans lequel l'étape de traitement par un agent repoussant l'encre inclut en outre un revêtement d'une région qui s'étend sur une distance inférieure à 1 cm à partir des parties d'extrémité du support en aluminium sur la couche d'enregistrement d'image, avec un agent repoussant l'encre.

FIG. 1

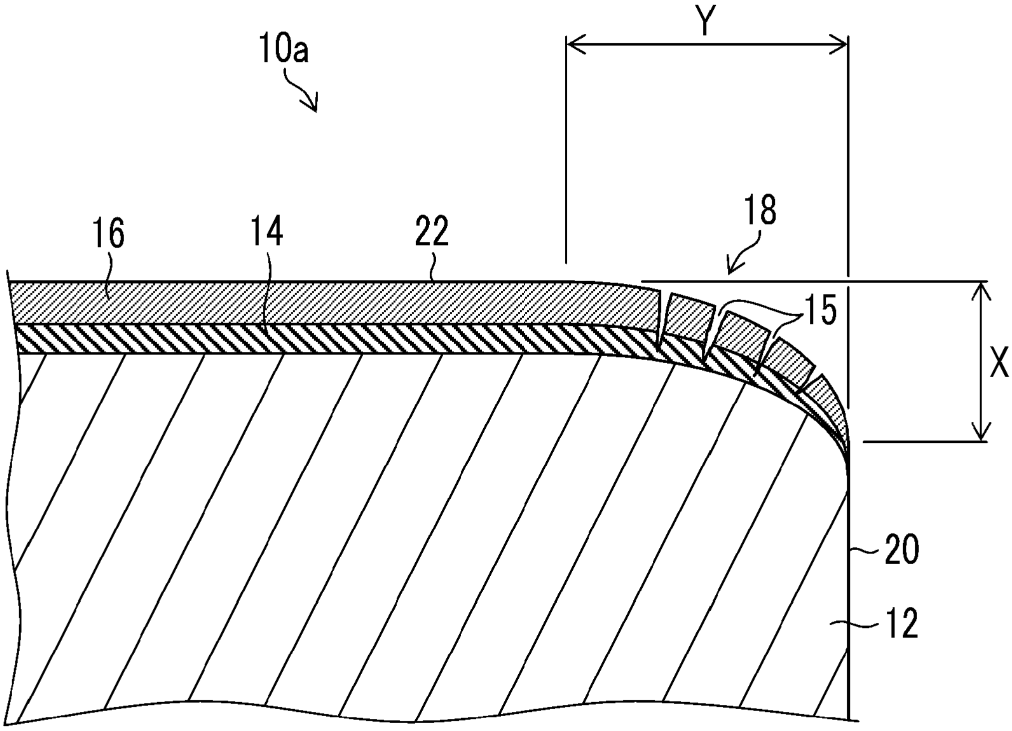


FIG. 2

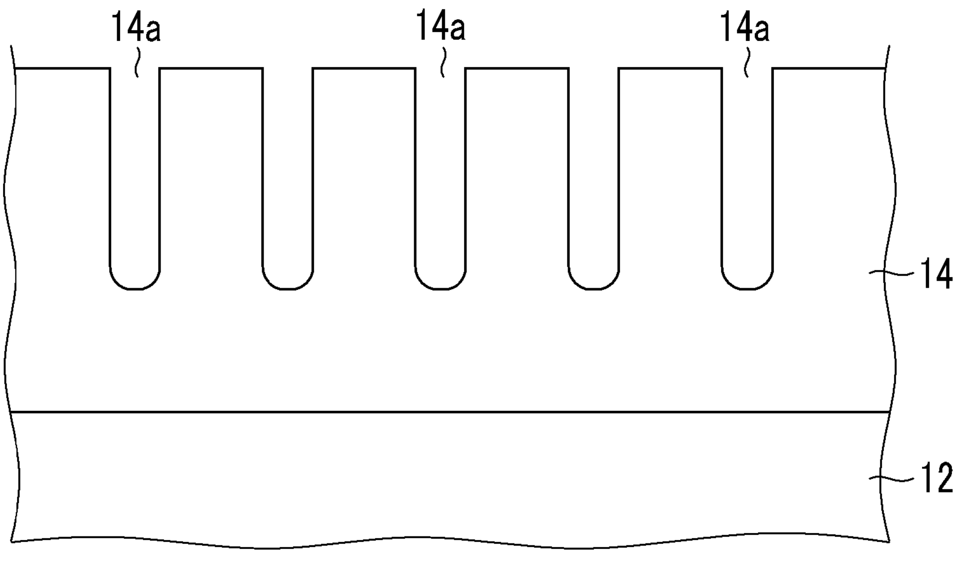

FIG. 3

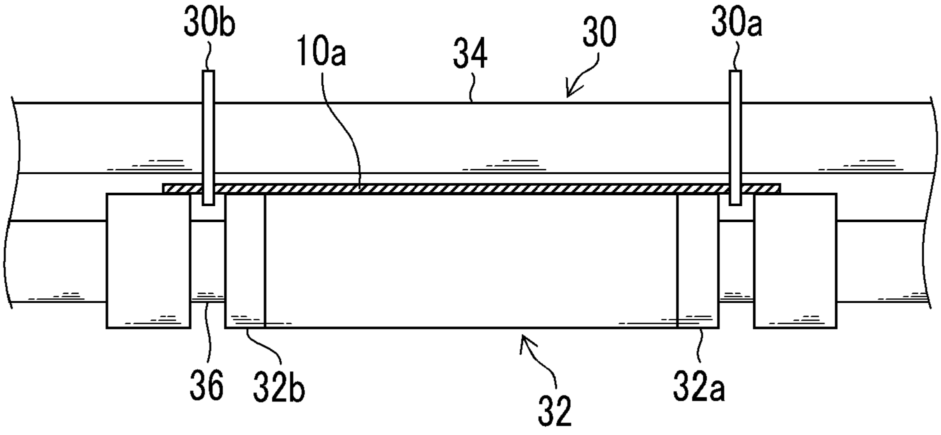


FIG. 4

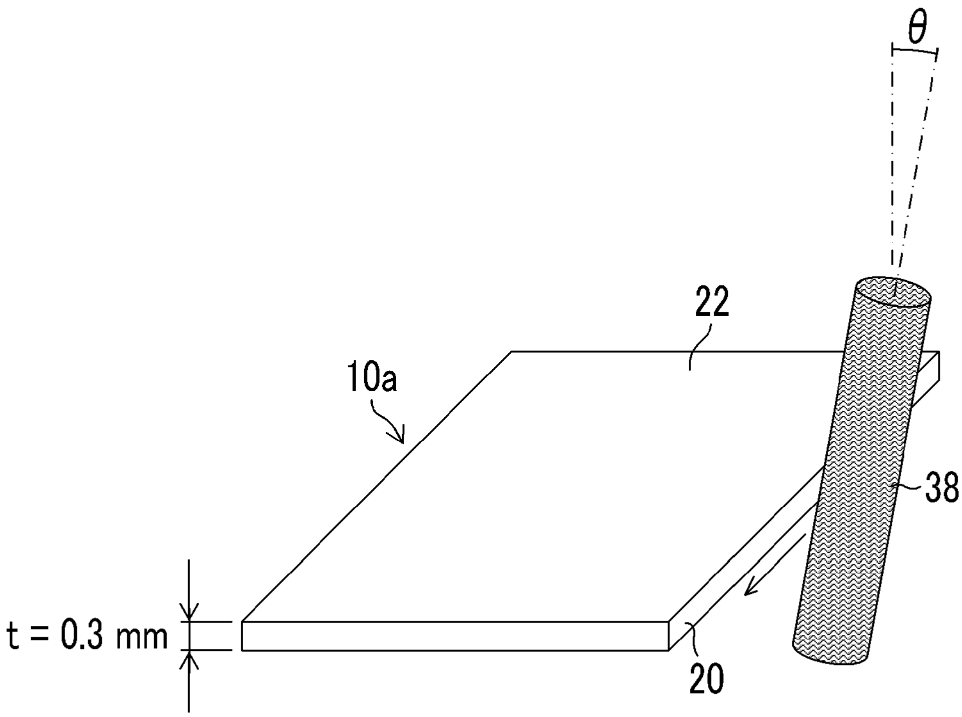

FIG. 5

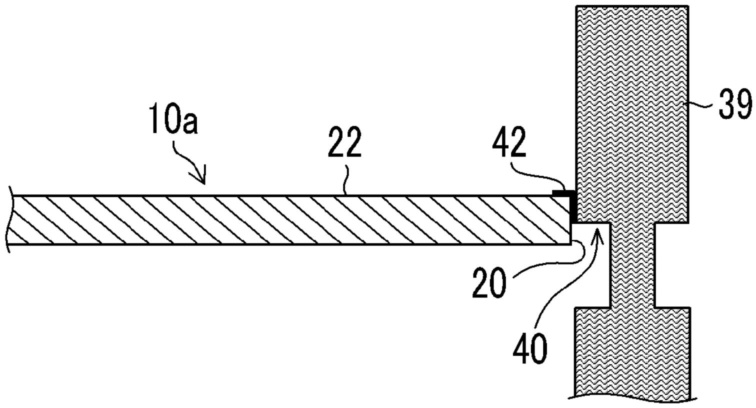


FIG. 6

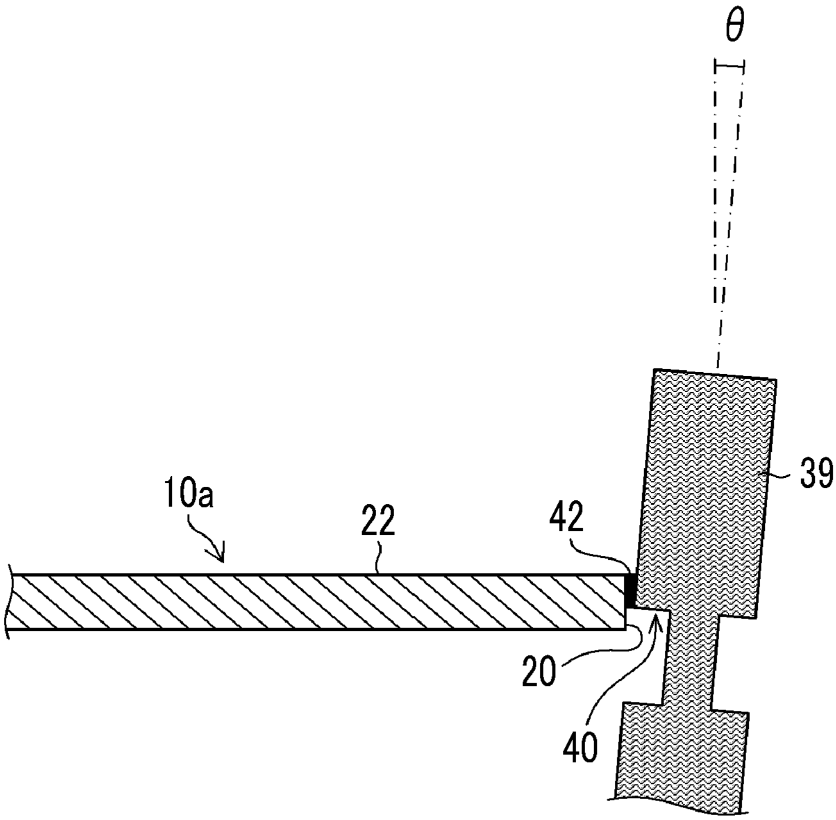

FIG. 7

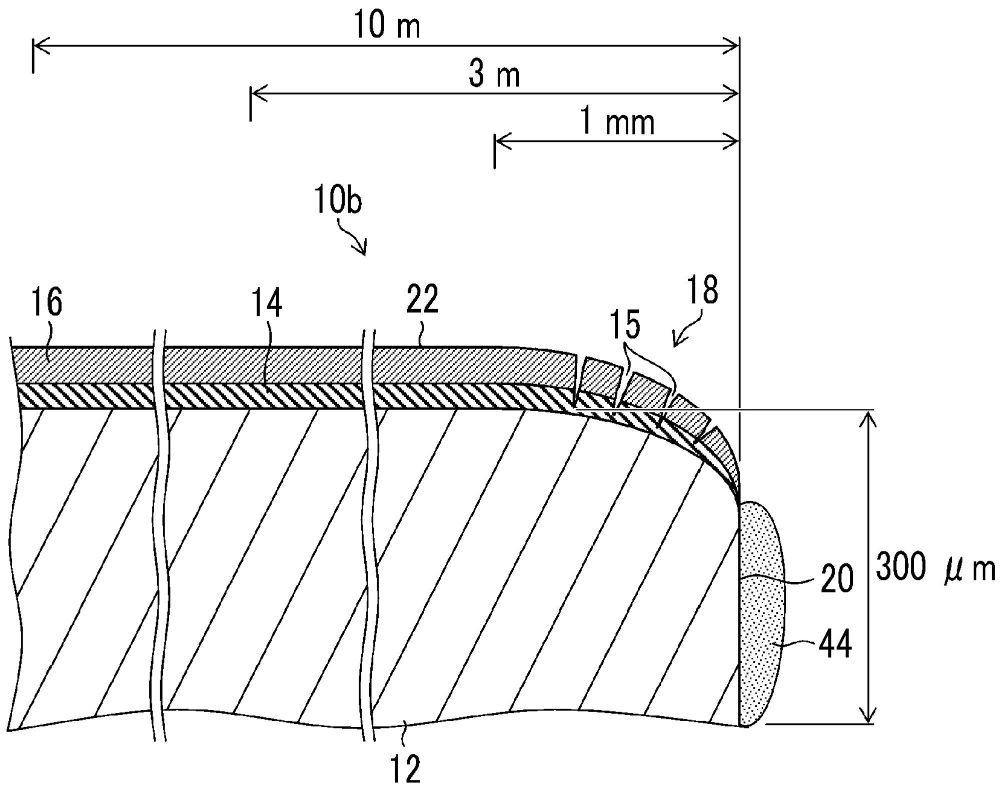
10 m
3 m
1 mm
10b
16
14
22
15
18
20
300 μm
44
12

FIG. 8

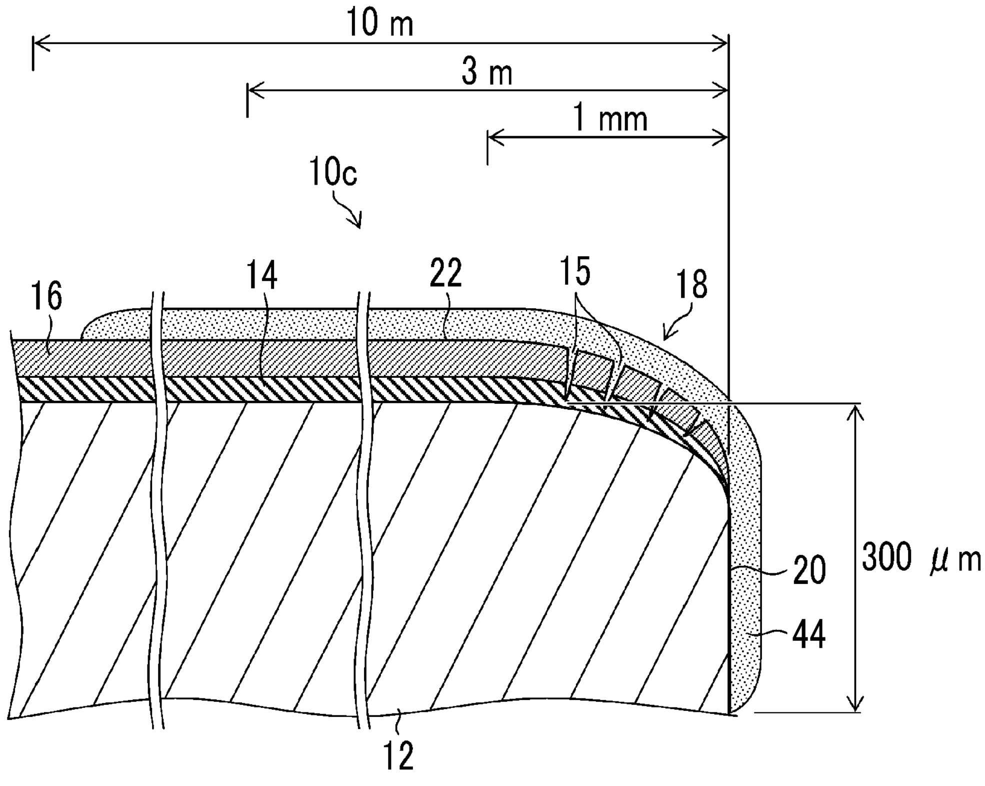
10 m
3 m
1 mm
10c
16
14
22
15
18
20
300 μm
44
12

FIG. 9

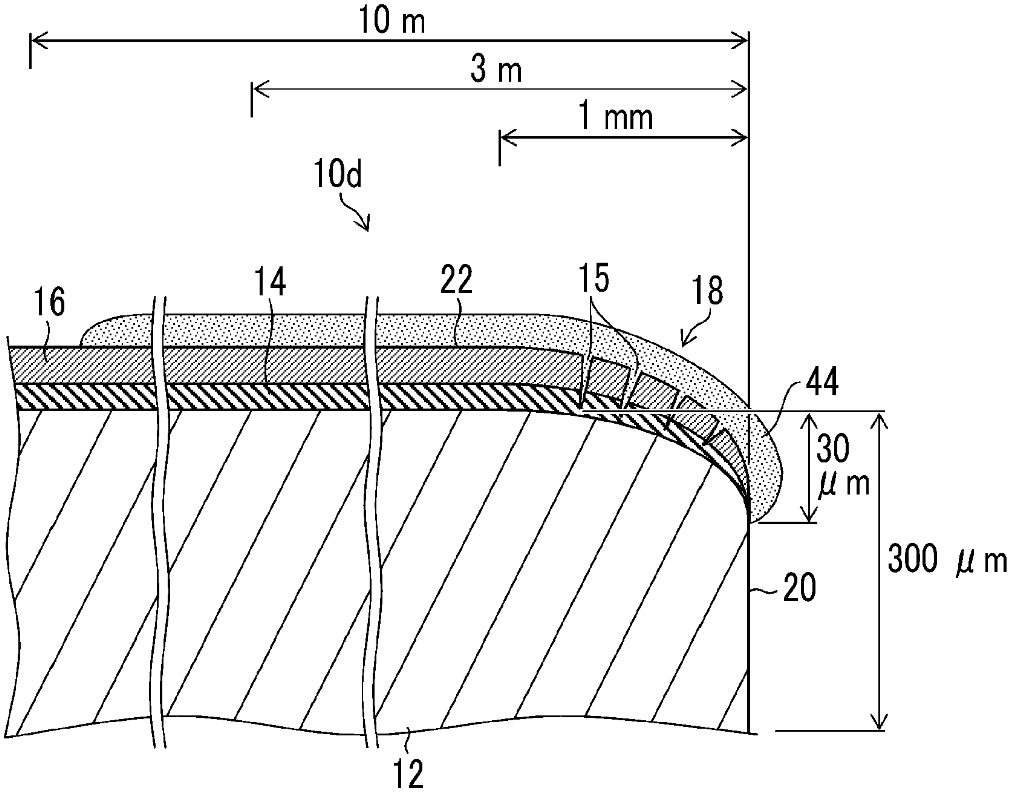
10 m
3 m
1 mm
10d
16
14
22
15
18
44
30
μm
300 μm
20
12

FIG. 10

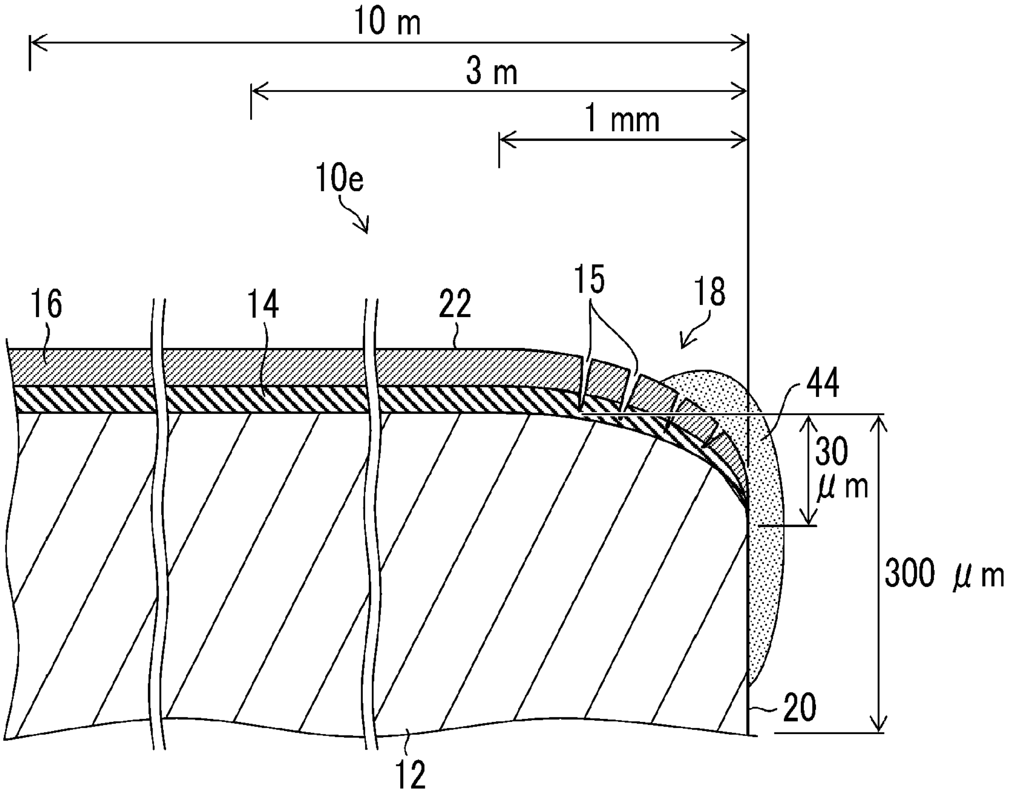
10 m
3 m
1 mm
10e
16
14
22
15
18
44
30
μm
300 μm
20
12

FIG. 11

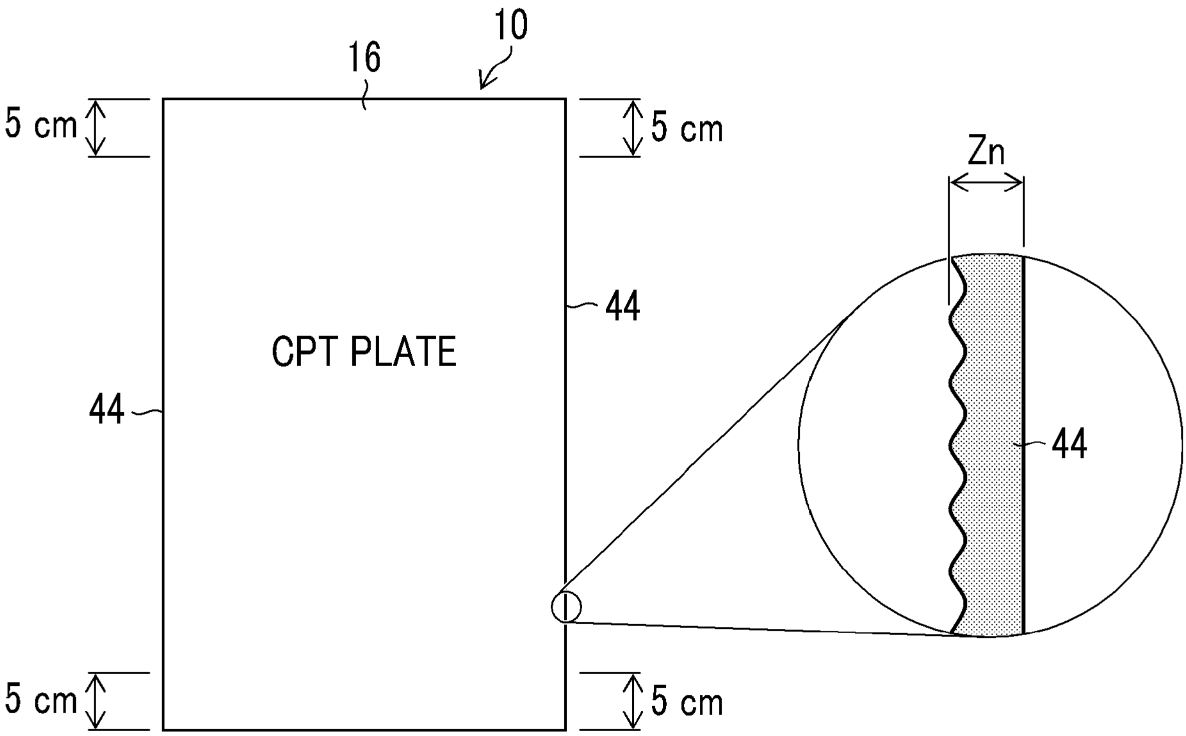

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2011177983 A
- WO 2015119089 A
- JP 8058257 A
- JP H08058257 A
- JP 11052579 A
- JP H11052579 A
- WO 2015129504 A
- US 2017320351 A
- JP 2008195018 A
- JP 2009255434 A
- JP 48041708 B
- JP S48041708 B
- JP 2012187907 A
- JP 50040047 B
- JP S50040047 B
- JP 9211843 A
- JP H09211843 A
- JP 10100556 A
- JP H10100556 A
- JP 2014104631 A
- US 4253999 A
- US 4268613 A
- US 4348954 A
- JP 2002327036 A
- JP 2002173410 A
- JP 2004307837 A
- JP 2006038246 A
- JP 2005250216 A
- JP 2006259137 A


### Non-patent literature cited in the description


- Dye Handbook. The Society of Synthetic Organic Chemistry, 1970
- Ultrafine Particle as Materials. SHOKABO Co., Ltd, 1993
- **HARUMA KAWAGUCHI.** Manufacturing & Application of Microspheres & Powders. CMC Publishing, 2005
- *Journal of the Adhesion Society of Japan,* 1993, vol. 29 (6), 249-259